(19) Europäisches Patentamt
European Patent Office
Office européen des brevets

(11) **EP 3 686 943 B1**

(12) **EUROPEAN PATENT SPECIFICATION**

(45) Date of publication and mention of the grant of the patent:
**27.09.2023 Bulletin 2023/39**

(21) Application number: **19807086.4**

(22) Date of filing: **23.05.2019**

(51) International Patent Classification (IPC):
***H10K 85/10*** *(2023.01)* ***H10K 85/60*** *(2023.01)*

(52) Cooperative Patent Classification (CPC):
**H10K 85/141; H10K 85/633; H10K 85/636; H10K 85/6572; H10K 85/6574;** H10K 50/17

(86) International application number:
**PCT/KR2019/006204**

(87) International publication number:
**WO 2019/225985 (28.11.2019 Gazette 2019/48)**

(54) **ORGANIC LIGHT EMITTING DIODE**

ORGANISCHE LEUCHTDIODE

DIODE ÉLECTROLUMINESCENTE ORGANIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **24.05.2018 KR 20180059175**

(43) Date of publication of application:
**29.07.2020 Bulletin 2020/31**

(73) Proprietor: **LG CHEM, LTD.**
**Yeongdeungpo-gu,**
**Seoul 07336 (KR)**

(72) Inventors:
- **KANG, Sungkyoung**
  **Daejeon 34122 (KR)**
- **PARK, Youngju**
  **Daejeon 34122 (KR)**
- **KIM, Kwanghyun**
  **Daejeon 34122 (KR)**
- **BAE, Jaesoon**
  **Daejeon 34122 (KR)**
- **LEE, Jaechol**
  **Daejeon 34122 (KR)**
- **KIM, Hwakyung**
  **Daejeon 34122 (KR)**
- **JEONG, Jae Hak**
  **Daejeon 34122 (KR)**
- **PARK, Hyungil**
  **Daejeon 34122 (KR)**

(74) Representative: **Hoffmann Eitle**
**Patent- und Rechtsanwälte PartmbB**
**Arabellastraße 30**
**81925 München (DE)**

(56) References cited:
**EP-A1- 3 686 186**
**WO-A1-2017/107117**
**KR-A- 20150 093 995**
**KR-A- 20170 043 558**
**US-A1- 2018 013 077**
**WO-A1-2017/107117**
**WO-A1-2017/164268**
**KR-A- 20160 041 124**
**KR-A- 20180 008 154**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 686 943 B1

## Description

[Technical Field]

The present specification relates to an organic light emitting device.

[Background Art]

An organic light emission phenomenon is one of examples converting a current to visible light by an internal process of specific organic molecules. A principle of an organic light emission phenomenon is as follows. When an organic material layer is placed between an anode and a cathode and a current is applied between the two electrodes, electrons and holes are injected to the organic material layer from the cathode and the anode, respectively. The holes and the electrons injected to the organic material layer recombine to form excitons, and light emits when these excitons fall back to the ground state. An organic electroluminescent device using such a principle may be generally formed with a cathode, an anode, and an organic material layer placed therebetween, for example, an organic material layer including a hole injection layer, a hole transfer layer, a light emitting layer, an electron transfer layer and an electron injection layer.

Materials used in an organic light emitting device are mostly pure organic materials or complex compounds in which organic materials and metals form complexes, and may be divided into hole injection materials, hole transfer materials, light emitting materials, electron transfer materials, electron injection materials and the like depending on the application. Herein, as the hole injection material or the hole transfer material, organic materials having a p-type property, that is, organic materials readily oxidized and having an electrochemically stable state when oxidized, are generally used. Meanwhile, as the electron injection material or the electron transfer material, organic materials having an n-type property, that is, organic materials readily reduced and having an electrochemically stable state when reduced, are generally used. As the light emitting material, materials having both a p-type property and an n-type property, that is, materials having a stable form in both oxidized and reduced states, are preferred, and materials having high light emission efficiency converting, when excitons are formed, the excitons to light are preferred.

In addition to the properties described above, it is preferred that materials used in an organic light emitting device additionally have properties as follows.

First, materials used in an organic light emitting device preferably have excellent thermal stability. This is due to joule heat produced by charge migration in the organic light emitting device. NPB (n-propyl bromide) normally used as a hole transfer layer material currently has a glass transition temperature of 100°C or lower, and has a problem in that it is difficult to use in organic light emitting devices requiring a high current.

Second, in order to obtain a highly efficient organic light emitting device capable of low voltage driving, holes or electrons injected into the organic light emitting device need to be smoothly transferred to a light emitting layer, and at the same time, the injected holes and electrons need to be kept from escaping out of the light emitting layer. For this, materials used in the organic light emitting device need to have a proper band gap and a HOMO or LUMO energy level. Poly(3,4-ethylenedioxythiophene) doped with poly(styrenesulfonic acid) (PEDOT:PSS) currently used as a hole transfer material in an organic light emitting device manufactured using a solution coating method has a lower LUMO energy level compared to a LUMO energy level of organic materials used as a light emitting layer material, and therefore, has a problem in manufacturing an organic light emitting device with high efficiency and long lifetime.

In addition thereto, materials used in an organic light emitting device need to have excellent chemical stability, charge mobility, and interface property with electrodes or adjacent layers. In other words, materials used in an organic light emitting device need to undergo less material deformation caused by moisture or oxygen. In addition, by having proper hole or electron mobility, the materials need to maximize exciton formation through balancing hole and electron density in a light emitting layer of the organic light emitting device. For device stability, the materials also need to improve an interface with electrodes including metals or metal oxides.

Accordingly, development of organic materials fulfilling such requirements has been required in the art.

EP-A-3686186, prior art pursuant to Article 54(3) EPC only, relates to an organic compound, a coating composition including the same, and an organic light emitting device. The compound may for instance be the following:

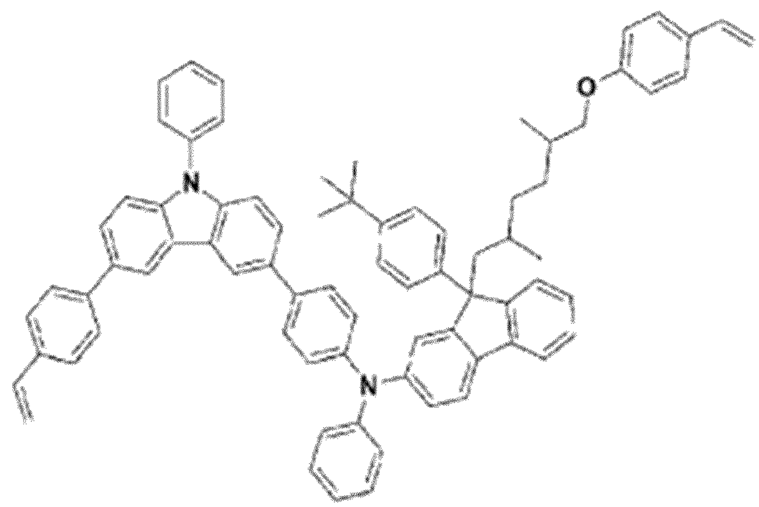

WO-A-2017/107117 discloses an organic polymeric layer for an electronic device that shows reduced driving voltage and/or increased luminous efficiency. The layer includes a p-dopant and a tri-arylamine monomer such as:

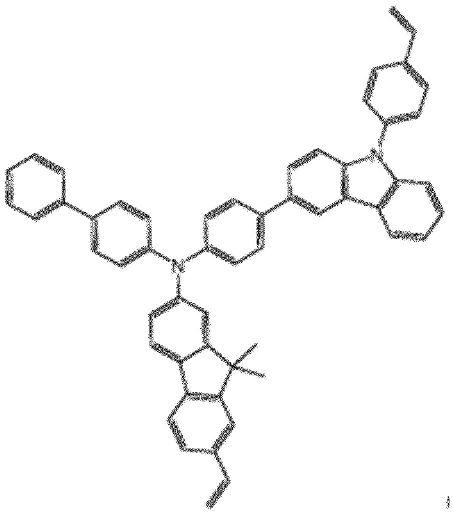

KR-A-2018-0008154 teaches an organic light emitting device including a layer between first and second electrodes including a compound such as:

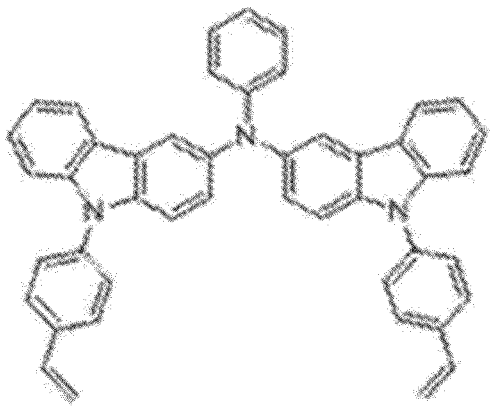

[Technical Problem]

The present specification is directed to providing an organic light emitting device.

[Technical Solution]

According to the present invention, there is provided an organic light emitting device comprising:

a first electrode;
a second electrode provided opposite to the first electrode; and
one or more organic material layers provided between the first electrode and the second electrode,
wherein one or more layers of the organic material layers includes a cured material formed from a compound represented by the following Chemical Formula 1 and an ionic compound including an anion group represented by the following Chemical Formula 11:

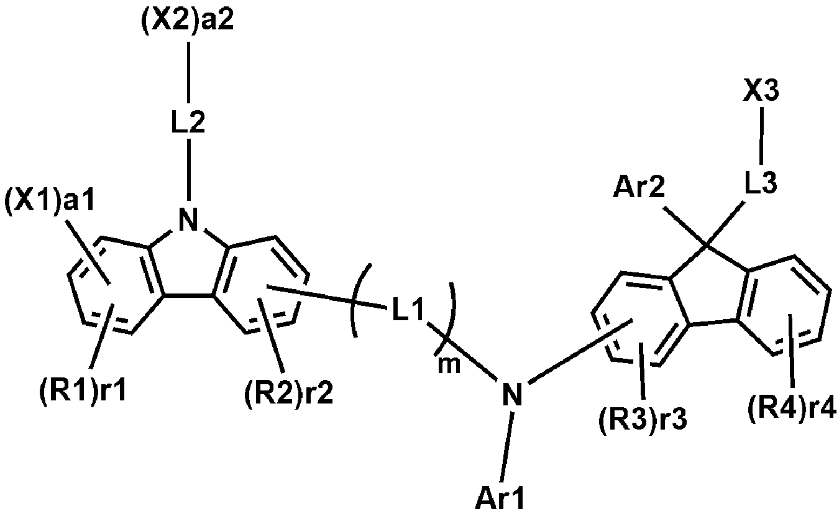

[Chemical Formula 1]

wherein:

Ar1 and Ar2 are the same as or different from each other, and each independently is a substituted or unsubstituted aryl group or a substituted or unsubstituted heterocyclic group;
R1 to R4 are the same as or different from each other, and each independently is hydrogen, deuterium, a halogen group, a nitrile group, a substituted or unsubstituted alkyl group, a substituted or unsubstituted aryl group or a substituted or unsubstituted heterocyclic group;
r1 to r3 are each from 1 to 3;
r4 is from 1 to 4;
when r1 to r4 are each 2 or greater, the two or more R1 to R4 are each the same as or different from each other;
X1 to X3 are the same as or different from each other, and each independently is selected from among the following structural formulae,

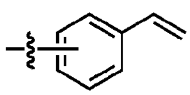
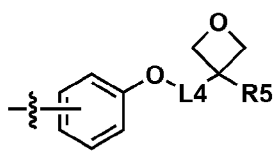
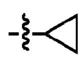
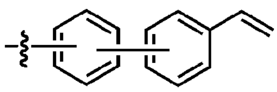
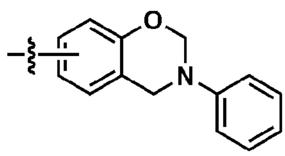
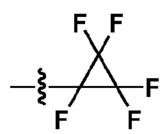

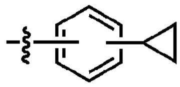 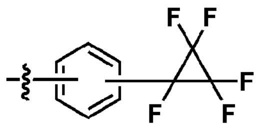 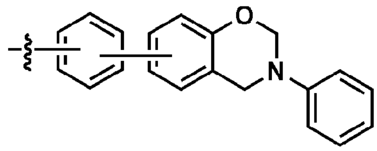

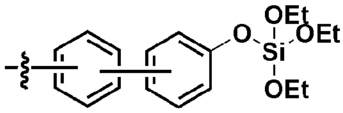 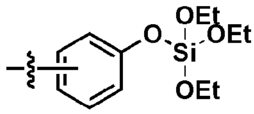 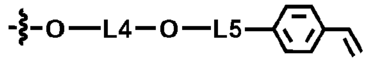

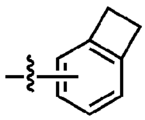 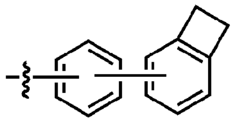

;

each 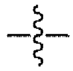 means a linking site;
L4 is a substituted or unsubstituted alkylene group;
L5 is a direct bond or a substituted or unsubstituted arylene group;
R5 is hydrogen or a substituted or unsubstituted alkyl group;
a1 and a2 are each 0 or 1;
when a2 is 0, L2 is a substituted or unsubstituted aryl group;
when a2 is 1, L2 is a direct bond or a substituted or unsubstituted arylene group;
m is 1 or 2, and when m is 2, L1s are the same as or different from each other, and L1 is a direct bond or a substituted or unsubstituted arylene group;
L3 is a direct bond or a substituted or unsubstituted alkylene group; and

$$0 \leq a1+a2 \leq 2,$$

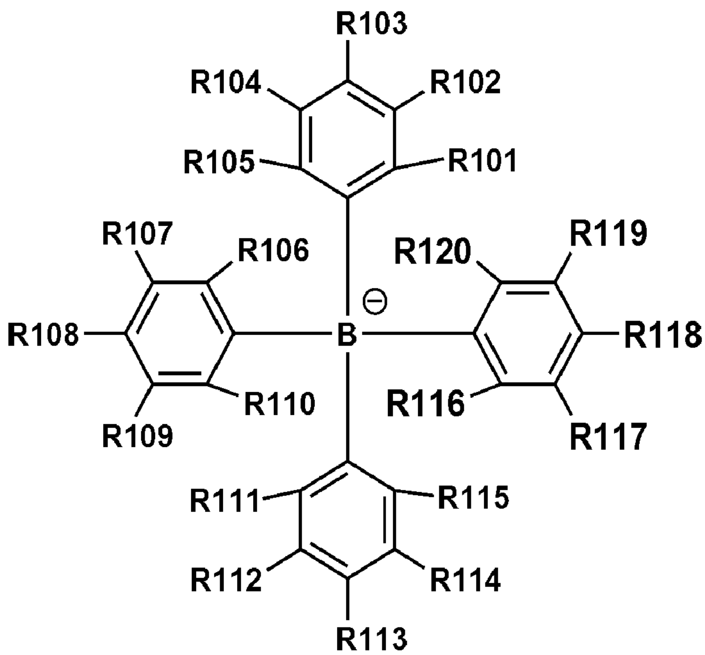

[Chemical Formula 11]

wherein:

at least one of R101 to R120 is F, a cyano group or a substituted or unsubstituted fluoroalkyl group;

at least one of the remaining R101 to R120 is a curing group; and
the remaining R101 to R120 are the same as or different from each other, and each independently is hydrogen, deuterium, a nitro group, a substituted or unsubstituted alkyl group, a substituted or unsubstituted alkenyl group, a substituted or unsubstituted amine group, a substituted or unsubstituted aryl group or a substituted or unsubstituted heterocyclic group.

[Advantageous Effects]

An organic material layer formed using compounds of Chemical Formulae 1 and 11 has excellent thermal and photostability after being cured through heat and light, and does not have solubility for other solvents, and therefore, a lamination film-forming process can be performed on the formed film through another solution process.
In addition, the cured material present in an organic material layer of an organic light emitting device is capable of lowering a driving voltage of the organic light emitting device.
In addition, the cured material present in an organic material layer of an organic light emitting device is capable of enhancing light efficiency and enhancing the lifetime properties of the device.

[Description of Drawings]

FIG. 1 is a diagram illustrating an example of an organic light emitting device according to one embodiment of the present specification.

[Reference Numeral]

101: Substrate
201: Anode
301: Hole Injection Layer
401: Hole Transfer Layer
501: Light Emitting Layer
601: Electron Transfer Layer
701: Cathode

[Mode for Disclosure]

Hereinafter, the present specification will be described in more detail.
The present invention makes use of a compound represented by Chemical Formula 1.
An arylamine-based monomer used in an organic light emitting device for a solution process generally does not have tolerance for a solvent of a next process, and therefore, an arylamine-based monomer compound usable in an organic light emitting device for a solution process needs to have a curing group introduced thereto. Accordingly, a thin film prepared by heat or light treating a coating composition of the amine group-bonding compound of the present disclosure, a curing initiator and a p-doping material has excellent tolerance for a solvent, and an organic light emitting device having excellent current efficiency and device properties are provided.
Examples of substituents in the present specification are described below, however, the substituents are not limited thereto.
In the present specification,

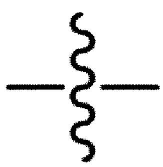

means a linking site.
The term "substitution" means a hydrogen atom bonding to a carbon atom of a compound is changed to another substituent. The position of substitution is not limited as long as it is a position at which the hydrogen atom is substituted, that is, a position at which a substituent can substitute, and when two or more substituents substitute, the two or more

substituents may be the same as or different from each other.

The term "substituted or unsubstituted" in the present specification means being substituted with one, two or more substituents selected from the group consisting of deuterium; a halogen group; a nitrile group; an alkyl group; a cycloalkyl group; an amine group; a silyl group; a phosphine oxide group; an aryl group; and a heteroaryl group including one or more of N, O, S, Se and Si atoms, being substituted with a substituent linking two or more substituents among the substituents illustrated above, or having no substituents.

In the present specification, the alkyl group may be linear or branched, and although not particularly limited thereto, the number of carbon atoms is preferably from 1 to 50 and more preferably from 1 to 30. Specific examples thereof may include methyl, ethyl, propyl, n-propyl, isopropyl, butyl, n-butyl, isobutyl, tert-butyl, sec-butyl, 1-methyl-butyl, 1-ethyl-butyl, pentyl, n-pentyl, isopentyl, neopentyl, tertpentyl, hexyl, n-hexyl, 1-methylpentyl, 2-methylpentyl, 4-methyl-2-pentyl, 3,3-dimethylbutyl, 2-ethylbutyl, heptyl, n-heptyl, 1-methylhexyl, cyclopentylmethyl, cyclohexylmethyl, octyl, n-octyl, tert-octyl, 1-methylheptyl, 2-ethylhexyl, 2-propylpentyl, n-nonyl, 2,2-dimethylheptyl, 1-ethyl-propyl, 1,1-dimethyl-propyl, isohexyl, 4-methylhexyl, 5-methylhexyl and the like, but are not limited thereto.

In the present specification, the cycloalkyl group is not particularly limited, but preferably has 3 to 60 carbon atoms, and more preferably has 3 to 30 carbon atoms. Specific examples thereof may include cyclopropyl, cyclobutyl, cyclopentyl, 3-methylcyclopentyl, 2,3-dimethylcyclopentyl, cyclohexyl, 3-methylcyclohexyl, 4-methylcyclohexyl, 2,3-dimethylcyclohexyl, 3,4,5-trimethylcyclohexyl, 4-tert-butylcyclohexyl, cycloheptyl, cyclooctyl and the like, but are not limited thereto.

In the present specification, the alkenyl group may be linear or branched, and although not particularly limited thereto, the number of carbon atoms is preferably from 2 to 40 and more preferably from 2 to 20. Specific examples thereof may include vinyl, 1-propenyl, isopropenyl, 1-butenyl, 2-butenyl, 3-butenyl, 1-pentenyl, 2-pentenyl, 3-pentenyl, 3-methyl-1-butenyl, 1,3-butadienyl, 1-phenylvinyl-1-yl, 2-phenylvinyl-1-yl, 2,2-diphenylvinyl-1-yl, 2-phenyl-2-(naphthyl-1-yl)vinyl-1-yl, 2,2-bis(diphenyl-1-yl)vinyl-1-yl, a stilbenyl group, a styrenyl group and the like, but are not limited thereto.

When the aryl group is a monocyclic aryl group in the present specification, the number of carbon atoms is not particularly limited, but is preferably from 6 to 50 and more preferably from 6 to 30. Specific examples of the monocyclic aryl group may include a phenyl group, a biphenyl group, a terphenyl group, a quaterphenyl group and the like, but are not limited thereto.

When the aryl group is a polycyclic aryl group, the number of carbon atoms is not particularly limited, but is preferably from 10 to 50 and more preferably from 10 to 30. Specific examples of the polycyclic aryl group may include a naphthyl group, an anthracenyl group, a phenanthryl group, a pyrenyl group, a perylenyl group, a triphenyl group, a chrysenyl group, a fluorenyl group and the like, but are not limited thereto.

In the present specification, the number of carbon atoms of the amine group is not particularly limited, but is preferably from 1 to 50 and more preferably from 10 to 30. The amine group may be substituted with the above-described alkyl group, aryl group, heterocyclic group, alkenyl group, cycloalkyl group, a combination thereof and the like, and specific examples of the amine group may include a methylamine group, a dimethylamine group, an ethylamine group, a diethylamine group, a phenylamine group, a naphthylamine group, a biphenylamine group, an anthracenylamine group, a 9-methyl-anthracenylamine group, a diphenylamine group, a phenylnaphthylamine group, a ditolylamine group, a phenyltolylamine group, a triphenylamine group and the like, but are not limited thereto.

In the present specification, examples of the arylamine group include a substituted or unsubstituted monoarylamine group, a substituted or unsubstituted diarylamine group, or a substituted or unsubstituted triarylamine group. The aryl group in the arylamine group may be a monocyclic aryl group or a polycyclic aryl group. The arylamine group including two or more aryl groups may include monocyclic aryl groups, polycyclic aryl groups, or both monocyclic aryl groups and polycyclic aryl groups. For example, the aryl group in the arylamine group may be selected from among the examples of the aryl group described above. Specific examples of the arylamine group may include phenylamine, naphthylamine, biphenylamine, anthracenylamine, 3-methyl-phenylamine, 4-methyl-naphthylamine, 2-methylbiphenylamine, 9-methyl-anthracenylamine, a diphenylamine group, a phenylnaphthylamine group, a ditolylamine group, a phenyltolylamine group, carbazole, a triphenylamine group and the like, but are not limited thereto.

In the present specification, the heterocyclic group includes one or more of N, O, S, Si and Se as a heteroatom, and although not particularly limited thereto, the number of carbon atoms is preferably from 2 to 60 and more preferably from 2 to 30. Examples of the heterocyclic group may include a thiophene group, a furan group, a pyrrole group, an imidazole group, a thiazole group, an oxazole group, an oxadiazole group, a triazole group, a pyridine group, a bipyridine group, a pyrimidine group, a triazine group, an acridine group, a pyridazine group, a pyrazine group, a quinoline group, a quinazoline group, a quinoxaline group, a phthalazine group, a pteridine group, a pyrido pyrimidine group, a pyrido pyrazine group, a pyrazino pyrazine group, an isoquinoline group, an indole group, a pyrido indole group, 5H-indeno pyrimidine, a carbazole group, a benzoxazole group, a benzimidazole group, a benzothiazole group, a benzocarbazole group, a benzothiophene group, a dibenzothiophene group, a benzofuran group, a dibenzofuran group, a phenanthroline group, a thiazolyl group, an isoxazolyl group, an oxadiazolyl group, a thiadiazolyl group and the like, but are not limited thereto.

In the present specification, the heteroaryl group may be selected from among the examples of the heterocyclic group except for those that are aromatic, but is not limited thereto.

In the present specification, the alkylene group means an alkyl group having two bonding sites, that is, a divalent group. Descriptions on the alkyl group provided above may be applied thereto except for those that are each divalent.

In the present specification, the arylene group means an aryl group having two bonding sites, that is, a divalent group. Descriptions on the aryl group provided above may be applied thereto except for those that are each divalent.

In the present specification, the heteroarylene group means a heteroaryl group having two bonding sites, that is, a divalent group. Descriptions on the heteroaryl group provided above may be applied thereto except for those that are each divalent.

In one embodiment of the present specification, Ar1 and Ar2 are the same as or different from each other, and each independently a substituted or unsubstituted aryl group; or a substituted or unsubstituted heteroring.

In one embodiment of the present specification, Ar1 is a substituted or unsubstituted phenyl group; a substituted or unsubstituted biphenyl group; a substituted or unsubstituted naphthyl group; a substituted or unsubstituted phenanthrene group; a substituted or unsubstituted fluorene group; or a substituted or unsubstituted dibenzofuran group.

In one embodiment of the present specification, Ar1 is a phenyl group unsubstituted or substituted with deuterium, a halogen group, an alkyl group or a fluoroalkyl group; biphenyl group unsubstituted or substituted with deuterium, a halogen group, an alkyl group or a fluoroalkyl group; a naphthyl group unsubstituted or substituted with deuterium, a halogen group, an alkyl group or a fluoroalkyl group; a phenanthrene group unsubstituted or substituted with deuterium, a halogen group, an alkyl group or a fluoroalkyl group; a fluorene group unsubstituted or substituted with deuterium, a halogen group, an alkyl group or a fluoroalkyl group; or a dibenzofuran group unsubstituted or substituted with deuterium, a halogen group, an alkyl group or a fluoroalkyl group.

In one embodiment of the present specification, Ar1 is a phenyl group unsubstituted or substituted with deuterium, F, a linear or branched alkyl group having 1 to 10 carbon atoms, or a trifluoromethyl group; a biphenyl group unsubstituted or substituted with deuterium, F, a linear or branched alkyl group having 1 to 10 carbon atoms, or a trifluoromethyl group; a naphthyl group unsubstituted or substituted with deuterium, F, a linear or branched alkyl group having 1 to 10 carbon atoms, or a trifluoromethyl group; a phenanthrene group unsubstituted or substituted with deuterium, F, a linear or branched alkyl group having 1 to 10 carbon atoms, or a trifluoromethyl group; a fluorene group substituted with an alkyl group having 1 to 3 carbon atoms; or a dibenzofuran group unsubstituted or substituted with an alkyl group having 1 to 5 carbon atoms.

In one embodiment of the present specification, Ar2 is a substituted or unsubstituted phenyl group.

In one embodiment of the present specification, Ar2 is a phenyl group unsubstituted or substituted with a halogen group or an alkyl group.

In one embodiment of the present specification, Ar2 is a phenyl group unsubstituted or substituted with F, or an alkyl group having 1 to 10 carbon atoms.

In one embodiment of the present specification, Ar2 is a phenyl group unsubstituted or substituted with F, or a linear or branched alkyl group having 1 to 10 carbon atoms.

In one embodiment of the present specification, Ar2 is a phenyl group.

In one embodiment of the present specification, R1 to R4 are the same as or different from each other, and each independently hydrogen; deuterium; a halogen group; a nitrile group; a substituted or unsubstituted alkyl group; a substituted or unsubstituted aryl group; or a substituted or unsubstituted heterocyclic group.

In one embodiment of the present specification, R1 to R4 are hydrogen; or a substituted or unsubstituted aryl group.

In one embodiment of the present specification, R1 to R4 are hydrogen; or a substituted or unsubstituted phenyl group.

In one embodiment of the present specification, R1 to R4 are hydrogen; or a phenyl group unsubstituted or substituted with deuterium or a halogen group.

In one embodiment of the present specification, R1 to R4 are hydrogen; or a phenyl group unsubstituted or substituted with deuterium or F.

In one embodiment of the present specification, R1 is hydrogen; or a substituted or unsubstituted aryl group.

In one embodiment of the present specification, R1 is hydrogen; or a substituted or unsubstituted phenyl group.

In one embodiment of the present specification, R1 is hydrogen; or a phenyl group unsubstituted or substituted with deuterium or a halogen group.

In one embodiment of the present specification, R1 is hydrogen; or a phenyl group unsubstituted or substituted with deuterium or F.

In one embodiment of the present specification, R2 to R4 are hydrogen.

In one embodiment of the present specification, R1 to R4 are hydrogen.

In one embodiment of the present specification, r1 to r3 are each from 1 to 3, r4 is from 1 to 4, and when r1 to r4 are each 2 or greater, the two or more R1 to R4 are each the same as or different from each other.

In one embodiment of the present specification, X1 to X3 are selected from among the following structures.

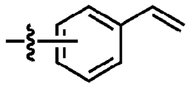

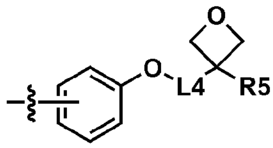

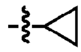

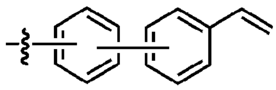

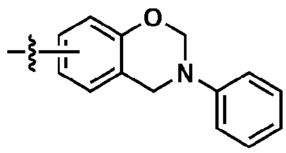

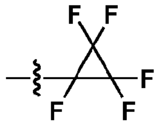

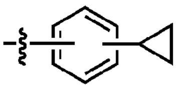

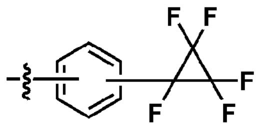

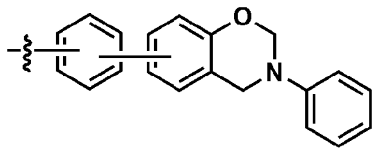

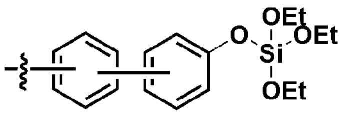

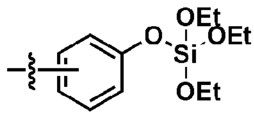

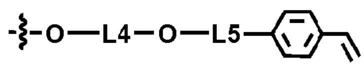

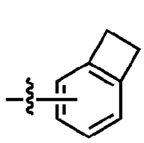

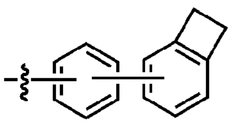

In the structural formulae,

L4 is a substituted or unsubstituted alkylene group;
L5 is a direct bond; or a substituted or unsubstituted arylene group; and
R5 is hydrogen, or a substituted or unsubstituted alkyl group.

In one embodiment of the present specification, L4 is a substituted or unsubstituted alkylene group having 1 to 20 carbon atoms.

In one embodiment of the present specification, L4 is a substituted or unsubstituted alkylene group having 1 to 10 carbon atoms.

In one embodiment of the present specification, L4 is a substituted or unsubstituted alkylene group having 1 to 8 carbon atoms.

In one embodiment of the present specification, L4 is a linear or branched alkylene group having 1 to 20 carbon atoms.

In one embodiment of the present specification, L4 is a linear or branched alkylene group having 1 to 10 carbon atoms.

In one embodiment of the present specification, L4 is a linear or branched alkylene group having 1 to 8 carbon atoms.

In one embodiment of the present specification, L5 is a direct bond; or a substituted or unsubstituted arylene group.

In one embodiment of the present specification, L5 is a direct bond; a substituted or unsubstituted phenylene group; or a substituted or unsubstituted naphthylene group.

In one embodiment of the present specification, L5 is a direct bond; a phenylene group unsubstituted or substituted with an alkyl group; or a naphthylene group unsubstituted or substituted with an alkyl group.

In one embodiment of the present specification, L5 is a direct bond; a phenylene group unsubstituted or substituted with an alkyl group having 1 to 3 carbon atoms; or a naphthylene group unsubstituted or substituted with an

alkyl group having 1 to 3 carbon atoms.

In one embodiment of the present specification, L5 is a direct bond; a phenylene group unsubstituted or substituted with a methyl group; or a naphthylene group unsubstituted or substituted with a methyl group.

In one embodiment of the present specification, L5 is a direct bond; a phenylene group unsubstituted or substituted with a methyl group; or a naphthylene group.

In one embodiment of the present specification, X3 is

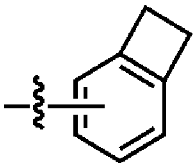 ; 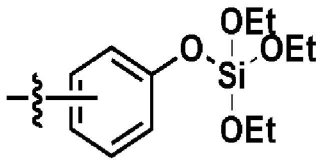 ; or 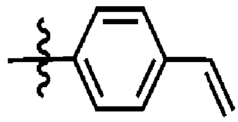 .

In one embodiment of the present specification, X3 is

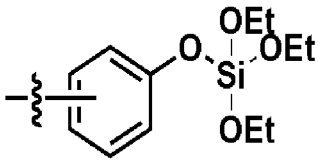 ; or 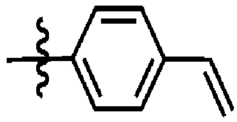 .

In one embodiment of the present specification, X3 is

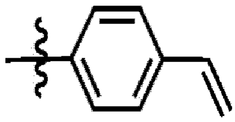 .

In one embodiment of the present specification, X1 and X2 are the same as or different from each other, and each independently

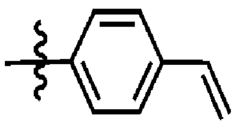 ; 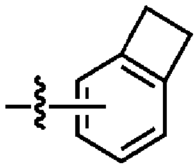 ; 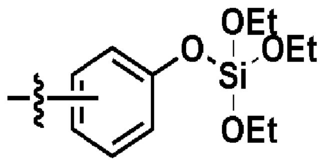

or

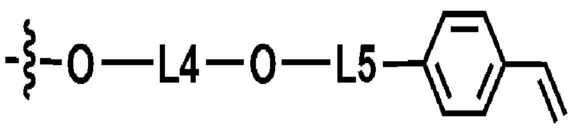 .

In one embodiment of the present specification, X1 and X2 are the same as or different from each other, and each independently

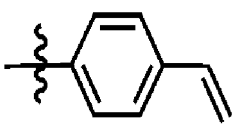 ; 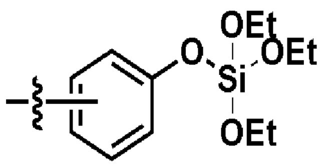 ;

or

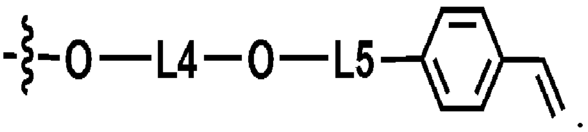

In one embodiment of the present specification, X1 to X3 are

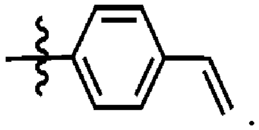

In one embodiment of the present specification, a1 and a2 are each 0 or 1.

In one embodiment of the present specification, when a2 is 0, L2 is a substituted or unsubstituted aryl group.

In one embodiment of the present specification, when a2 is 0, L2 is a substituted or unsubstituted phenyl group.

In one embodiment of the present specification, when a2 is 0, L2 is a phenyl group unsubstituted or substituted with deuterium, an alkyl group, a fluoroalkyl group or a halogen group.

In one embodiment of the present specification, when a2 is 0, L2 is a phenyl group unsubstituted or substituted with deuterium, a fluoroalkyl group having 1 to 3 carbon atoms, an alkyl group having 1 to 5 carbon atoms, or F.

In one embodiment of the present specification, when a2 is 0, L2 is a phenyl group.

In one embodiment of the present specification, when a2 is 1, L2 is a direct bond; or a substituted or unsubstituted arylene group.

In one embodiment of the present specification, when a2 is 1, L2 is a direct bond; or a substituted or unsubstituted phenylene group.

In one embodiment of the present specification, when a2 is 1, L2 is a direct bond; or a phenylene group.

In one embodiment of the present specification, m is 1 or 2, and when m is 2, L1s are the same as or different from each other, and L1 is a direct bond; or a substituted or unsubstituted arylene group.

In one embodiment of the present specification, L1 is a direct bond; a substituted or unsubstituted phenylene group; a substituted or unsubstituted naphthylene group; or a substituted or unsubstituted divalent fluorene group.

In one embodiment of the present specification, L1 is a direct bond; a phenylene group unsubstituted or substituted with an alkyl group; a naphthylene group unsubstituted or substituted with an alkyl group; a divalent fluorene group unsubstituted or substituted with an alkyl group.

In one embodiment of the present specification, L1 is a direct bond; a phenylene group unsubstituted or substituted with a methyl group; a naphthylene group; or a divalent fluorene group substituted with a methyl group.

In one embodiment of the present specification, L3 is a direct bond; or an alkylene group.

In one embodiment of the present specification, L3 is a direct bond; or an alkylene group having 1 to 20 carbon atoms.

In one embodiment of the present specification, L3 is a direct bond; or an alkylene group having 1 to 10 carbon atoms.

In one embodiment of the present specification, L3 is a direct bond; or a linear or branched alkylene group having 1 to 10 carbon atoms.

In one embodiment of the present specification, L3 is a direct bond.

In one embodiment of the present specification, at least one of R101 to R120 is F; a cyano group; or a substituted or unsubstituted fluoroalkyl group.

In one embodiment of the present specification, at least one of the remaining R101 to R120 is a curing group.

In one embodiment of the present specification, the remaining R101 to R120 are the same as or different from each other, and each independently hydrogen; deuterium; a nitro group; a substituted or unsubstituted alkyl group; a substituted or unsubstituted alkenyl group; a substituted or unsubstituted amine group; a substituted or unsubstituted aryl group; or a substituted or unsubstituted heterocyclic group.

In one embodiment of the present specification, R121 to R130 are the same as or different from each other, and each independently hydrogen; deuterium; a nitro group; a halogen group; a substituted or unsubstituted alkyl group; a substituted or unsubstituted cycloalkyl group; a substituted or unsubstituted alkenyl group; a substituted or unsubstituted aryl group; or a substituted or unsubstituted heterocyclic group, or a curing group.

In one embodiment of the present specification, Chemical Formula 1 may be represented by the following

Chemical Formula 2.

[Chemical Formula 2]

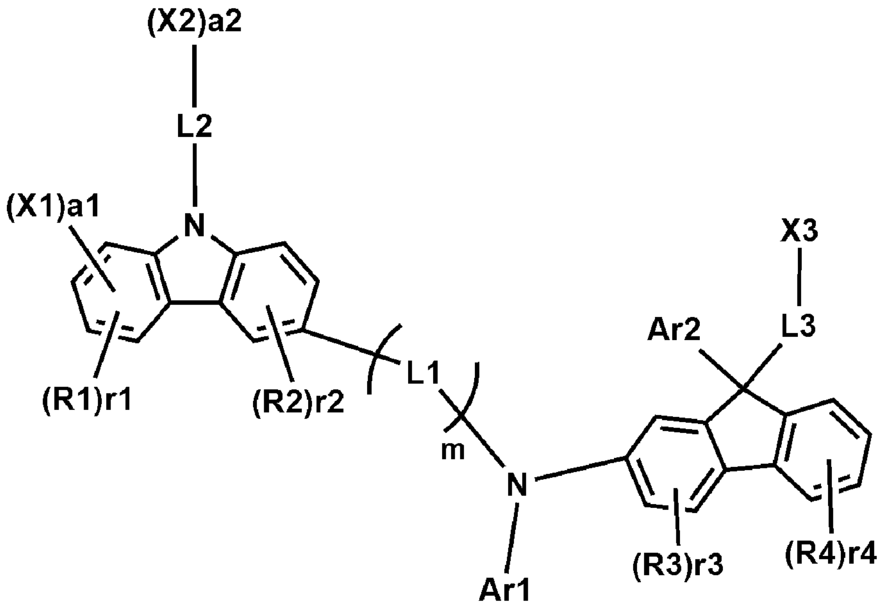

In Chemical Formula 2,

L1 to L3, Ar1, Ar2, R1 to R4, r1 to r4, X1 to X3, m, a1 and a2 have the same definitions as in Chemical Formula 1. In one embodiment of the present specification, the compound represented by Chemical Formula 1 is any one selected from among the following compounds.

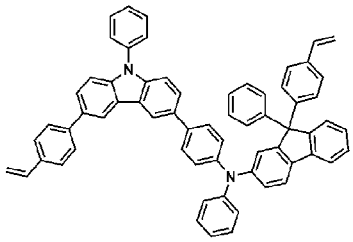

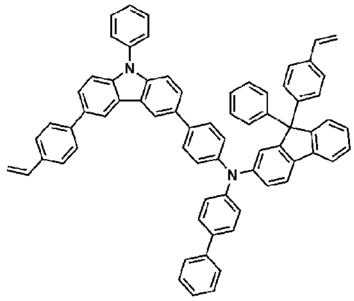

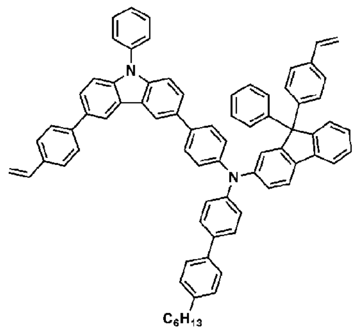

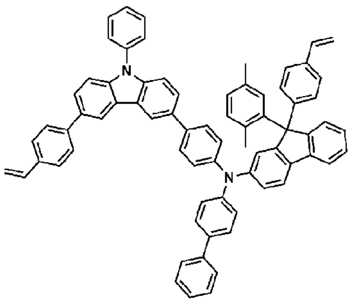

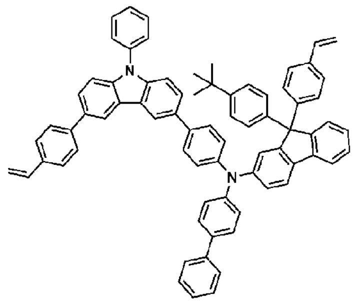

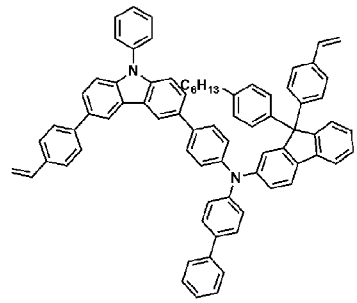

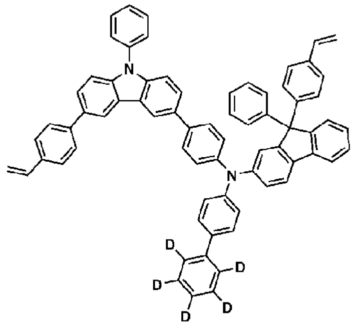

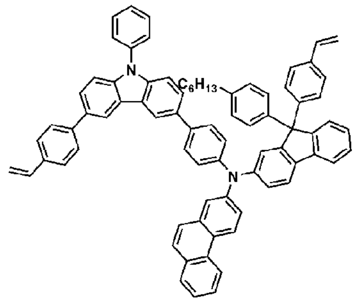

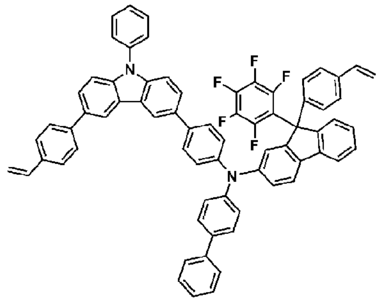

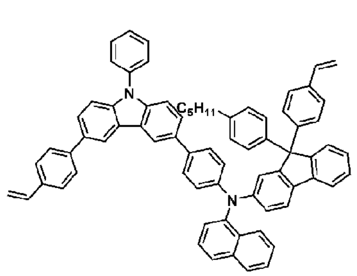

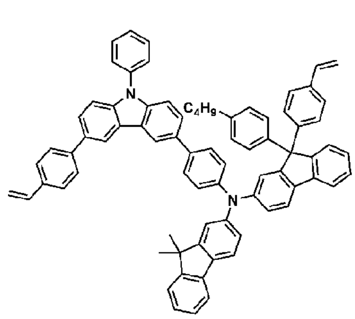

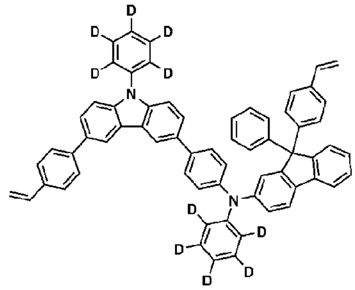

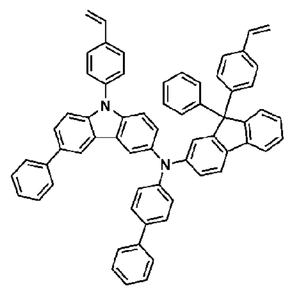

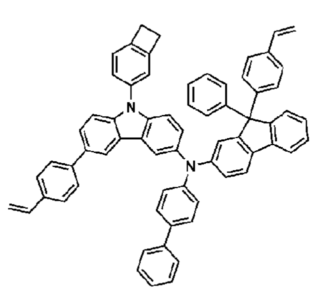

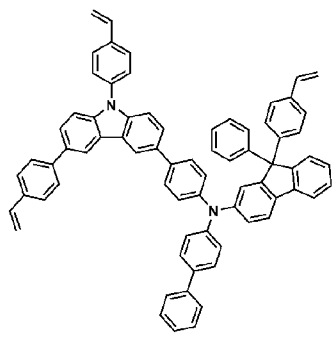

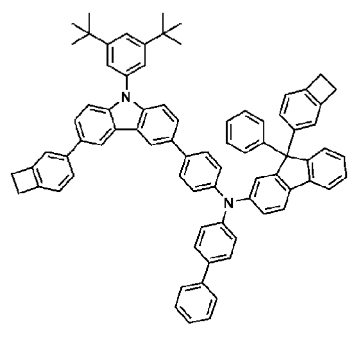

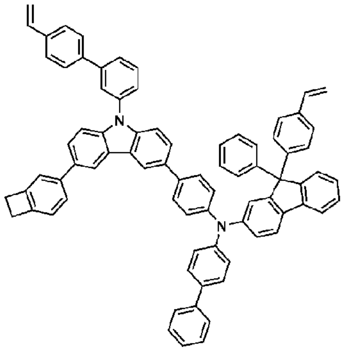

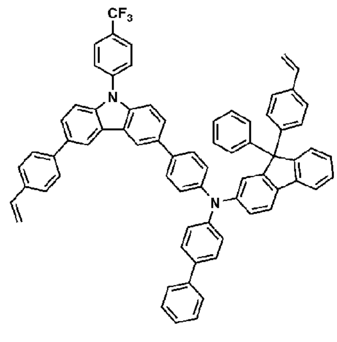

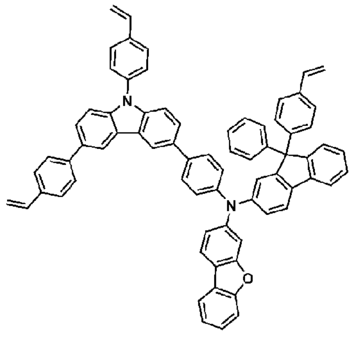
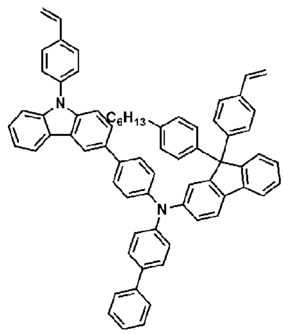
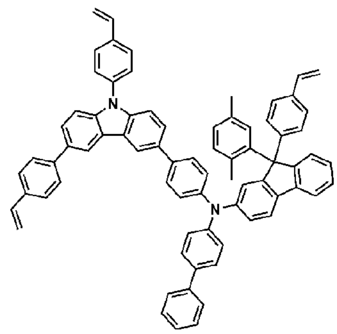

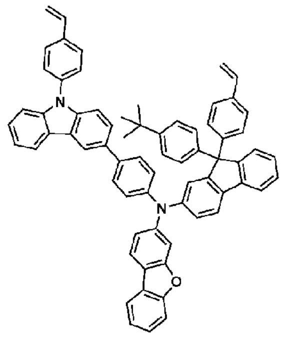
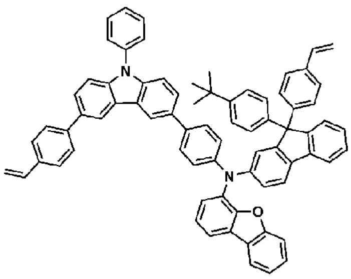
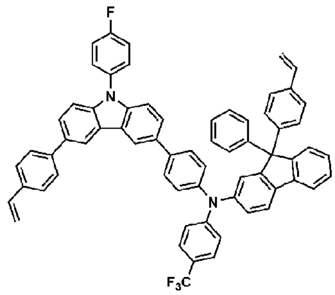

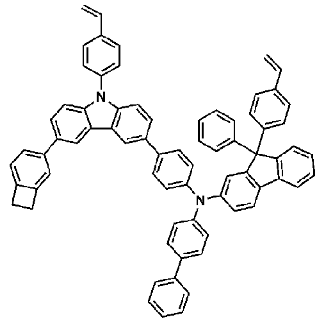
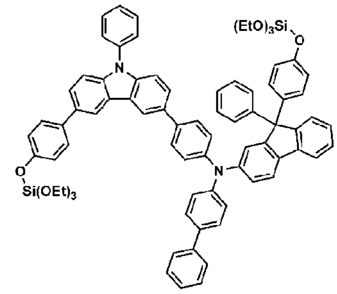
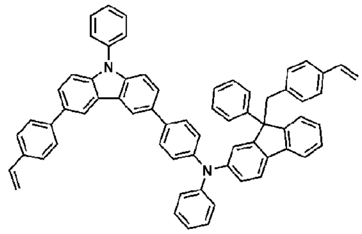

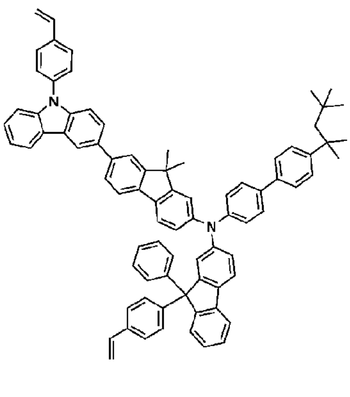
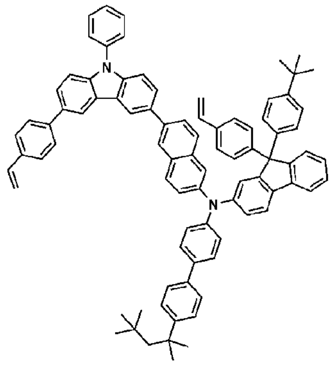
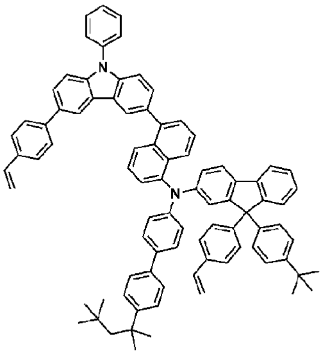

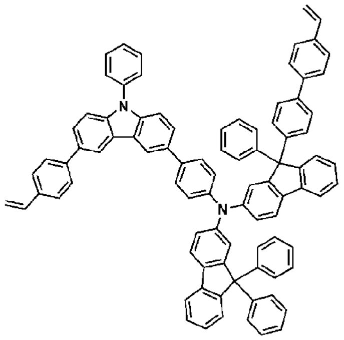
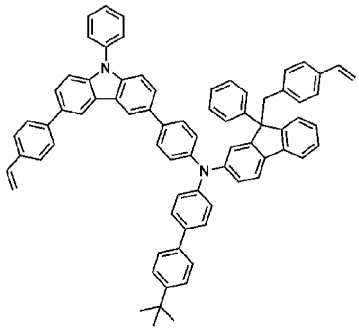
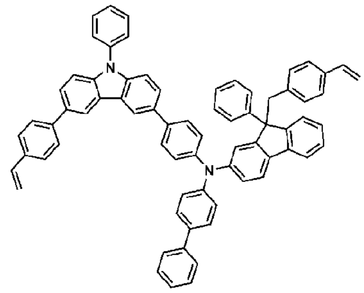

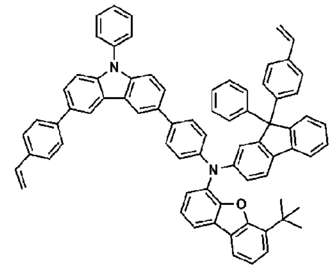
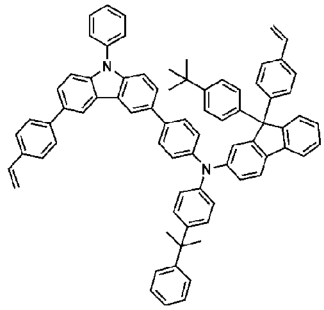
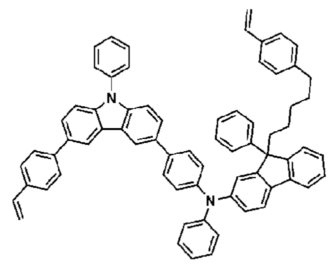

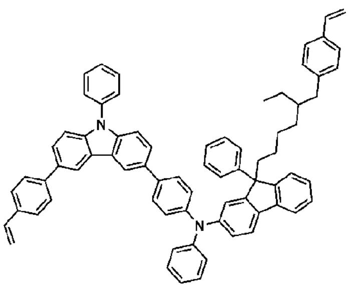
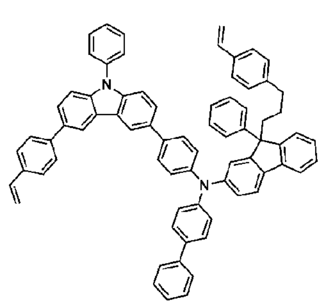
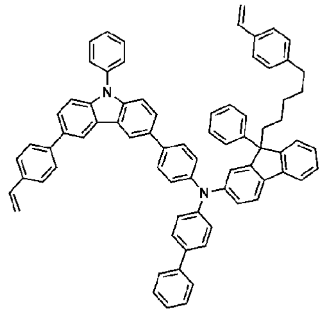

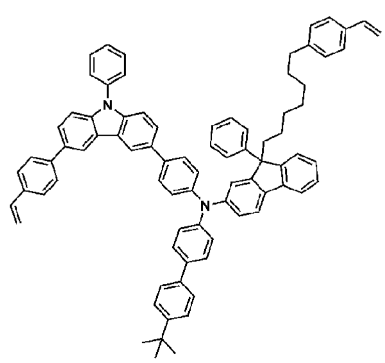
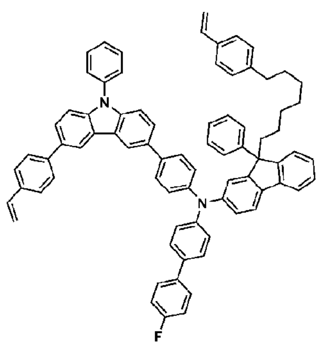
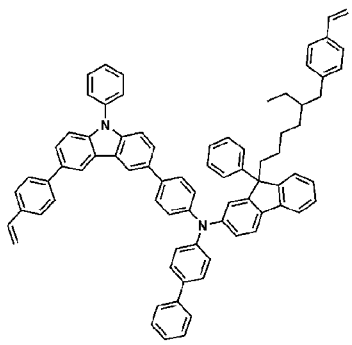

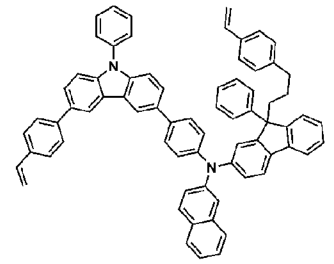
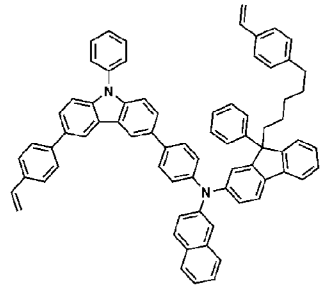
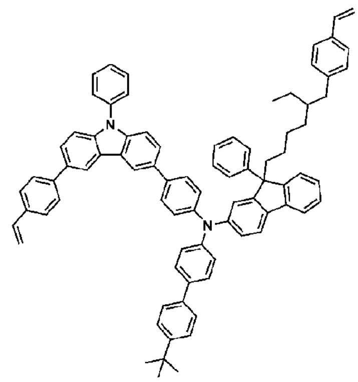

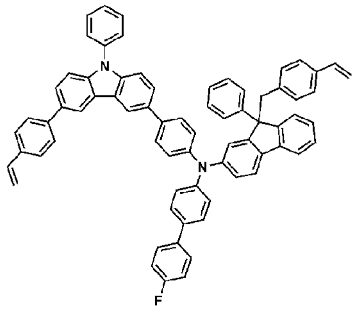
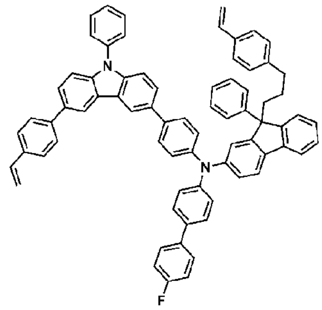
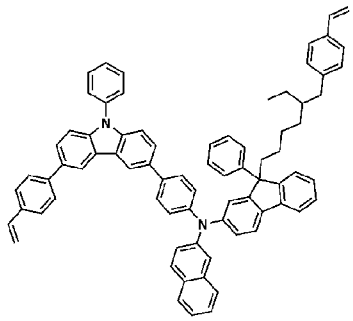

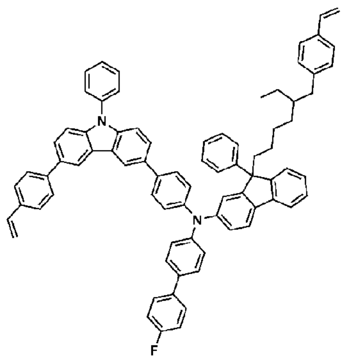
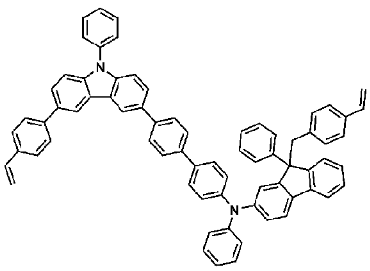
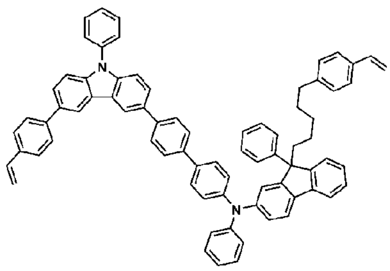

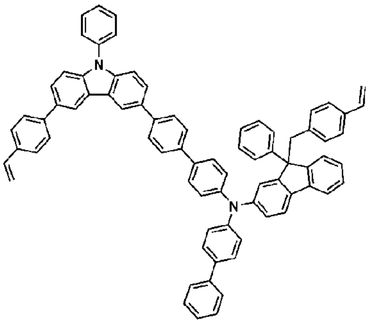
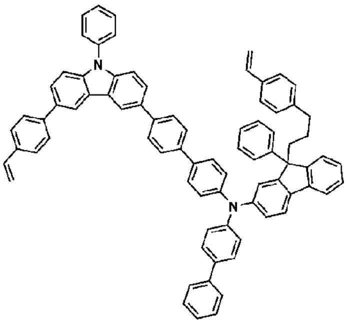
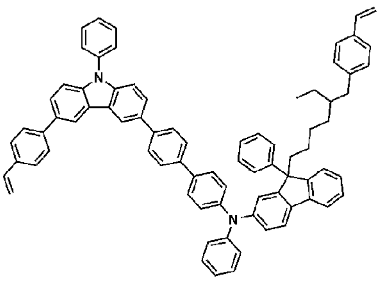

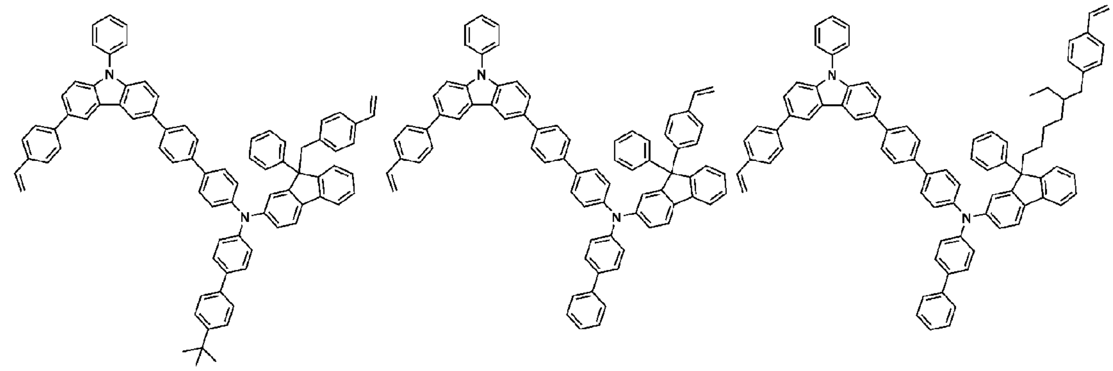

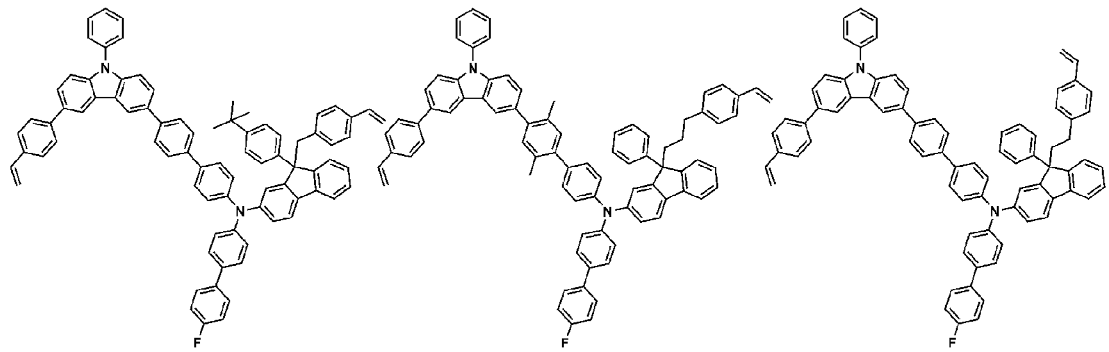

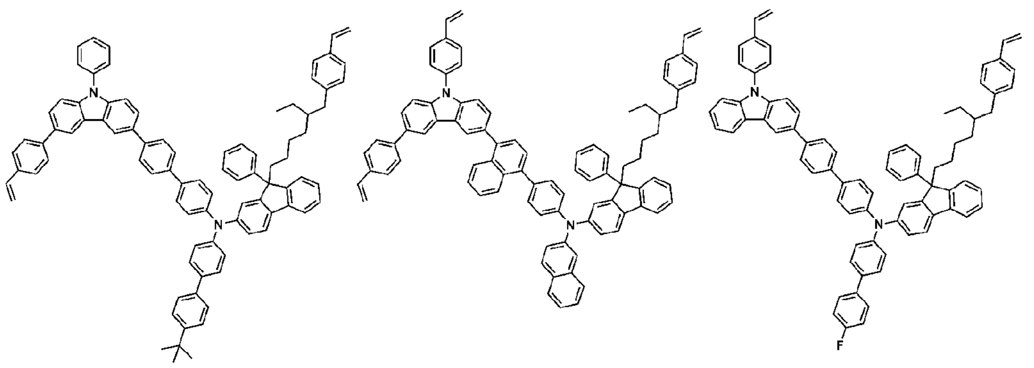

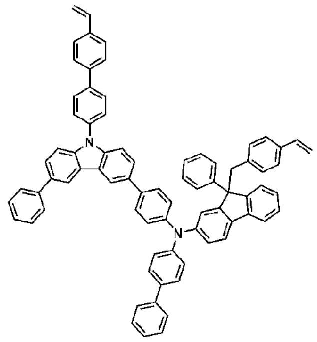

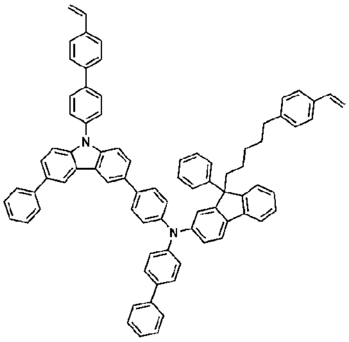

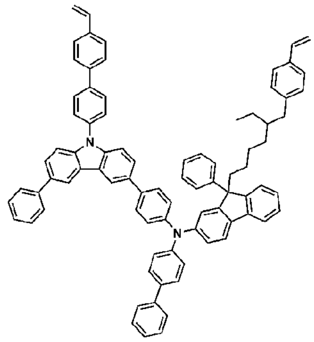

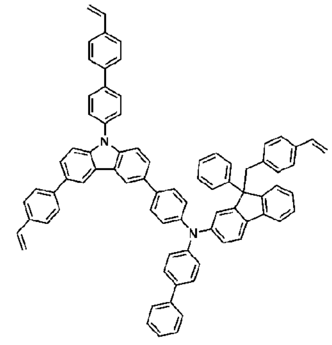
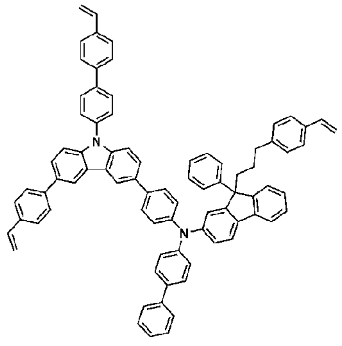
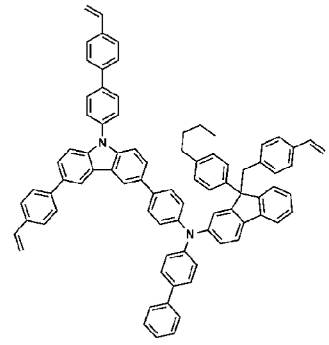

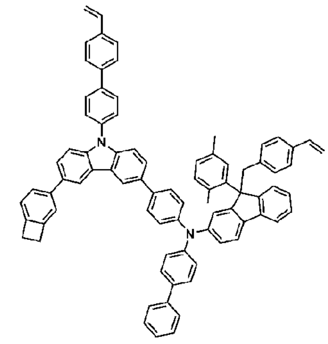
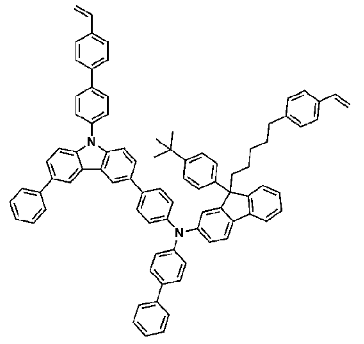
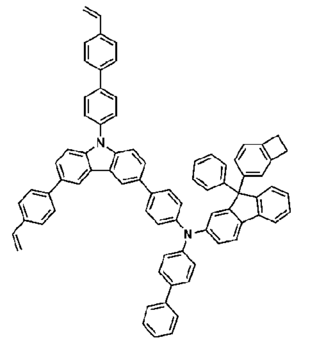

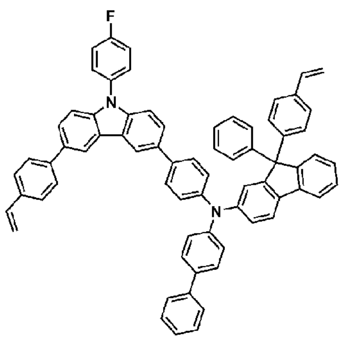
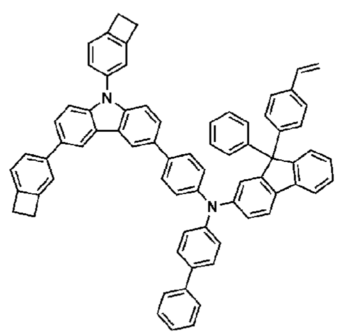
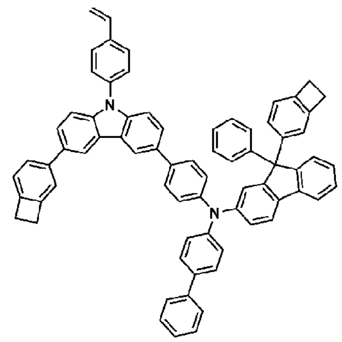

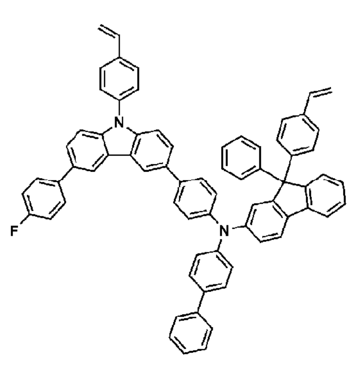
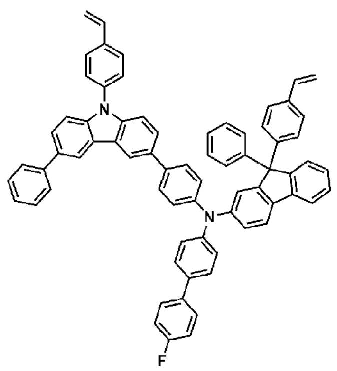
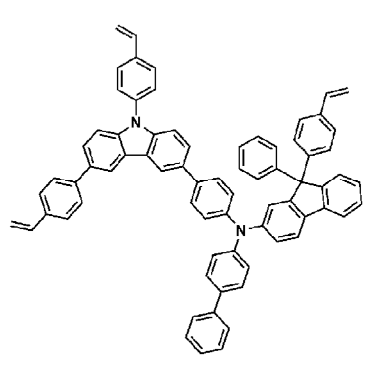

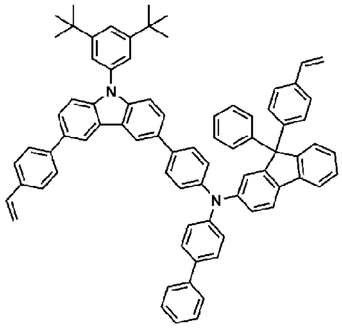
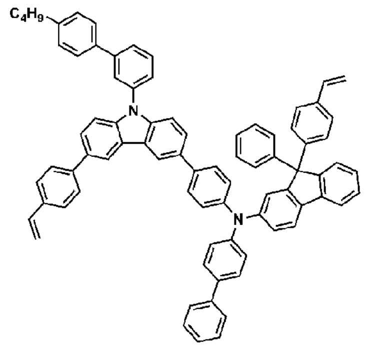
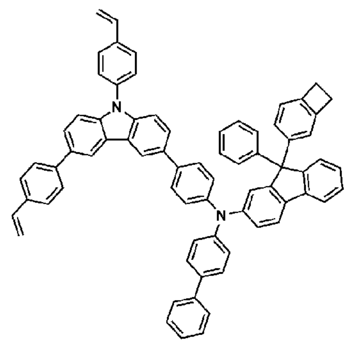

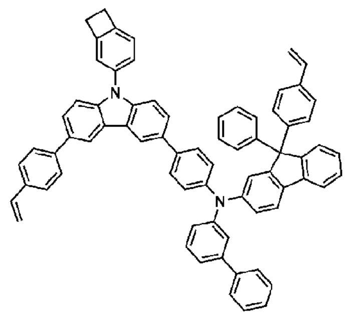
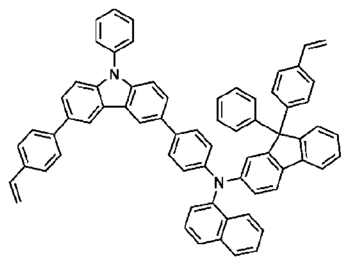
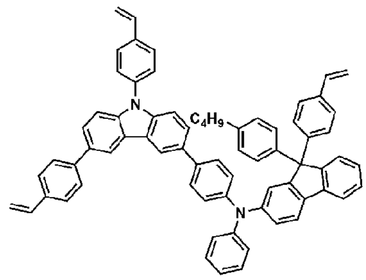

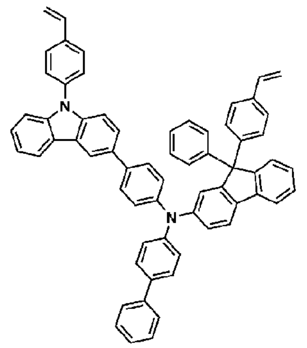
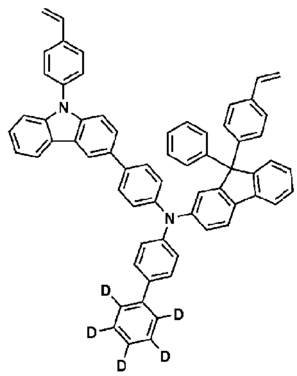
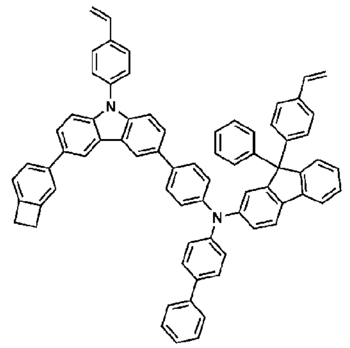

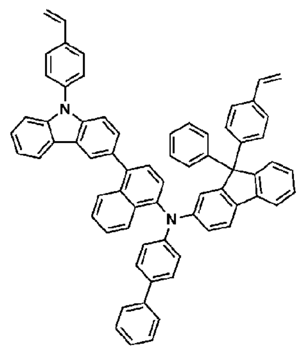
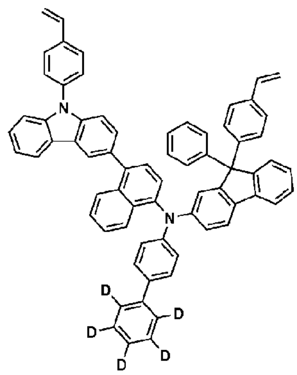
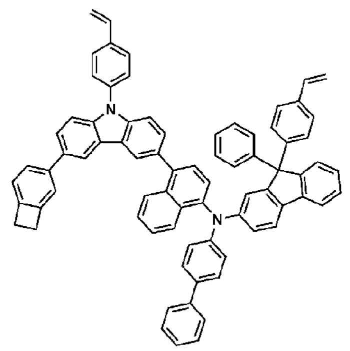

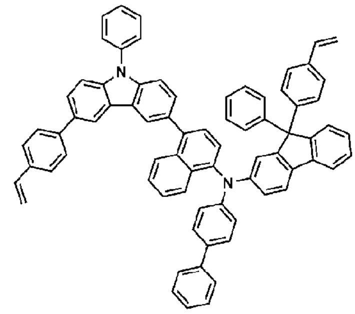
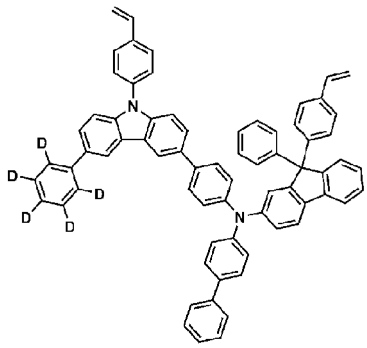
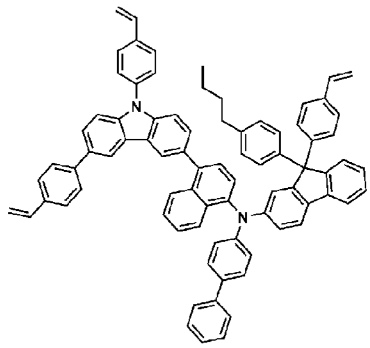

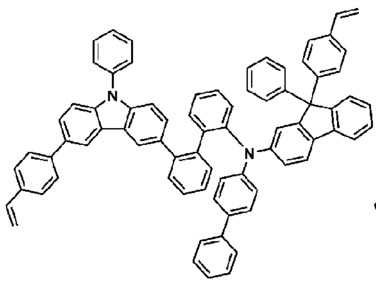
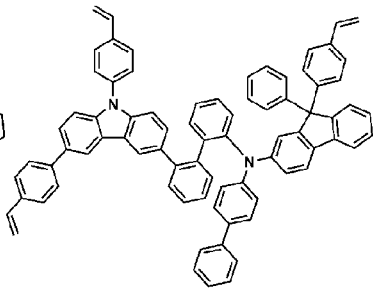
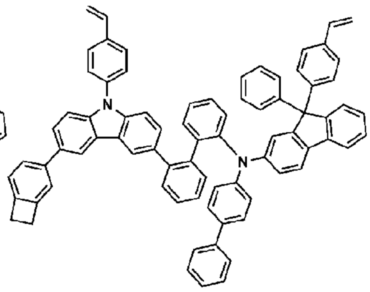

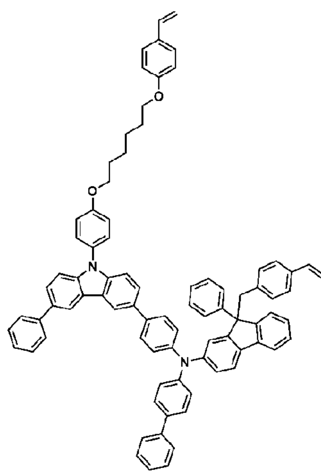
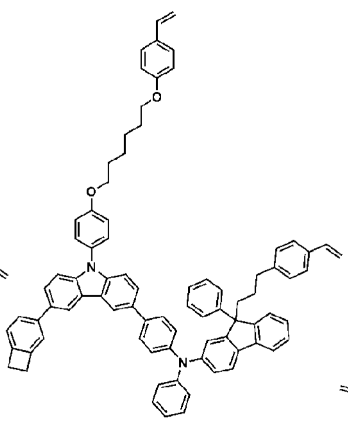
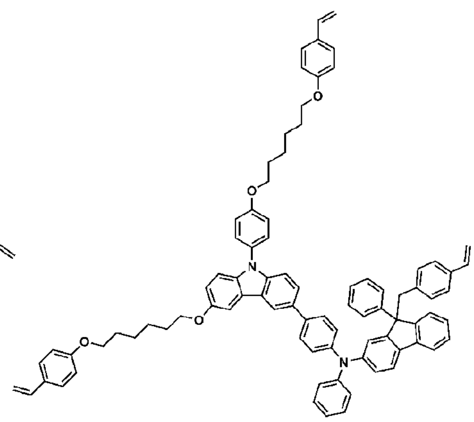

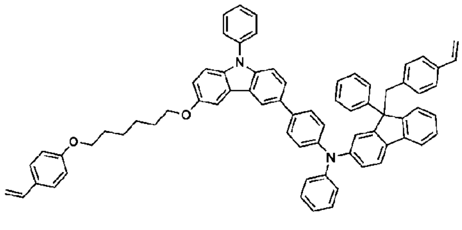
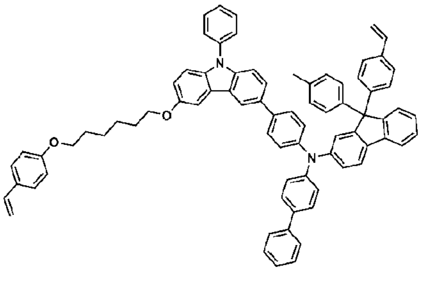

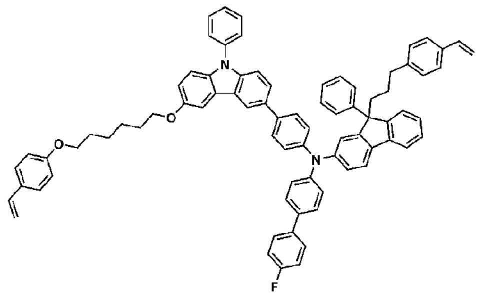 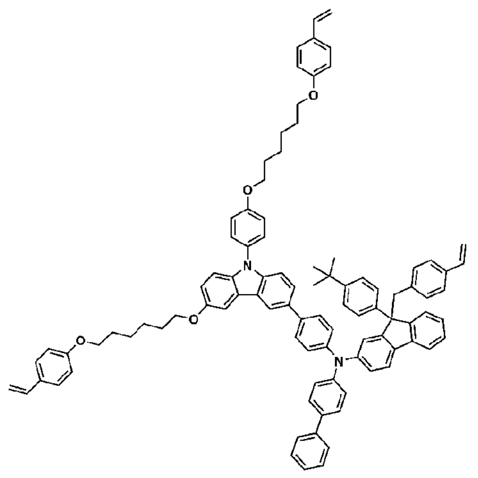

In the present specification, the "curing group" may mean a reactive substituent crosslinking compounds by being exposed to heat and/or light. The crosslinking may be produced by linking radicals produced while carbon-carbon multiple bonds or cyclic structures are decomposed by heat treatment or light irradiation.

In one embodiment of the present specification, the curing group is any one selected from among the following structures.

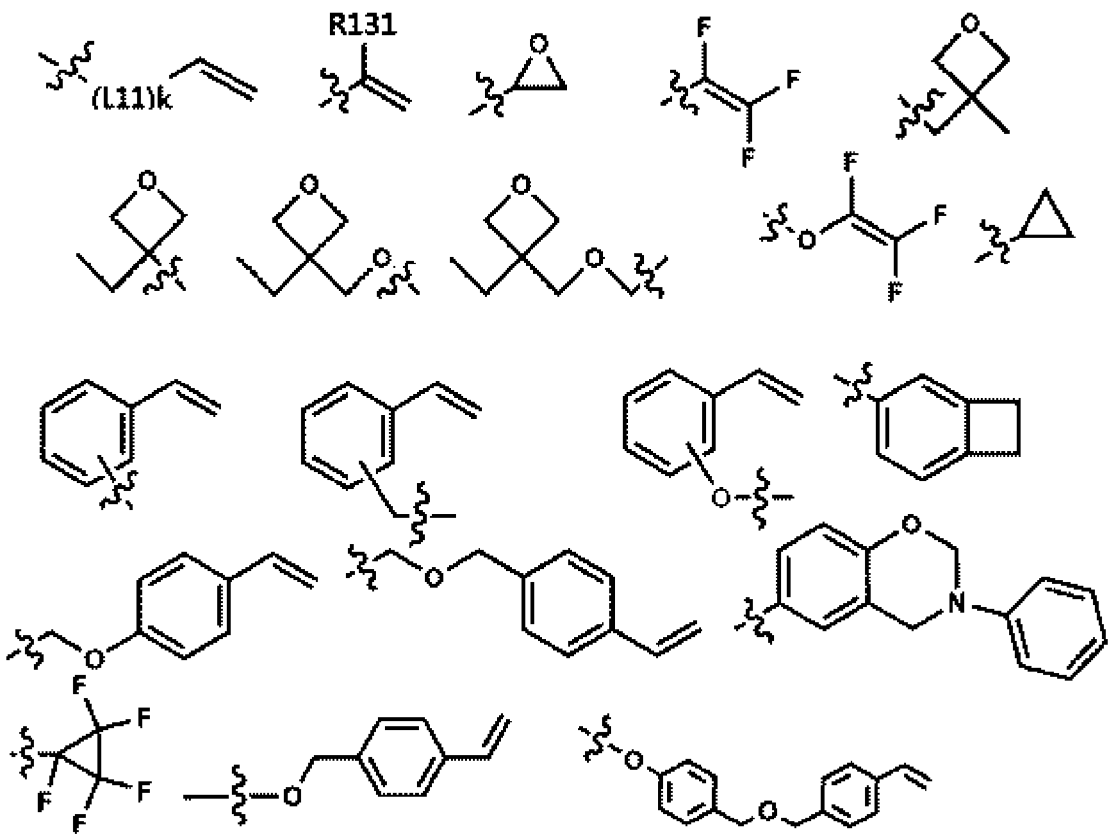

In the structures,

L11 is a direct bond; -O-; -S-; a substituted or unsubstituted alkylene group; a substituted or unsubstituted arylene group; or a substituted or unsubstituted heteroarylene group,
k is 1 or 2,
when k is 2, L11s are the same as or different from each other, and
R131 is a substituted or unsubstituted alkyl group.

In one embodiment of the present specification, the curing group of Chemical Formula 11 is a vinyl group.

In one embodiment of the present specification, R103, R108, R113 and R118 of Chemical Formula 11 are the same as or different from each other, and each independently a vinyl group or F.

In one embodiment of the present specification, at least one of R103, R108, R113 and R118 of Chemical Formula 11 is a curing group.

In one embodiment of the present specification, at least one of R103, R108, R113 and R118 of Chemical Formula 11 is a vinyl group.

In one embodiment of the present specification, at least one of R103, R108, R113 and R118 of Chemical Formula 11 is a vinyl group, and the rest are F.

In one embodiment of the present specification, the anion group represented by Chemical Formula 11 is any one selected from among the following structures.

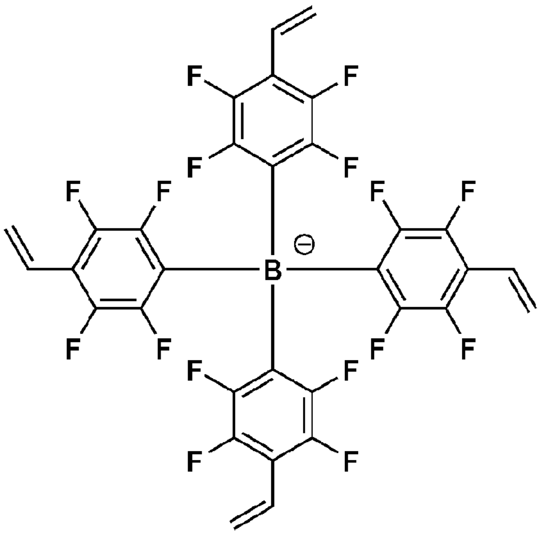

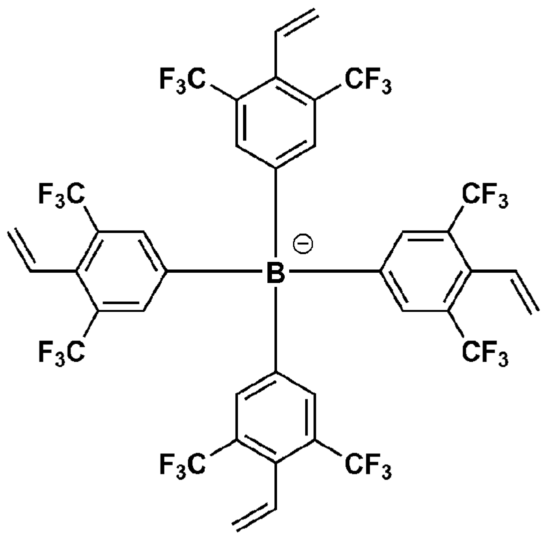

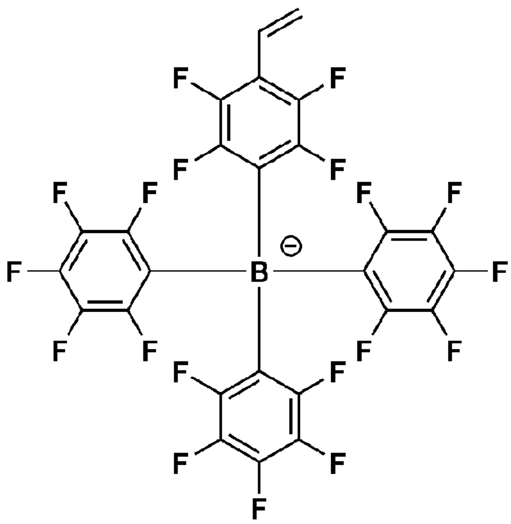

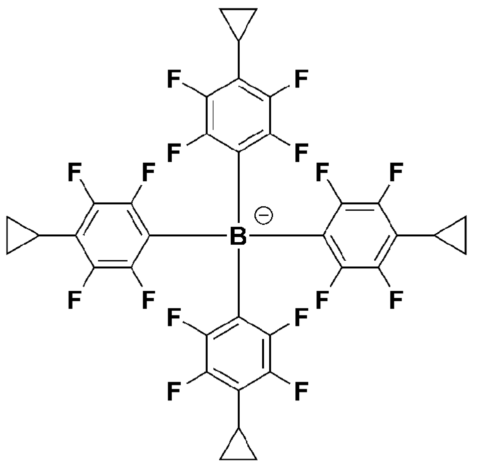

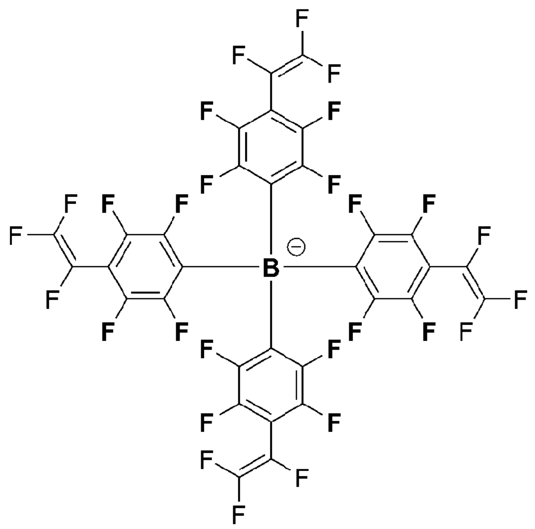

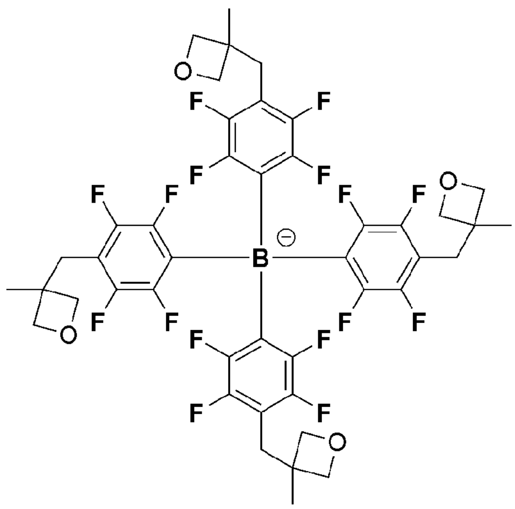

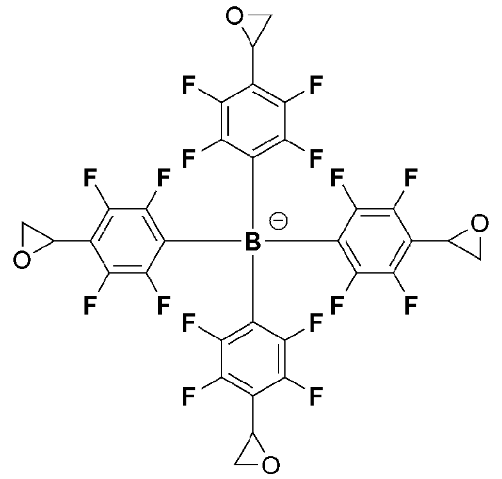

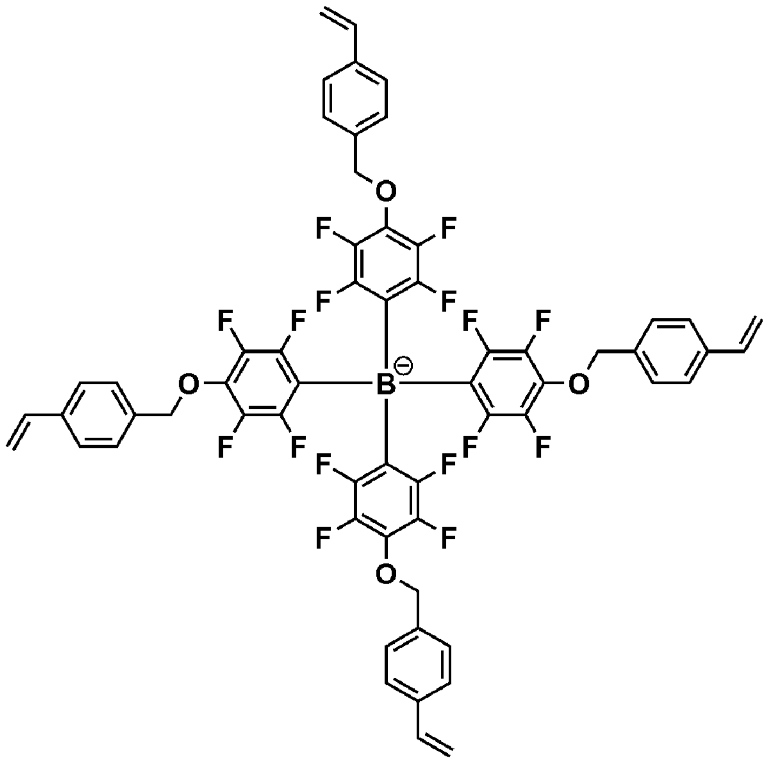

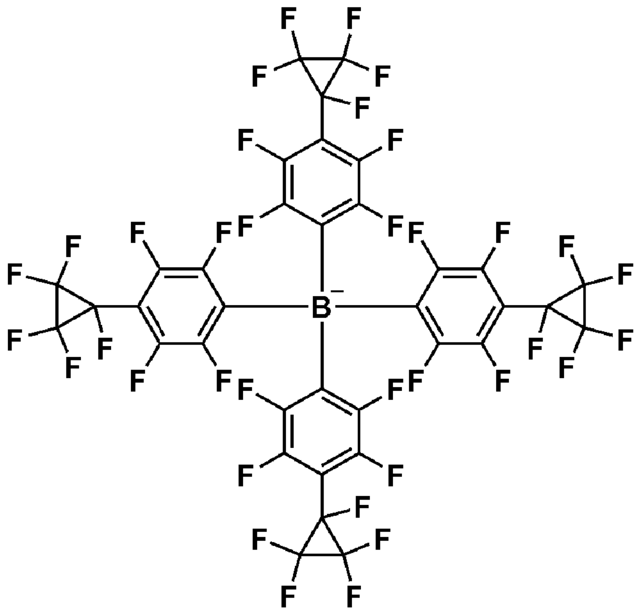

In one embodiment of the present specification, the ionic compound includes a cation group selected from among the following structural formulae.

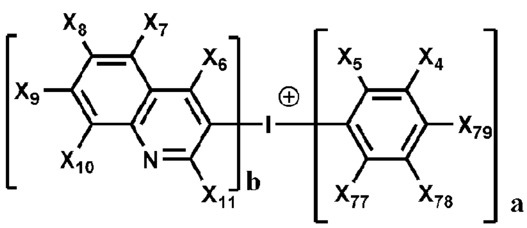

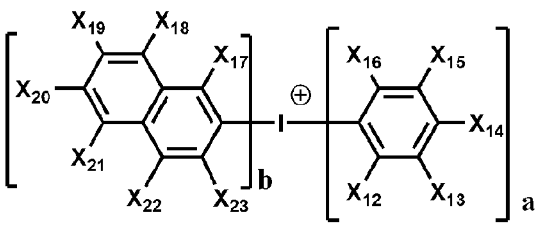

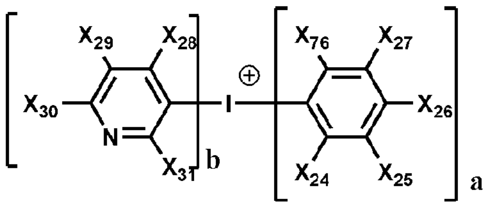
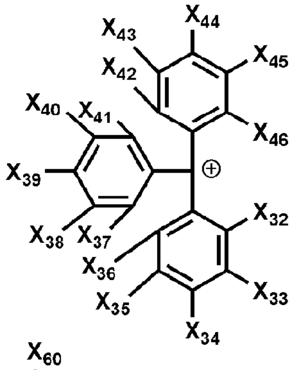
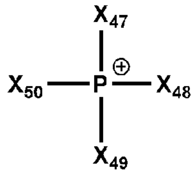
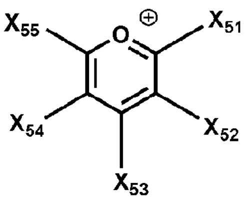
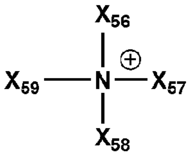
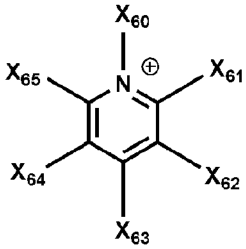
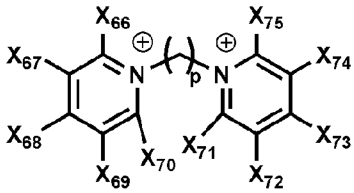
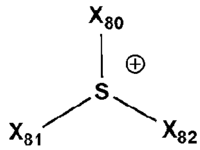

In the structural formulae,

$X_4$ to $X_{79}$ are the same as or different from each other, and each independently hydrogen; a cyano group; a nitro group; a halogen group; $-COOR_{200}$; a substituted or unsubstituted alkyl group; a substituted or unsubstituted alkoxy group; a substituted or unsubstituted cycloalkyl group; a substituted or unsubstituted fluoroalkyl group; or a substituted or unsubstituted aryl group, or the curing group,

$R_{200}$ is hydrogen; deuterium; or a substituted or unsubstituted alkyl group,

p is an integer of 0 to 10,

a is 1 or 2, b is 0 or 1, and a+b=2, and

$X_{80}$ to $X_{82}$ are the same as or different from each other, and each independently a substituted or unsubstituted alkyl group; a substituted or unsubstituted alkenyl group; a substituted or unsubstituted alkynyl group; a substituted or unsubstituted cycloalkyl group; a substituted or unsubstituted aryl group; or a substituted or unsubstituted heterocyclic group, or groups adjacent to each other bond to each other to form a ring.

In one embodiment of the present specification, the cation group is represented by the following Chemical Formula 12.

[Chemical Formula 12]

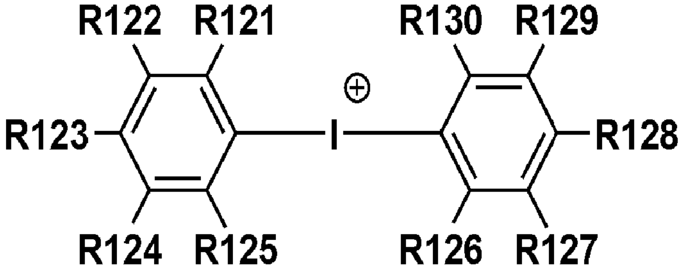

In Chemical Formula 12,
R121 to R130 are the same as or different from each other, and each independently hydrogen; deuterium; a nitro group;

a halogen group; a substituted or unsubstituted alkyl group; a substituted or unsubstituted cycloalkyl group; a substituted or unsubstituted alkenyl group; a substituted or unsubstituted aryl group; or a substituted or unsubstituted heterocyclic group, or the curing group.

In one embodiment of the present specification, the cation group is any one selected from among the following structural formulae.

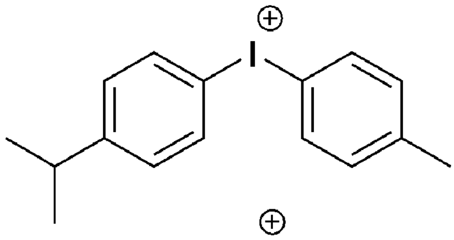

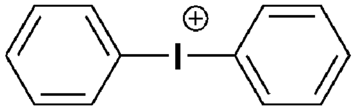

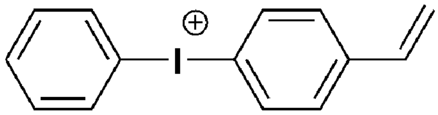

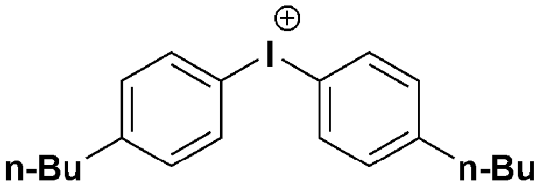

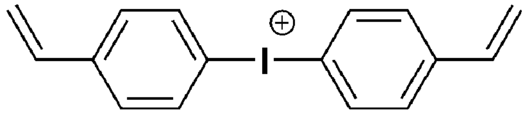

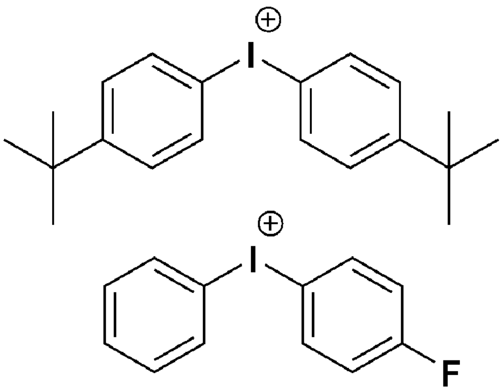

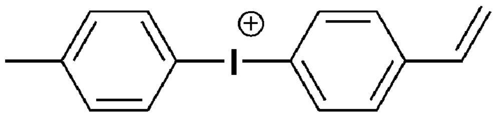

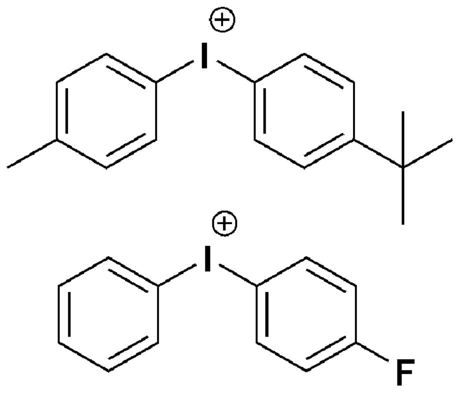

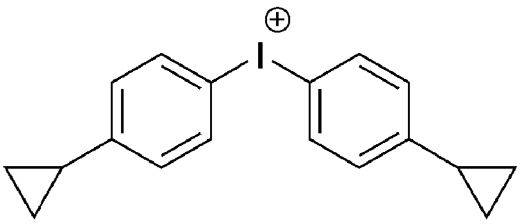

The compound according to one embodiment of the present specification may be prepared using preparation methods to describe below. In the preparation examples to describe below, representative examples are described, however, substituents may be added or excluded as necessary, and positions of the substituents may vary. In addition, based on technologies known in the art, starting materials, reaction materials, reaction conditions or the like may vary.

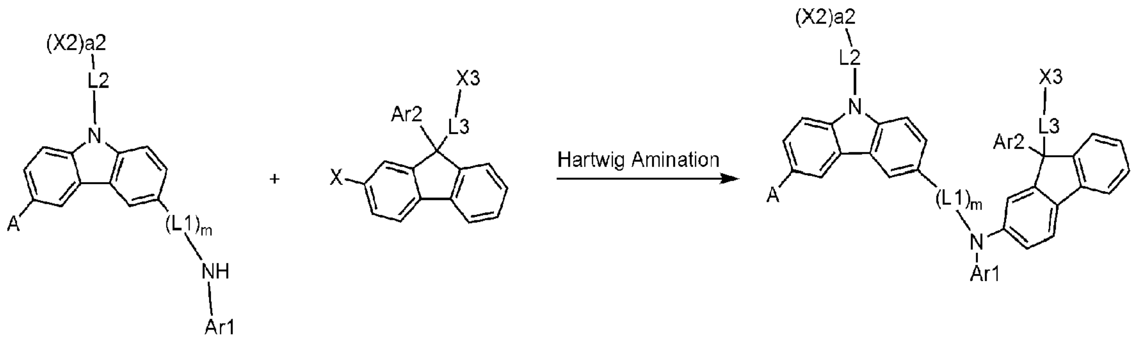


In the reaction formula, A is X1 or R1 of Chemical Formula 1, X is a halogen group, and L1, L2, Ar1, Ar2, L3, X2, X3 and m have the same definitions as in Chemical Formula 1.

The present specification provides, in one aspect, a coating composition including a cured material formed from the compound represented by Chemical Formula 1; and an ionic compound including the anion group represented by Chemical Formula 11 and the cation group represented by Chemical Formula 12.

According to one embodiment of the present specification, the coating composition may further include a solvent.

In one embodiment of the present specification, the coating composition may be a liquid phase. The "liquid phase" means in a liquid state at room temperature and atmospheric pressure.

In one embodiment of the present specification, examples of the solvent may include chlorine-based solvents such as chloroform, methylene chloride, 1,2-dichloroethane, 1,1,2-trichloroethane, chlorobenzene or o-dichlorobenzene; ether-based solvents such as tetrahydrofuran or dioxane; aromatic hydrocarbon-based solvents such as toluene, xylene, trimethylbenzene or mesitylene; aliphatic hydrocarbon-based solvents such as cyclohexane, methylcyclohexane, n-pentane, n-hexane, n-heptane, n-octane, n-nonane or n-decane; ketone-based solvents such as acetone, methyl ethyl ketone or cyclohexanone; ester-based solvents such as ethyl acetate, butyl acetate or ethyl cellosolve acetate; polyalcohols such as ethylene glycol, ethylene glycol monobutyl ether, ethylene glycol monoethyl ether, ethylene glycol monomethyl ether, dimethoxyethane, propylene glycol, diethoxymethane, triethylene glycol monoethyl ether, glycerin or 1,2-hexanediol, and derivatives thereof; alcohol-based solvents such as methanol, ethanol, propanol, isopropanol or cyclohexanol; sulfoxide-based solvents such as dimethyl sulfoxide; amide-based solvents such as N-methyl-2-pyrrolidone or N,N-dimethylformamide; benzoate-based solvents such as methyl benzoate, butyl benzoate or 3-phenoxybenzoate; tetraline, and the like, however, the solvent is not limited thereto as long as it is a solvent capable of dissolving or dispersing the compound according to one embodiment of the present specification.

In another embodiment, the solvent may be used either alone as one type, or as a mixture mixing two or more solvent types.

In another embodiment, the solvent preferably has a boiling point of 40°C to 250°C and more preferably 60°C to 230°C, however, the boiling point is not limited thereto.

In another embodiment, viscosity of the single or mixed solvent is preferably from 1 CP to 10 CP and more preferably from 3 CP to 8 CP, but is not limited thereto.

In another embodiment, the coating composition preferably has a concentration of 0.1 wt/v% to 20 wt/v% and more preferably 0.5 wt/v% to 5 wt/v%, however, the concentration is not limited thereto.

In one embodiment of the present specification, the coating composition may further include one, two or more types of additives selected from the group consisting of thermal polymerization initiators and photopolymerization initiators.

Examples of the thermal polymerization initiator may include peroxides such as methyl ethyl ketone peroxide, methyl isobutyl ketone peroxide, acetylacetone peroxide, methylcyclohexanone peroxide, cyclohexanone peroxide, isobutyryl peroxide, 2,4-dichlorobenzoyl peroxide, bis-3,5,5-trimethyl hexanoyl peroxide, lauryl peroxide, benzoyl peroxide, p-chlorobenzoyl peroxide, dicumyl peroxide, 2,5-dimethyl-2,5-(t-butyloxy)-hexane, 1,3-bis(t-butylperoxy-isopropyl)benzene, t-butyl cumyl peroxide, di-t-butyl peroxide, 2,5-dimethyl-2,5-(di-t-butylperoxy)hexane-3, tris-(t-butylperoxy)triazine, 1,1-di-t-butylperoxy-3,3,5-trimethylcyclohexane, 1,1-di-t-butylperoxycyclohexane, 2,2-di(t-butylperoxy)butane, 4,4-di-t-butylperoxy valeric acid n-butyl ester, 2,2-bis(4,4-t-butylperoxycyclohexyl)propane, t-butyl peroxyisobutyrate, di-t-butyl peroxyhexahydroterephthalate, t-butylperoxy-3,5,5-trimethylhexate, t-butyl peroxybenzoate or di-t-butyl peroxytrimethyl adipate; or azo-based such as azobis isobutylnitrile, azobis dimethylvaleronitrile or azobis cyclohexyl nitrile, but are not limited thereto.

Examples of the photopolymerization initiator may include acetophenone-based or ketal-based photopolymerization initiators such as diethoxyacetophenone, 2,2-dimethoxy-1,2-diphenyl ethan-1-one, 1-hydroxy-cyclohexyl-phenyl-ketone, 4-(2-hydroxyethoxy)phenyl-(2-hydroxy-2-propyl)ketone, 2-benzyl-2-dimethylamino-1-(4-morpholinophenyl)butanone-1,2-hydroxy-2-methyl-1-phenylpropan-1-one, 2-methyl-2-morpholino(4-methylthiophenyl)propan-1-one or 1-phenyl-1,2-propanedion-2-(o-ethoxycarbonyl)oxime; benzoin ether-based photopolymerization initiators such as benzoin, benzoin methyl ether, benzoin ethyl ether, benzoin isobutyl ether or benzoin isopropyl ether; benzophenone-based photopolymerization initiators such as benzophenone, 4-hydroxybenzophenone, 2-benzoylnaphthalene, 4-benzoylbiphenyl, 4-benzoyl phenyl ether, acrylated benzophenone or 1,4-benzoylbenzene; thioxanthone-based photopolymerization initiators such as 2-isopropylthioxanthone, 2-chlorothioxanthone, 2,4-dimethylthioxanthone, 2,4-diethylthioxanthone or 2,4-dichlorothioxanthone; and, as other photopolymerization initiators, ethyl anthraquinone, 2,4,6-trimethylbenzoyldiphenylphosphine oxide, 2,4,6-trimethylbenzoylphenylethoxyphosphine oxide, bis(2,4,6-trimethylbenzoyl)phenylphosphine oxide, bis(2,4-dimethoxybenzoyl)-2,4,4-trimethylpentylphosphine oxide, methylphenylglyoxyester, 9,10-phenanthrene, acridine-based compounds, triazine-based compounds, imidazole-based compounds, and the like, but are not limited thereto.

In addition, those having a photopolymerization facilitating effect may be used either alone or together with the photopolymerization initiator. Examples thereof may include triethanolamine, methyldiethanolamine, ethyl 4-dimethylaminobenzoate, isoamyl 4-dimethylaminobenzoate, (2-dimethylamino)ethyl benzoate, 4,4'-dimethylaminobenzophenone and the like, but are not limited thereto.

The present invention provides an organic light emitting device formed using the coating composition.

In one embodiment of the present specification, the first electrode is a cathode, and the second electrode is an anode.

In another embodiment, the first electrode is an anode, and the second electrode is a cathode.

In one embodiment of the present specification, the organic material layer formed using the coating composition is a hole transfer layer, a hole injection layer, or a layer carrying out hole transfer and hole injection at the same time.

In one embodiment of the present specification, the organic material layer including the cured material is a light emitting layer.

In one embodiment of the present specification, the organic light emitting device may further include one, two or more layers selected from the group consisting of a hole injection layer, a hole transfer layer, an electron transfer layer, an electron injection layer, an electron blocking layer and a hole blocking layer.

In another embodiment, the organic light emitting device may be an organic light emitting device having a structure in which an anode, one or more organic material layers and a cathode are consecutively laminated on a substrate (normal type).

In another embodiment, the organic light emitting device may be an organic light emitting device having a structure in a reverse direction in which a cathode, one or more organic material layers and an anode are consecutively laminated on a substrate (inverted type).

The organic material layer of the organic light emitting device of the present specification may be formed in a single layer structure, but may also be formed in a multilayer structure in which two or more organic material layers are laminated. For example, the organic light emitting device of the present specification may have a structure including a hole injection layer, a hole transfer layer, a light emitting layer, an electron transfer layer, an electron injection layer and the like as the organic material layer. However, the structure of the organic light emitting device is not limited thereto, and may include a smaller number of organic material layers.

For example, a structure of the organic light emitting device according to one embodiment of the present specification is illustrated in FIG. 1.

FIG. 1 illustrates a structure of the organic light emitting device in which an anode (201), a hole injection layer (301), a hole transfer layer (401), a light emitting layer (501), an electron transfer layer (601) and a cathode (701) are consecutively laminated on a substrate (101).

FIG. 1 illustrates the organic light emitting device, however, the organic light emitting device is not limited thereto.

When the organic light emitting device includes a plurality of organic material layers, the organic material layers may be formed with materials that are the same as or different from each other.

The organic light emitting device of the present specification may be manufactured using materials and methods known in the art, except that one or more layers of the organic material layers are formed using the coating composition.

For example, the organic light emitting device of the present specification may be manufactured by consecutively laminating an anode, an organic material layer and a cathode on a substrate. Herein, the organic light emitting device may be manufactured by forming an anode on a substrate by depositing a metal, a metal oxide having conductivity, or an alloy thereof using a physical vapor deposition (PVD) method such as sputtering or e-beam evaporation, forming an organic material layer including a hole injection layer, a hole transfer layer, a light emitting layer and an electron transfer layer thereon, and then depositing a material capable of being used as a cathode thereon. In addition to such a method, the organic light emitting device may also be manufactured by consecutively depositing a cathode material, an organic material layer and an anode material on a substrate.

Another embodiment of the present specification provides a method for manufacturing an organic light emitting device formed using the coating composition.

Specifically, in one embodiment of the present specification, the method for manufacturing an organic light

emitting device includes preparing a substrate; forming a cathode or an anode on the substrate; forming one or more organic material layers on the cathode or the anode; and forming an anode or a cathode on the organic material layer, wherein the forming of organic material layers includes forming one or more organic material layers using the coating composition.

In one embodiment of the present specification, the organic material layer formed using the coating composition is formed using spin coating or inkjetting.

In another embodiment, the organic material layer formed using the coating composition is formed using a printing method.

In an embodiment of the present specification, examples of the printing method include inkjet printing, nozzle printing, offset printing, transfer printing, screen printing or the like, but are not limited thereto.

The coating composition according to one embodiment of the present specification is suited for a solution process due to its structural properties and may be formed using a printing method, and therefore, is economically effective in terms of time and costs when manufacturing a device.

In one embodiment of the present specification, the forming of an organic material layer formed using the coating composition includes coating the coating composition on the cathode or the anode; and heat treating or light treating the coated coating composition.

In one embodiment of the present specification, the time of heat treating the organic material layer formed using the coating composition is preferably within 1 hour and more preferably within 30 minutes.

In one embodiment of the present specification, the atmosphere of heat treating the organic material layer formed using the coating composition is preferably inert gas such as argon or nitrogen.

When the forming of organic material layers using the coating composition includes the heat treating or light treating, a plurality of fluorene groups included in the coating composition form crosslinking, and an organic material layer including a thin-filmed structure may be provided. In this case, being dissolved by a solvent deposited on a surface of the organic material layer formed using the coating composition, or being morphologically influenced or decomposed may be prevented.

Accordingly, when the organic material layer formed using the coating composition is formed including the heat treating or light treating, resistance for a solvent increases, and a multilayer may be formed by repeatedly performing solution deposition and crosslinking method, and as a result, lifetime properties of a device may be enhanced due to increased stability.

In one embodiment of the present specification, the coating composition including the compound may use a coating composition mixed to a polymer binder and dispersed.

In one embodiment of the present specification, as the polymer binder, those that do not extremely inhibit charge transfer are preferred, and those that do not have strong absorption for visible light are preferably used. Examples of the polymer binder may include poly(N-vinylcarbazole), polyaniline and derivatives thereof, polythiophene and derivatives thereof, poly(p-phenylenevinylene) and derivatives thereof, poly(2,5-thienylenevinylene) and derivatives thereof, polycarbonate, polyacrylate, polymethyl acrylate, polymethyl methacrylate, polystyrene, polyvinyl chloride, polysiloxane and the like.

In addition, the compound according to one embodiment of the present specification may be included alone in the organic material layer, or may be included as a copolymer using a coating composition mixed with other monomers. In addition, a copolymer or a mixture may be included using a coating composition mixed with other polymers.

As the anode material, materials having large work function are normally preferred so that hole injection to an organic material layer is smooth. Specific examples of the anode material capable of being used in the present specification include metals such as vanadium, chromium, copper, zinc and gold, or alloys thereof; metal oxides such as zinc oxide, indium oxide, indium tin oxide (ITO) and indium zinc oxide (IZO); combinations of metals and oxides such as ZnO:Al or $SnO_2$:Sb; conductive polymers such as poly(3-methylthiophene), poly[3,4-(ethylene-1,2-dioxy)thiophene] (PEDOT), polypyrrole and polyaniline, and the like, but are not limited thereto.

As the cathode material, materials having small work function are normally preferred so that electron injection to an organic material layer is smooth. Specific examples of the cathode material include metals such as magnesium, calcium, sodium, potassium, titanium, indium, yttrium, lithium, gadolinium, aluminum, silver, tin and lead, or alloys thereof; multilayer structure materials such as LiF/Al or $LiO_2$/Al, and the like, but are not limited thereto.

The hole injection layer is a layer that injects holes from an electrode, and the hole injection material is preferably a compound that has an ability to transfer holes and thereby has a hole injection effect in an anode and an excellent hole injection effect for a light emitting layer or a light emitting material, prevents excitons generated in the light emitting layer from moving to an electron injection layer or an electron injection material, and in addition thereto, has an excellent thin film forming ability. The highest occupied molecular orbital (HOMO) of the hole injection material is preferably in between the work function of an anode material and the HOMO of surrounding organic material layers. Specific examples of the hole injection material include metal porphyrins, oligothiophene, arylamine-based organic materials, hexanitrile hexaazatriphenylene-based organic materials, quinacridone-based organic materials, perylene-based organic materials,

anthraquinone, and polyaniline- and polythiophenebased conductive polymers, and the like, but are not limited thereto.

The hole transfer layer is a layer that receives holes from a hole injection layer and transfers the holes to a light emitting layer, and as the hole transfer material, materials capable of receiving holes from an anode or a hole injection layer, moving the holes to a light emitting layer, and having high mobility for the holes are suited. Specific examples thereof include arylamine-based organic materials, conductive polymers, block copolymers having conjugated parts and nonconjugated parts together, and the like, but are not limited thereto.

The light emitting material is a material capable of emitting light in a visible light region by receiving holes and electrons from a hole transfer layer and an electron transfer layer, respectively, and binding the holes and the electrons, and is preferably a material having favorable quantum efficiency for fluorescence or phosphorescence. Specific examples thereof include 8-hydroxyquinoline aluminum complexes ($Alq_3$); carbazole-based compounds; dimerized styryl compounds; BAlq; 10-hydroxybenzoquinoline-metal compounds; benzoxazole-, benzothiazole- and benzimidazole-based compounds; poly(p-phenylenevinylene) (PPV)-based polymers; spiro compounds; polyfluorene, rubrene, or the like, but are not limited thereto.

The light emitting layer may include a host material and a dopant material. The host material includes fused aromatic ring derivatives, heteroring-containing compounds or the like. Specifically, the fused aromatic ring derivative includes anthracene derivatives, pyrene derivatives, naphthalene derivatives, pentacene derivatives, phenanthrene compounds, fluoranthene compounds and the like, and the heteroring-containing compound includes carbazole derivatives, dibenzofuran derivatives, ladder-type furan compounds, pyrimidine derivatives and the like, however, the material is not limited thereto.

The dopant material includes aromatic amine derivatives, styrylamine compounds, boron complexes, fluoranthene compounds, metal complexes and the like. Specifically, the aromatic amine derivative is a fused aromatic ring derivative having a substituted or unsubstituted arylamine group and includes arylamine group-including pyrene, anthracene, chrysene, peryflanthene and the like, and the styrylamine compound is a compound in which substituted or unsubstituted arylamine is substituted with at least one arylvinyl group, and one, two or more substituents selected from the group consisting of an aryl group, a silyl group, an alkyl group, a cycloalkyl group and an arylamine group are substituted or unsubstituted. Specifically, styrylamine, styryldiamine, styryltriamine, styryltetramine or the like is included, however, the styrylamine compound is not limited thereto. In addition, the metal complex includes iridium complexes, platinum complexes or the like, but is not limited thereto.

The electron transfer layer is a layer that receives electrons from an electron injection layer and transfers the electrons to a light emitting layer, and as the electron transfer material, materials capable of favorably receiving electrons from a cathode, moving the electrons to a light emitting layer, and having high mobility for the electrons are suited. Specific examples thereof include Al complexes of 8-hydroxyquinoline; complexes including $Alq_3$; organic radical compounds; hydroxyflavon-metal complexes, or the like, but are not limited thereto. The electron transfer layer may be used together with any desired cathode material as used in the art. Particularly, examples of the suitable cathode material include common materials that have small work function, and in which an aluminum layer or a silver layer follows. Specifically, the cathode material includes cesium, barium, calcium, ytterbium and samarium, and in each case, an aluminum layer or a silver layer follows.

The electron injection layer is a layer that injects electrons from an electrode, and the electron injection material is preferably a compound that has an ability to transfer electrons, has an electron injection effect from a cathode, has an excellent electron injection effect for a light emitting layer or a light emitting material, prevents excitons generated in the light emitting layer from moving to a hole injection layer, and in addition thereto, has an excellent thin film forming ability. Specific examples thereof include fluorenone, anthraquinodimethane, diphenoquinone, thiopyran dioxide, oxazole, oxadiazole, triazole, imidazole, perylene tetracarboxylic acid, fluorenylidene methane, anthrone or the like, and derivatives thereof, metal complex compounds, nitrogen-containing 5-membered ring derivatives, and the like, but are not limited there.

The metal complex compound includes 8-hydroxyquinolinato lithium, bis(8-hydroxyquinolinato)zinc, bis(8-hydroxyquinolinato)copper, bis(8-hydroxyquinolinato)manganese, tris(8-hydroxyquinolinato)aluminum, tris(2-methyl-8-hydroxyquinolinato)aluminum, tris(8-hydroxyquinolinato)gallium, bis(10-hydroxybenzo[h]quinolinato)beryllium, bis(10-hydroxybenzo[h]quinolinato)zinc, bis(2-methyl-8-quinolinato)chlorogallium, bis(2-methyl-8-quinolinato)(o-cresolato)gallium, bis(2-methyl-8-quinolinato)(1-naphtholato)aluminum, bis(2-methyl-8-quinolinato)(2-naphtholato)gallium and the like, but is not limited thereto.

The hole blocking layer is a layer blocking holes from reaching a cathode, and generally, may be formed under the same condition as the hole injection layer. Specifically, oxadiazole derivatives or triazole derivatives, phenanthroline derivatives, aluminum complexes and the like are included, however, the material is not limited thereto.

The organic light emitting device according to the present specification may be a top-emission type, a bottomemission type or a dual-emission type depending on the materials used.

In one embodiment of the present specification, the compound may be included in an organic solar cell or an organic transistor in addition to the organic light emitting device.

Hereinafter, the present specification will be described in detail with reference to examples in order to specifically describe the present specification. However, the examples according to the present specification may be modified to various different forms, and the scope of the present specification is not to be construed as being limited to the examples described below. Examples of the present specification are provided in order to more fully describe the present specification to those having average knowledge in the art.

**<Synthesis Example>**

**<Synthesis Example 1. Synthesis of Compound A>**

- Preparation of Compound **5**

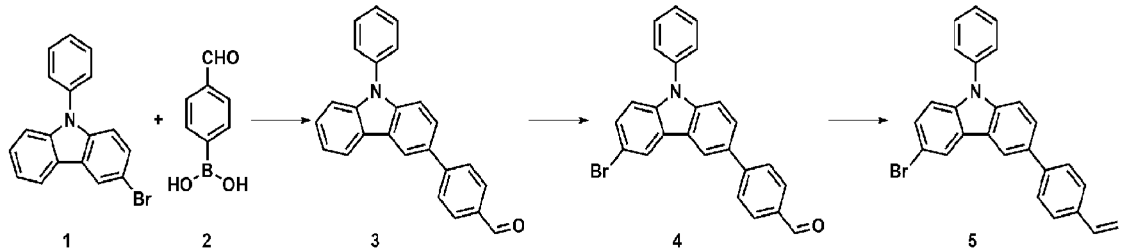

1 2 3 4 5

Synthesis of Compound **3** (4-(9-phenyl-9H-carbazol-3-yl)benzaldehyde): After dissolving Compound **1** (3-bromo-9-phenyl-9H-carbazole) (9 g, 27.9 mmol) and Compound **2** ((4-formylphenyl)boronic acid-d) (4.18 g, 27.9 mmol) in anhydrous tetrahydrofuran (THF) (100 mL), $Pd(PPh_3)_4$ (0.32 g, 0.28 mmol) and a 2 M aqueous potassium carbonate ($K_2CO_3/H_2O$) solution (70 ml) were introduced thereto, and the result was refluxed for 6 hours. The reaction solution was cooled to room temperature, and the organic layer was extracted. The reaction solution was concentrated, and recrystallized with ethyl alcohol (EtOH) to obtain Compound **3** (8.9 g, yield 92%).

Synthesis of Compound **4** (4-(6-bromo-9-phenyl-9H-carbazol-3-yl)benzaldehyde): After dissolving Compound **3** (8.2 g, 23.6 mmol) in chloroform (200 mL), N-bromosuccinimide (4.15 g, 23.6 mmol) was added thereto, and the result was stirred for 5 hours at room temperature. Distilled water was introduced to the reaction solution to terminate the reaction, and the organic layer was extracted. The reaction solution was concentrated, and recrystallized with ethyl alcohol (EtOH) to obtain Compound **4** (8.25 g, yield 82%).

Synthesis of Compound **5** (3-bromo-9-phenyl-6-(4-vinylphenyl)-9H-carbazole): After introducing tetrahydrofuran [THF] to Compound **4** (8 g, 18.8 mmol) and $CH_3BrPPh_3$ (13.4 g, 37.6 mmol), potassium tert-butoxide (4.2 g, 37.6 mmol) was introduced thereto at 0°C, and the result was stirred for 1 hour. The reaction was stopped using water, and the result was extracted with ethyl acetate (EA). The collected organic solution was dried by introducing magnesium sulfate ($MgSO_4$) thereto, and after filtering, the result was recrystallized with ethyl acetate/ethyl alcohol to obtain Compound **5** (6.8 g, yield 85%).

- Preparation of Compound **7**

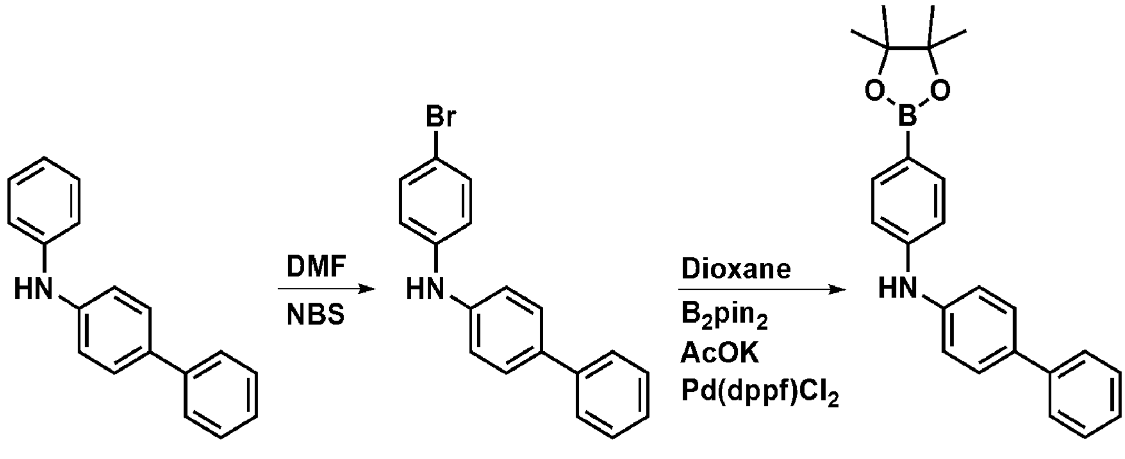


6 7

Synthesis of Compound **6** (N-(4-bromophenyl)-[1,1'-biphenyl]-4-amine): A reaction flask in which N-phenyl-[1,1'-biphenyl]-4-amine (61.3 g, 250.1 mmol) was dissolved in dimethylformamide (DMF) (700 ml) was placed in an ice bath. N-bromosuccinimide (NBS) (43.1 g, 242.58 mmol) was introduced to the reaction flask, and the result was stirred overnight. The reaction material was dropped to water (1.7 L), and filtered to obtain Compound **6** (77.8 g).

Synthesis of Compound **7** (N-(4-(4,4,5,5-tetramethyl-1,3,2-dioxaborolan-2-yl)phenyl)-[1,1'-biphenyl]-4-amine): To a flask holding Compound **6** (27 g, 83.3 mmol), 4,4,4',4',5,5,5',5'-octamethyl-2,2'-bi(1,3,2-dioxaborolane) (42.3 g, 167 mmol) and potassium acetate (24.5 g, 250 mmol), anhydrous dioxane (280 ml) was introduced. The reaction flask was placed in an 80°C oil bath, $Pd(dppf)Cl_2$.DCM (3.3 g, 4.2 mmol) was introduced to the reaction flask, and the result was stirred for a day. The result was vacuumed to evaporate dioxane as much as possible, and extracted using water and ethyl acetate. The collected organic layer was dried with $MgSO_4$, column purified (EA:Hx=1:20->1:9 (v/v)), and recrystallized using a temperature difference in a hexane/EA solvent to obtain Compound **7** (22 g, yield 71%).

- Preparation of Compound **8**

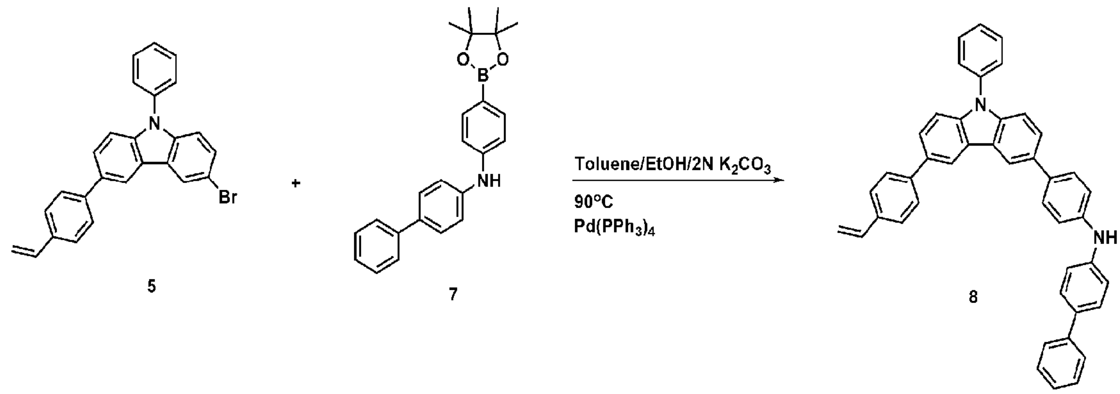


Synthesis of Compound **8** (N-(4-(9-phenyl-6-(4-vinylphenyl)-9H-carbazol-3-yl)phenyl)-[1,1'-biphenyl]-4-amine): To a reaction flask holding Compound **5** (3-bromo-9-phenyl-6-(4-vinylphenyl)-9H-carbazole) (1.4 g, 3.3 mmol) and Compound **7** (1.23 g, 3.3 mmol), a toluene/EtOH/2 N $K_2CO_3$ (aq) (2v:1v:1v) solvent was introduced. The reaction flask was placed in an 90°C oil bath, and degassed using a vacuum pump. $Pd(PPh_3)_4$ (191 mg, 0.165 mmol) was introduced to the reaction flask, and the result was stirred for a day. EtOH was removed using a vacuum concentrator, and the organic material was extracted with dichloromethane (DCM). The organic layer was dried with $MgSO_4$, then filtered, and column purified to obtain Compound **8** (1.3 g, yield 67%).

- Preparation of Compound **A**

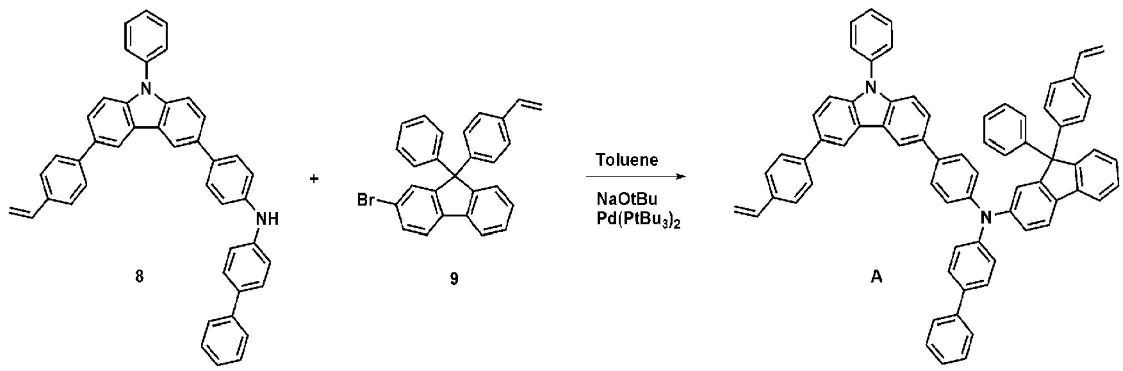


8 9 A

Synthesis of Compound **A** (N-([1,1'-biphenyl]-4-yl)-9-phenyl-N-(4-(9-phenyl-6-(4-vinylphenyl)-9H-carbazol-3-yl)phenyl)-9-(4-vinylphenyl)-9H-fluorene-2-amine): To a flask holding Compound **9** (2-bromo-9-phenyl-9-(4-vinylphenyl)-9H-fluorene) (935 mg, 2.2 mmol), Compound **8** (1.3 g, 2.2 mmol) and sodium tert-butoxide (634 mg, 6.6 mmol), toluene (20 ml) was introduced, and the flask was bubbled with nitrogen. The flask holding the reaction material was placed in an 80°C oil bath, then $Pd(PtBu_3)_2$ (34 mg, 0.066 mmol) was introduced thereto, and the result was stirred for 1 hour. The result was precipitated in ethanol, adsorbed to silica, and column purified (DCM/HX) to obtain Compound **A** (1.2 g, yield 59%, purity 99.2%).

MS: $[M+H]^+$=931

$^1H$ NMR : δ 8.44 (dd, J=14.7, 1.8 Hz, 2H), 7.78-7.10 (m, 42H), 6.80 (dd, J=17.6, 10.9 Hz, 1H), 6.69 (dd, J=17.6, 10.9 Hz, 1H), 5.83 (d, *J*=17.6 Hz, 1H), 5.70 (d, *J*=17.6 Hz, 1H), 5.28 (d, *J*=10.9 Hz, 1H), 5.20 (d, *J*=10.9 Hz, 1H).

**<Synthesis Example 2. Synthesis of Compound B>**

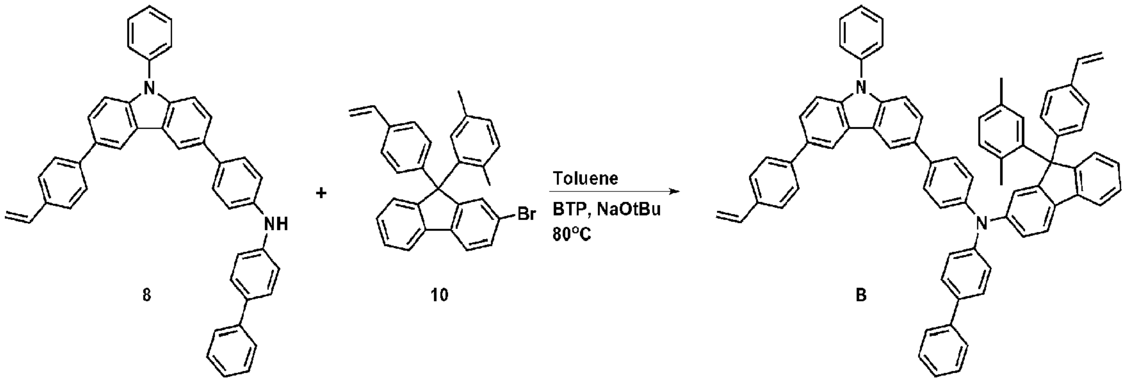


8 10 B

Synthesis of Compound **B** (N-([1,1'-biphenyl]-4-yl)-9-(2,5-dimethylphenyl)-N-(4-(9-phenyl-6-(4-vinyl phenyl)-9H-carbazol-3-yl)phenyl)-9-(4-vinyl phenyl)-9H-fluorene-2-amine): To a flask holding Compound **10** (2-bromo-9-(2,5-dimethylphenyl)-9-(4-vinylphenyl)-9H-fluorene) (2.47 g. 5.5 mmol), Compound **8** (2.94 g, 5 mmol) and sodium tert-butoxide (1.2 g, 12.5 mmol), toluene (35 ml) was introduced. The flask holding the reaction material was placed in an 80°C oil bath, then $Pd(PtBu_3)_2$ (77 mg, 0.15 mmol) was introduced thereto, and the result was stirred for 15 minutes. The result was precipitated in ethanol, adsorbed to silica, and column purified (DCM/HX=2:5) to obtain Compound **B** (2.04 g, yield 43%, purity 98.1%).

MS: $[M+H]^+$=959

$^1H$ NMR : δ 8.44 (dd, *J*=13.8, 1.8 Hz, 2H), 7.81-7.09 (m, 37H), 6.95 (s, 2H), 6.89 (s, 1H), 6.80 (dd, *J*=17.6, 10.9 Hz, 1H), 6.70 (dd, *J*=17.7, 10.9 Hz, 1H), 5.83 (d, *J*=17.6 Hz, 1H), 5.72 (d, *J*=17.6 Hz, 1H), 5.28 (d, *J*=10.9 Hz, 1H), 5.21 (d, *J*=10.9 Hz, 1H), 2.16 (s, 3H), 1.60 (s, 3H).

**<Synthesis Example 3. Synthesis of Compound C>**

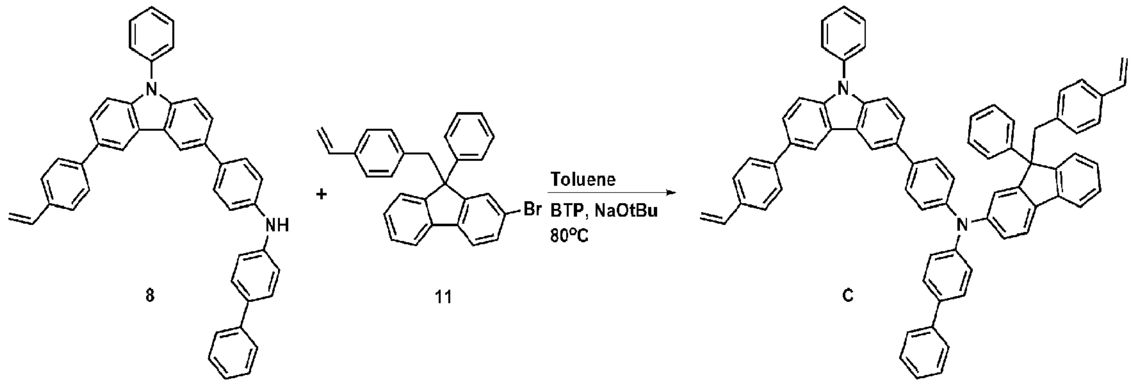


8 11 C

Synthesis of Compound **C** (N-([1,1'-biphenyl]-4-yl)-9-phenyl-N-(4-(9-phenyl-6-(4-vinylphenyl)-9H-carbazol-3-yl)phenyl)-9-(4-vinylbenzyl)-9H-fluorene-2-amine): To a flask holding Compound **11** (2.39 g. 5.45 mmol), Compound **8** (2.92 g, 4.96 mmol) and sodium tert-butoxide (1.19 g, 12.4 mmol), toluene (25 ml) was introduced. The flask holding the reaction material was placed in an 80°C oil bath, then $Pd(PtBu_3)_2$ (76 mg, 0.15 mmol) was introduced thereto, and the result was stirred for 40 minutes. The reaction was stopped using water, and the result was precipitated in ethanol, adsorbed to silica, and column purified (DCM/HX=2:5) to obtain Compound **C** (3.0 g, yield 64%, purity 99.6%).

MS: $[M+H]^+$=945

$^1$H NMR : $\delta$ 8.45 (dd, *J*=7.7, 1.8 Hz, 2H), 7.80-7.16 (m, 37H), 7.11 (dd, *J*=8.2, 2.0 Hz, 1H), 6.99 (d, *J*=7.9 Hz, 2H), 6.80 (dd, *J*=17.6, 10.9 Hz, 1H), 6.54 (t, *J*=7.7 Hz, 3H), 5.82 (d, *J*=17.6 Hz, 1H), 5.61 (d, *J*=17.6 Hz, 1H), 5.28 (d, *J*=10.9 Hz, 1H), 5.12 (d, *J*=10.9 Hz, 1H), 3.88 (d, *J*=12.8 Hz, 1H), 3.69 (d, *J*=12.7 Hz, 1H).

**<Synthesis Example 4. Synthesis of Compound D>**

- Preparation of Compound **15**

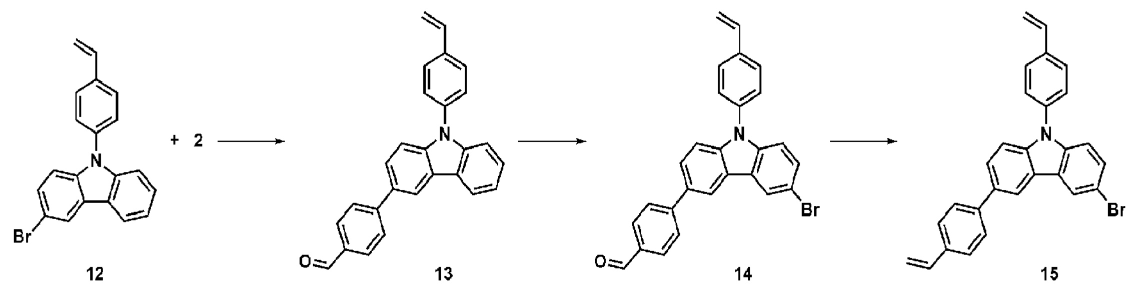


12 13 14 15

Synthesis of Compound **13** (4-(9-(4-vinylphenyl)-9H-carbazol-3-yl)benzaldehyde): Compound **13** (10.4 g, 92%) was obtained using the same equivalents, and synthesis and purification methods as in Preparation Example 1-Synthesis of Compound **3** except that Compound **12** was used instead of Compound **1.**

Synthesis of Compound **14** (4-[6-bromo-9-(4-vinyl phenyl)-9H-carbazol-3-yl]-benzaldehyde): Compound **14** (5.6 g) was obtained using the same equivalents, and synthesis and purification methods as in Preparation Example 1-Synthesis of Compound **4** except that Compound **13** was used instead of Compound **3.**

Synthesis of Compound **15** (3-bromo-6,9-bis(4-vinylphenyl)-9H-carbazole): Compound **15** (5.2 g, 95%) was obtained using the same equivalents, and synthesis and purification methods as in Preparation Example 1-Synthesis of Compound **5** except that Compound **14** was used instead of Compound **4.**

- Preparation of Compound **19**

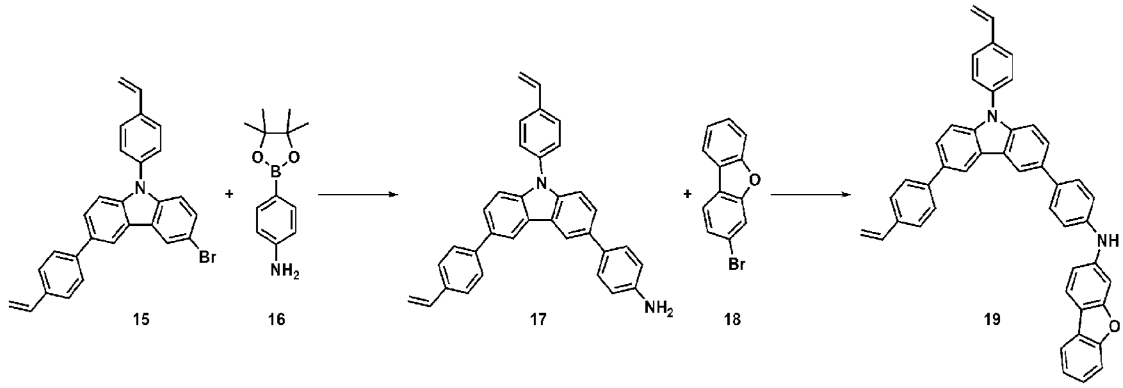

15 16 17 18 19

Synthesis of Compound **17** (4-(6,9-bis(4-vinylphenyl)-9H-carbazol-3-yl)aniline): To a flask holding Compound **15** (4.5 g, 10.0 mmol), Compound **16** 4-(4,4,5,5-tetramethyl-1,3,2-dioxaborolan-2-yl)aniline (2.2 g, 10.0 mmol), tetrakis(triphenylphosphine)palladium(0) (0.6 g, 0.3 mmol) and $K_2CO_3$ (4.1 g, 20.0 mmol), THF/$H_2O$ (v/v=3/1) (160 ml) was introduced, and the result was stirred for 16 hours at 80°C under $N_2$. After the reaction was finished, the reaction solution was cooled, and then the organic layer was extracted using an extraction flask. The organic layer was dried with $MgSO_4$, the organic solvent was removed using a rotary vacuum evaporator, and then the residue was column purified to obtain Compound **17** (2.4 g, yield 52%).

Synthesis of Compound **19** (N-(4-(6,9-bis(4-vinylphenyl)-9H-carbazol-3-yl)phenyl)dibenzo[b,d]furan-3-amine): To a flask holding Compound **17** (2.3 g, 5.0 mmol), Compound **18** (1.36 g. 5.5 mmol) and sodium tert-butoxide (1.2 g, 12.5 mmol), toluene was introduced. The flask holding the reaction material was placed in an 90°C oil bath, then $Pd(PtBu_3)_2$ (280 mg, 0.5 mmol) was introduced thereto, and the result was stirred for 1 hour. Water was introduced thereto to stop the reaction, and after extracting the result with dichloromethane (DCM), the organic layer was dried with $MgSO_4$. The organic solvent was removed using a rotary vacuum evaporator, and then the residue was column purified to obtain Compound **19** (2.1 g, yield 67%).

- Synthesis of Compound **D**

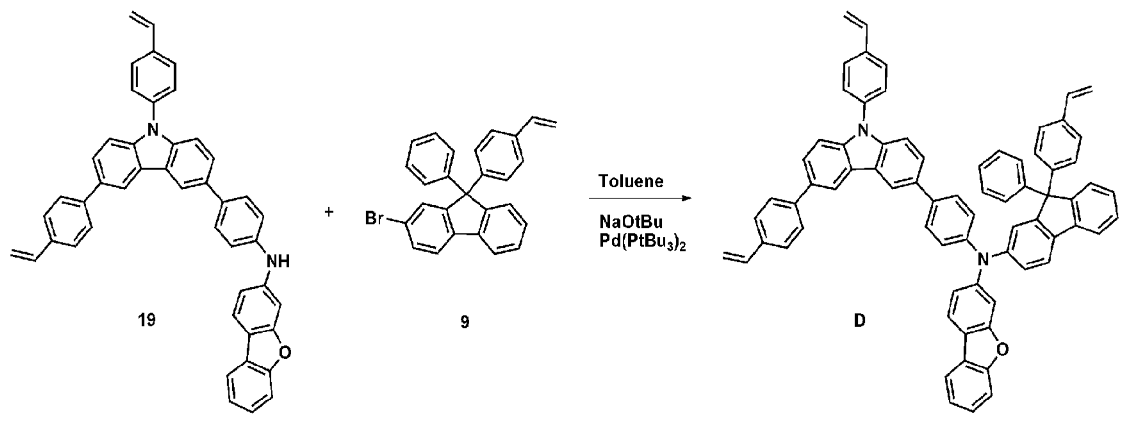


19 9 D

Synthesis of Compound D (N-(4-(6,9-bis(4-vinylphenyl)-9H-carbazol-3-yl)phenyl)-N-(9-phenyl-9-(4-vinylphenyl)-9H-fluoren-2-yl)dibenzo[b,d]furan-3-amine): To a flask holding Compound **19** (1.38 g. 2.2 mmol), Compound **9** (1.3 g, 2.2 mmol) and sodium tert-butoxide (634 mg, 6.6 mmol), toluene (20 ml) was introduced, and the flask was bubbled with nitrogen. The flask holding the reaction material was placed in an 80°C oil bath, then $Pd(PtBu_3)_2$ (34 mg, 0.066 mmol) was introduced thereto, and the result was stirred for 1 hour. The result was precipitated in ethanol, then adsorbed to silica, and column purified (DCM/HX) to obtain Compound **D** (1.1 g, yield 51%, purity 99.0%).

MS: $[M+H]^+$=971
$^1H$ NMR : δ 8.44 (dd, *J*=14.7, 1.8 Hz, 2H), 7.78-7.06 (m, 39H), 6.85-6.78 (m, 2H), 6.69 (dd, *J*=17.6, 10.9 Hz, 1H), 5.86-5.81 (m, 2H), 5.70 (d, *J*=17.6 Hz, 1H), 5.34 (d, *J*=10.9 Hz, 1H), 5.27 (d, *J*=10.9 Hz, 1H), 5.20 (d, *J*=10.9 Hz, 1H).

**<Preparation Example 1. Preparation of Coating Composition 1>**

Coating Composition 1 was prepared by dissolving Compound A (16 mg) and the following Compound D1 (4 mg) in toluene (980 mg) in a weight ratio of 8: 2.

[Compound D1]

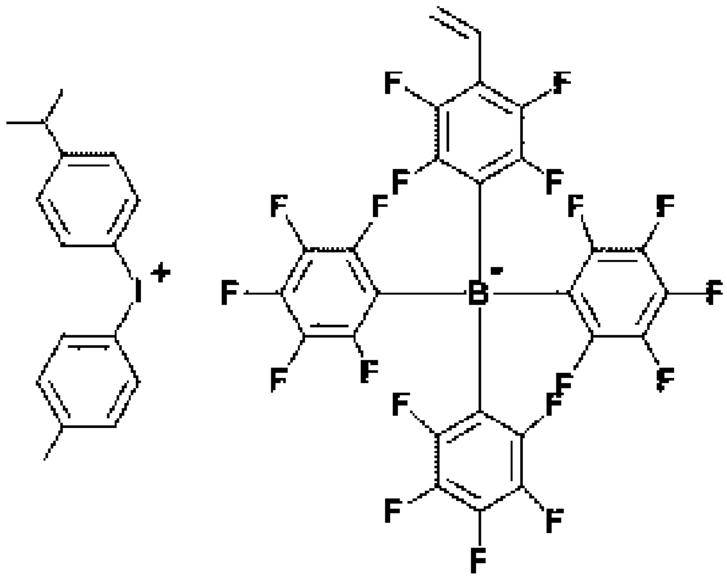

<Preparation Example 2, Preparation of Coating Composition 2>

A coating composition was prepared in the same manner as in Preparation Example 1 except that Compound B was used instead of Compound A.

<Preparation Example 3, Preparation of Coating Composition 3>

A coating composition was prepared in the same manner as in Preparation Example 1 except that Compound C was used instead of Compound A.

<Preparation Example 4, Preparation of Coating Composition 4>

A coating composition was prepared in the same manner as in Preparation Example 1 except that Compound D was used instead of Compound A.

<Preparation Example 5, Preparation of Coating Composition 5>

A coating composition was prepared in the same manner as in Preparation Example 1 except that the following Compound E was used instead of Compound A.

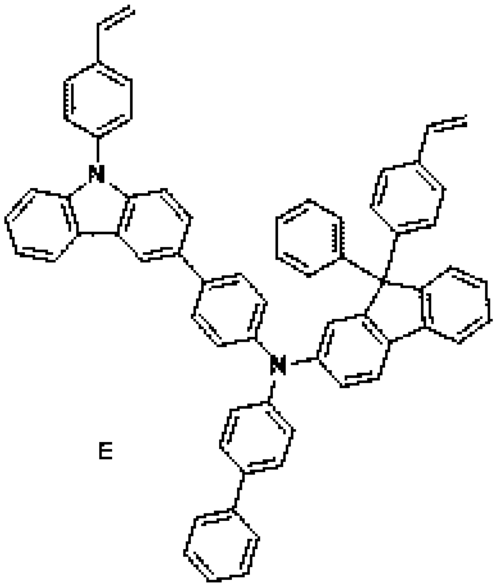

E

<Preparation Example 6, Preparation of Coating Composition 6>

A coating composition was prepared in the same manner as in Preparation Example 1 except that the following Compound D2 was used instead of Compound D1.

[Compound D2]

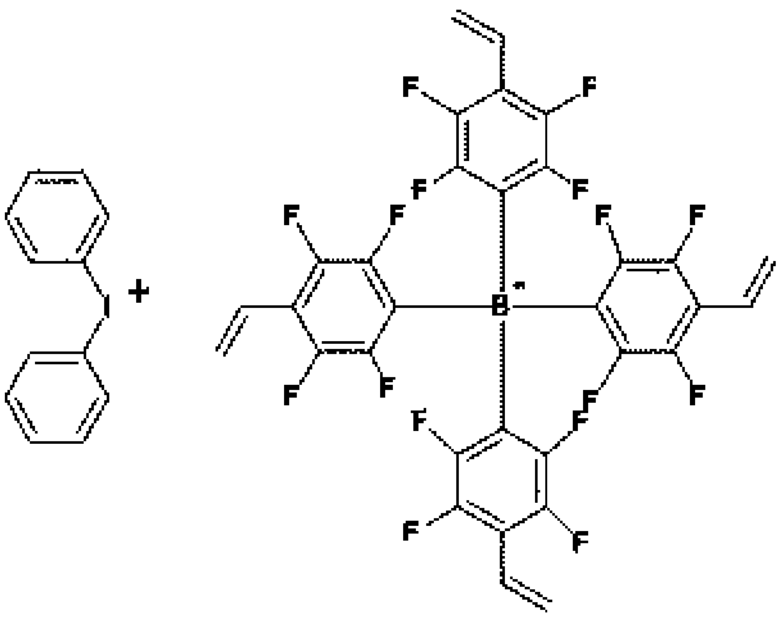

<Preparation Example 7, Preparation of Coating Composition 7>

A coating composition was prepared in the same manner as in Preparation Example 1 except that the following Compound D3 was used instead of Compound D1.

[Compound D3]

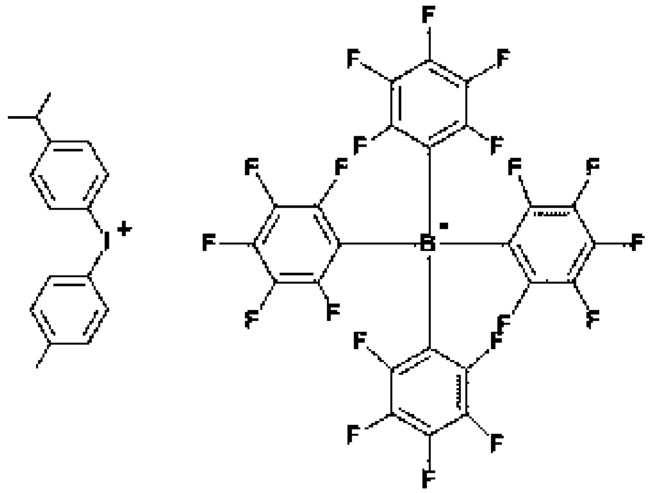

<Preparation Example 8, Preparation of Coating Composition 8>

A coating composition was prepared in the same manner as in Preparation Example 1 except that the following Compound F was used instead of Compound A.

[Compound F]

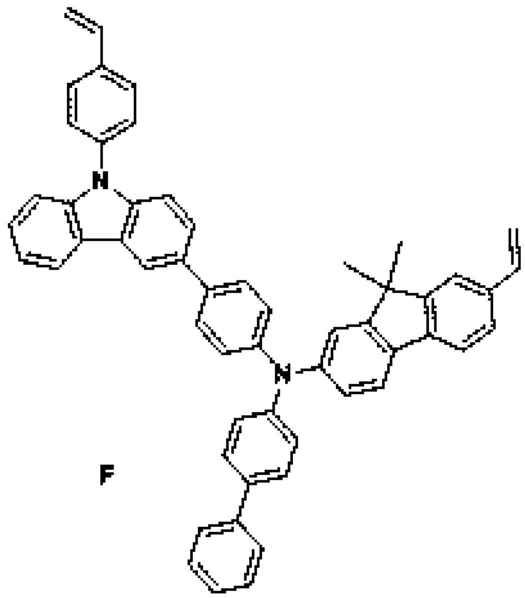

<Preparation Example 9, Preparation of Coating Composition 9>

A coating composition was prepared in the same manner as in Preparation Example 1 except that the following Compound G was used instead of Compound A.

[Compound G]

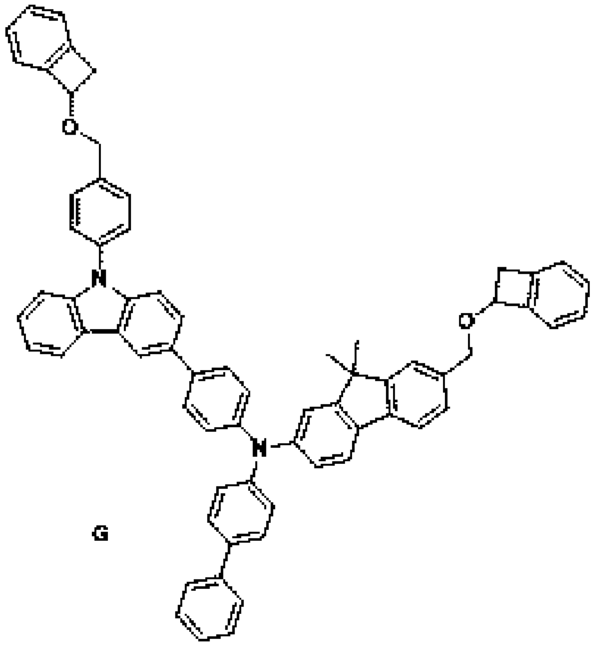

G

<Preparation Example 10, Preparation of Coating Composition 10>

A coating composition was prepared in the same manner as in Preparation Example 1 except that the following VNPB was used instead of Compound A.

[VNPB]

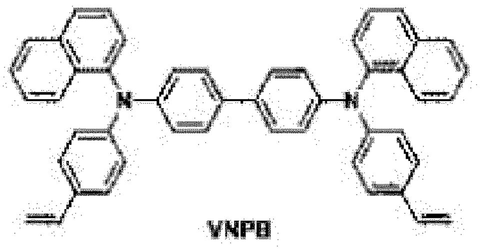

VNPB

<Preparation Example 11, Preparation of Coating Composition 11>

A coating composition was prepared in the same manner as in Preparation Example 10 except that Compound D3 was used instead of Compound D1.

**<Example/Comparative Example>-Manufacture of Organic Light Emitting Device**

**Example 1. Manufacture of Organic Light Emitting Device 1**

A glass substrate on which indium tin oxide (ITO) was deposited as a thin film to a thickness of 1,500 Å was placed in detergent-dissolved distilled water and ultrasonic cleaned. After the ITO was cleaned for 30 minutes, ultrasonic cleaning was repeated twice using distilled water for 10 minutes. After the cleaning with distilled water was finished, the substrate was ultrasonic cleaned with solvents of isopropyl alcohol and acetone for 30 minutes each, dried, and then transferred to a glove box.

On the transparent ITO electrode, a hole injection layer was formed to a thickness of 30 nm by spin coating Coating Composition 1 on the ITO surface and heat treating (curing) the result for 30 minutes at 220°C. On the hole injection layer formed above, a 2 wt% toluene ink of N,N-di(1-naphthyl)-N,N-diphenyl-(1,1'-biphenyl)-4,4'-diamine ($\alpha$-NPD) was spin coated to form a hole transfer layer to a thickness of 40 nm.

After that, the result was transferred to a vacuum deposition apparatus, and a light emitting layer was formed on the hole transfer layer by vacuum depositing ADN and DPAVBi in a weight ratio (ADN:DPAVBi) of 20:1 to a thickness of 20 nm. On the light emitting layer, BCP was vacuum deposited to a thickness of 35 nm to form an electron injection and transfer layer. A cathode was formed on the electron injection and transfer layer by depositing LiF to a thickness of 1 nm and aluminum to a thickness of 100 nm in consecutive order.

In the above-mentioned process, the deposition rates of the organic materials were maintained at 0.4 Å/sec to 0.7 Å/sec, the deposition rates of the lithium fluoride and the aluminum of the cathode were maintained at 0.3 Å/sec and 2 Å/sec, respectively, and the degree of vacuum during the deposition was maintained at $2\times10^{-7}$ torr to $5\times10^{-6}$ torr.

[α-NPD]

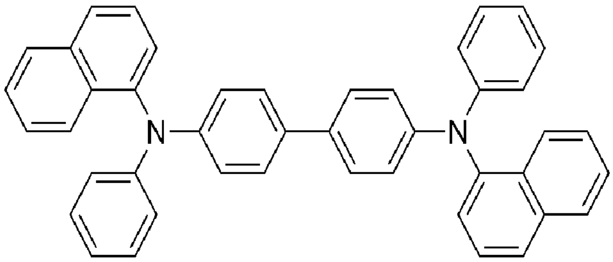

[ADN]

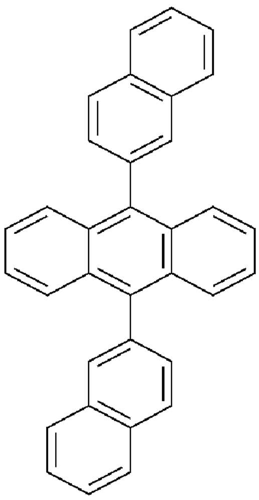

[DPAVBi (4,4'-bis[4-di-p-tolylamino)styryl]biphenyl)]

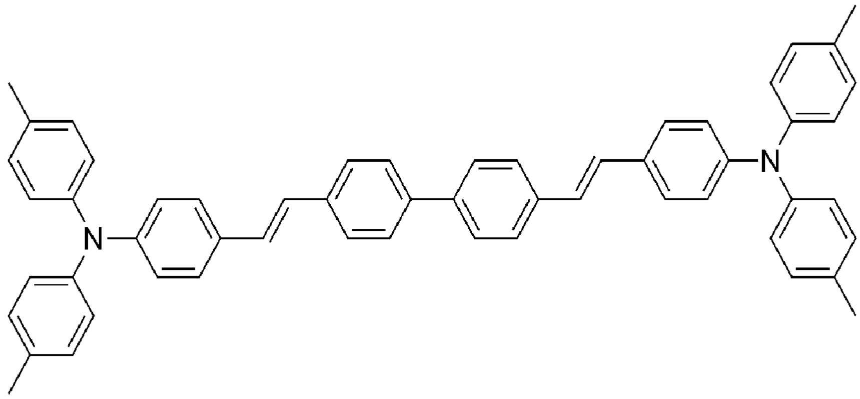

[BCP (2,9-dimethyl-4,7-diphenyl-1,10-phenanthroline)]

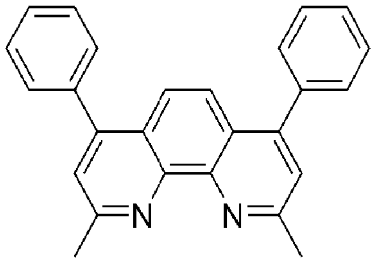

**Example 2. Manufacture of Organic Light Emitting Device 2**

An organic light emitting device was manufactured in the same manner as in Example 1 except that Coating Composition 2 was used instead of Coating Composition 1.

**Example 3. Manufacture of Organic Light Emitting Device 3**

An organic light emitting device was manufactured in the same manner as in Example 1 except that Coating Composition 3 was used instead of Coating Composition 1.

**Example 4. Manufacture of Organic Light Emitting Device 4**

An organic light emitting device was manufactured in the same manner as in Example 1 except that Coating Composition 4 was used instead of Coating Composition 1.

**Example 5. Manufacture of Organic Light Emitting Device 5**

An organic light emitting device was manufactured in the same manner as in Example 1 except that Coating Composition 5 was used instead of Coating Composition 1.

**Example 6. Manufacture of Organic Light Emitting Device 6**

An organic light emitting device was manufactured in the same manner as in Example 1 except that Coating Composition 6 was used instead of Coating Composition 1.

**Comparative Example 1. Manufacture of Comparative Organic Light Emitting Device 1**

An organic light emitting device was manufactured in the same manner as in Example 1 except that Coating Composition 7 was used instead of Coating Composition 1.

**Comparative Example 2. Manufacture of Comparative Organic Light Emitting Device 2**

An organic light emitting device was manufactured in the same manner as in Example 1 except that Coating Composition 8 was used instead of Coating Composition 1.

**Comparative Example 3. Manufacture of Comparative Organic Light Emitting Device 3**

An organic light emitting device was manufactured in the same manner as in Example 1 except that Coating Composition 9 was used instead of Coating Composition 1.

**Comparative Example 4. Manufacture of Comparative Organic Light Emitting Device 4**

An organic light emitting device was manufactured in the same manner as in Example 1 except that Coating Composition 10 was used instead of Coating Composition 1.

**Comparative Example 5. Manufacture of Comparative Organic Light Emitting Device 5**

An organic light emitting device was manufactured in the same manner as in Example 1 except that Coating Composition 11 was used instead of Coating Composition 1.

For each of the organic light emitting devices manufactured in Examples 1 to 6 and Comparative Examples 1 to 5, driving voltage, current efficiency and quantum efficiency (QE) values were measured at current density of 10 $mA/cm^2$, and time taken for luminance becoming 95% with respect to initial luminance (T95) was measured at current density of 10 $mA/cm^2$. The results are shown in the following Table 1.

[Table 1]

| | Volt | Cd/A | QE (%) | $Cd/m^2$ | T95 (10 $mA/cm^2$) |
|---|---|---|---|---|---|
| **Example 1** | 3.85 | 5.42 | 5.94 | 539.67 | 127.8 |
| **Example 2** | 3.88 | 5.38 | 5.76 | 535.68 | 113.3 |
| **Example 3** | 3.93 | 5.52 | 5.98 | 549.60 | 120.5 |
| **Example 4** | 4.06 | 5.74 | 6.13 | 571.23 | 116.3 |
| **Example 5** | 3.91 | 5.53 | 5.99 | 550.26 | 130.1 |
| **Example 6** | 3.87 | 5.45 | 6.01 | 542.56 | 131.8 |
| **Comparative Example 1** | 3.96 | 5.43 | 5.87 | 540.56 | 77.1 |
| **Comparative Example 2** | 3.79 | 5.42 | 5.95 | 539.67 | 93.9 |
| **Comparative Example 3** | 4.11 | 5.31 | 5.61 | 528.72 | 32.3 |
| **Comparative Example 4** | 3.88 | 5.17 | 5.70 | 516.1 | 82.3 |
| **Comparative Example 5** | 3.87 | 5.22 | 5.76 | 521.6 | 40.1 |

From the table, it was identified that the organic light emitting devices of Examples 1 to 6 using the coating composition including the compound represented by Chemical Formula 1 and the compound represented by Chemical Formula 11 of the present application had properties of long lifetime compared to Comparative Example 1 that did not include Chemical Formula 11 of the present application, Comparative Examples 2 to 4 that did not include Chemical Formula 1 of the present application, and Comparative Example 5 that did not include Chemical Formulae 1 and 11 of the present application.

## Claims

**1.** An organic light emitting device comprising:

a first electrode;
a second electrode provided opposite to the first electrode; and

one or more organic material layers provided between the first electrode and the second electrode, wherein one or more layers of the organic material layers includes a cured material formed from a compound represented by the following Chemical Formula 1 and an ionic compound including an anion group represented by the following Chemical Formula 11:

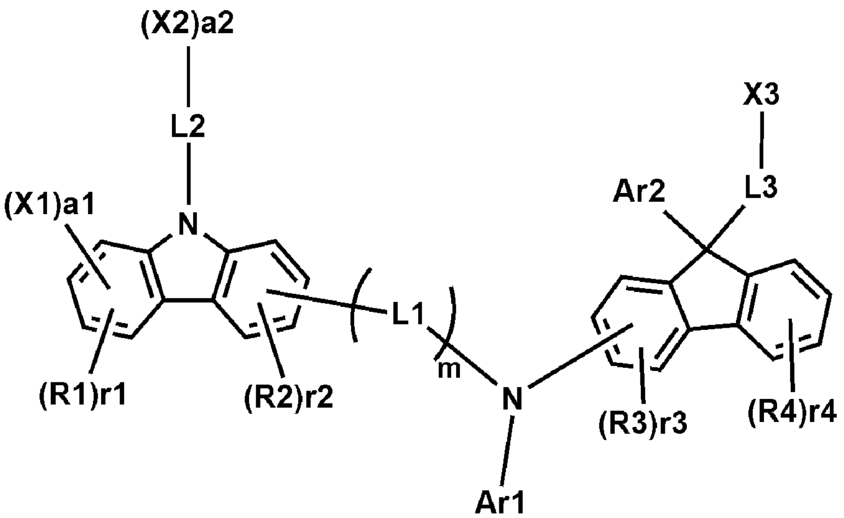

[Chemical Formula 1]

wherein:

Ar1 and Ar2 are the same as or different from each other, and each independently is a substituted or unsubstituted aryl group or a substituted or unsubstituted heterocyclic group;
R1 to R4 are the same as or different from each other, and each independently is hydrogen, deuterium, a halogen group, a nitrile group, a substituted or unsubstituted alkyl group, a substituted or unsubstituted aryl group or a substituted or unsubstituted heterocyclic group;
r1 to r3 are each from 1 to 3;
r4 is from 1 to 4;
when r1 to r4 are each 2 or greater, the two or more R1 to R4 are each the same as or different from each other;
X1 to X3 are the same as or different from each other, and each independently is selected from among the following structural formulae,

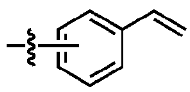 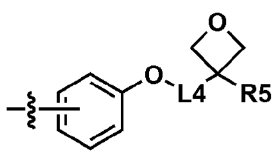 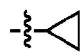

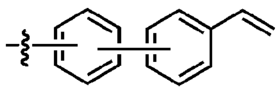 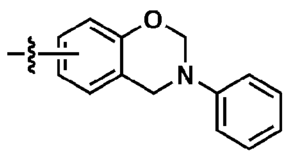 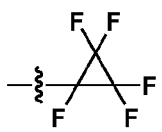

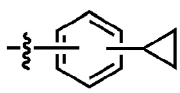 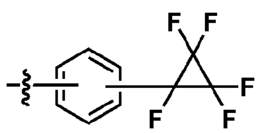 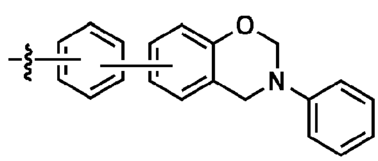

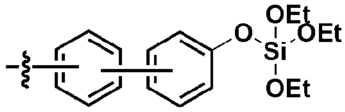 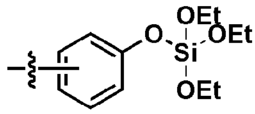 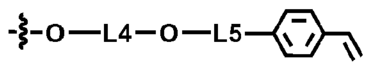

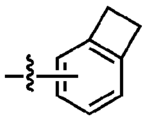 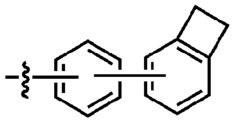 ;

each

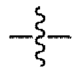

means a linking site;
L4 is a substituted or unsubstituted alkylene group;
L5 is a direct bond or a substituted or unsubstituted arylene group;
R5 is hydrogen or a substituted or unsubstituted alkyl group;
a1 and a2 are each 0 or 1;
when a2 is 0, L2 is a substituted or unsubstituted aryl group;
when a2 is 1, L2 is a direct bond or a substituted or unsubstituted arylene group;
m is 1 or 2, and when m is 2, L1s are the same as or different from each other, and L1 is a direct bond or a substituted or unsubstituted arylene group;
L3 is a direct bond or a substituted or unsubstituted alkylene group; and

$$0 \leq a1+a2 \leq 2,$$

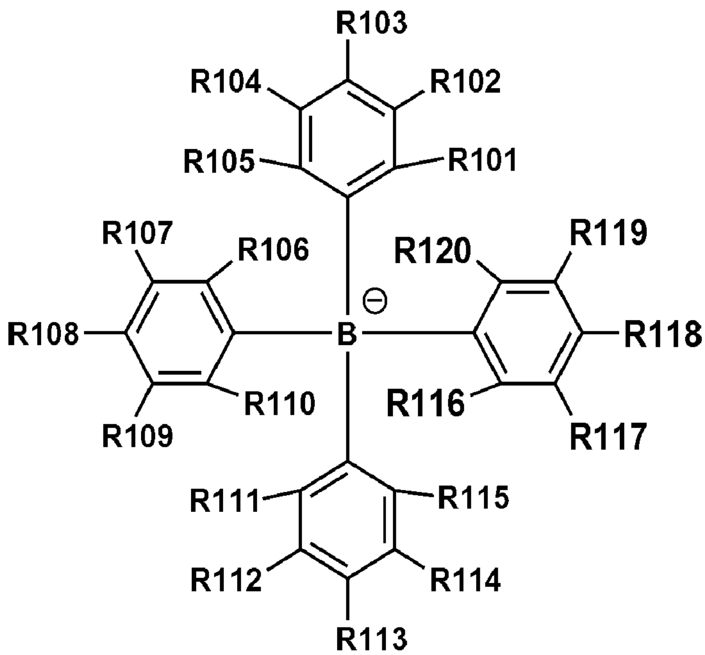

[Chemical Formula 11]

wherein:

at least one of R101 to R120 is F, a cyano group or a substituted or unsubstituted fluoroalkyl group;
at least one of the remaining R101 to R120 is a curing group; and
the remaining R101 to R120 are the same as or different from each other, and each independently is

hydrogen, deuterium, a nitro group, a substituted or unsubstituted alkyl group, a substituted or unsubstituted alkenyl group, a substituted or unsubstituted amine group, a substituted or unsubstituted aryl group or a substituted or unsubstituted heterocyclic group.

**2.** The organic light emitting device of Claim 1, wherein Chemical Formula 1 is represented by the following Chemical Formula 2:

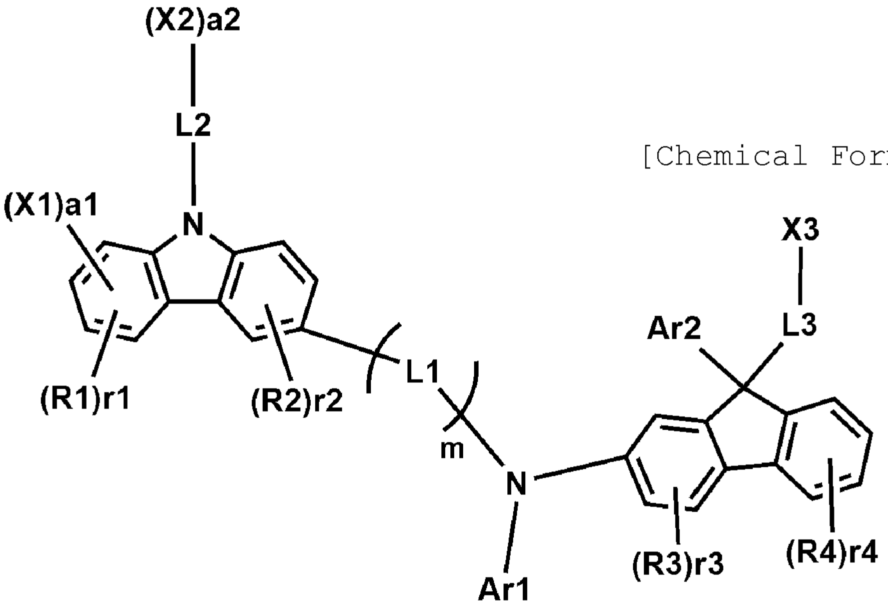

[Chemical Formula 2]

wherein:
L1 to L3, Ar1, Ar2, R1 to R4, r1 to r4, X1 to X3, m, a1 and a2 are the same as defined in Claim 1.

**3.** The organic light emitting device of Claim 1, wherein L1 is a substituted or unsubstituted phenylene group.

**4.** The organic light emitting device of Claim 1, wherein Ar1 and Ar2 are the same as or different from each other, and each independently is a substituted or unsubstituted phenyl group or a substituted or unsubstituted biphenyl group.

**5.** The organic light emitting device of Claim 1, wherein the compound represented by Chemical Formula 1 is any one of the following compounds:

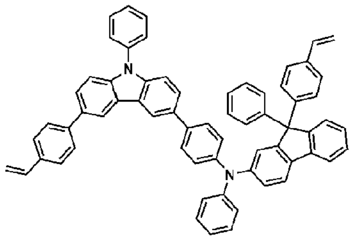 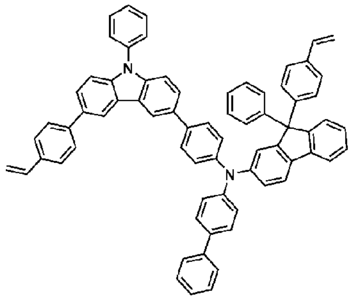 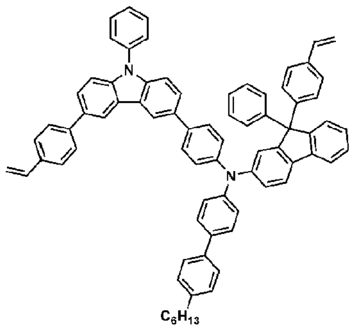

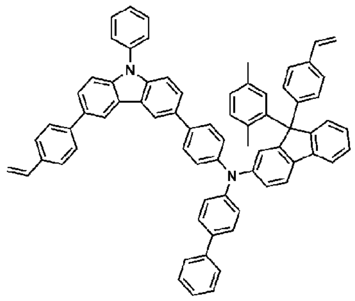

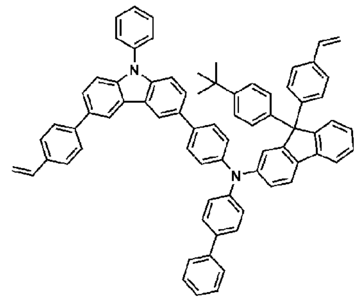

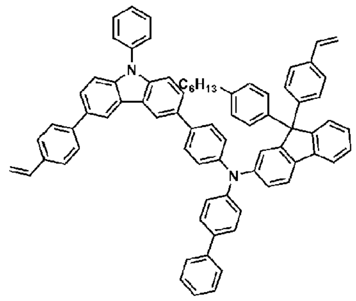

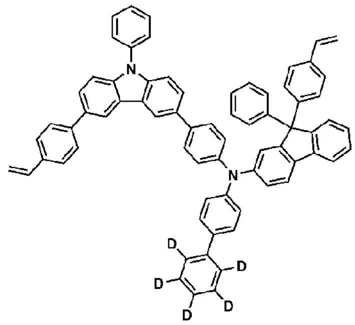

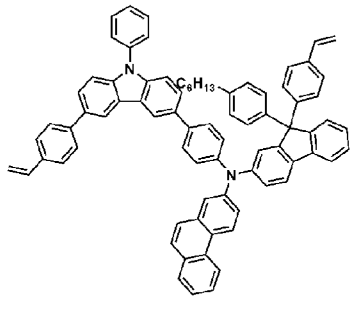

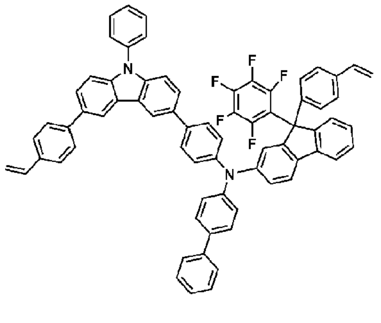

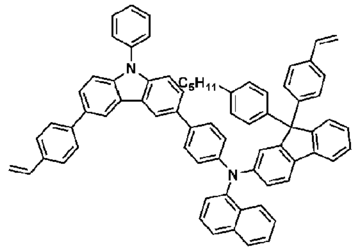

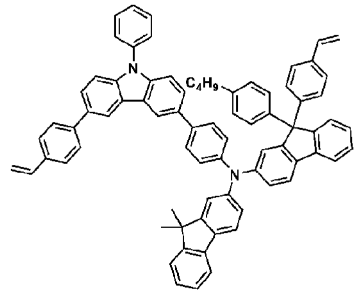

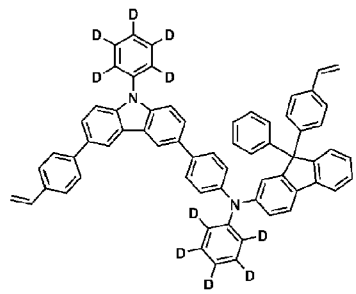

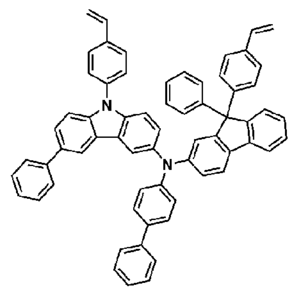

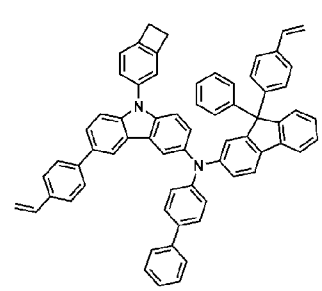

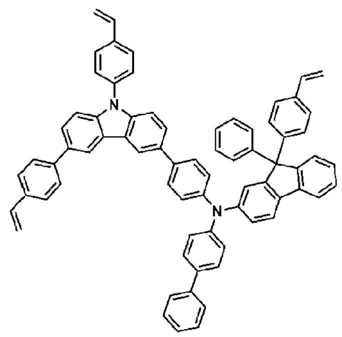

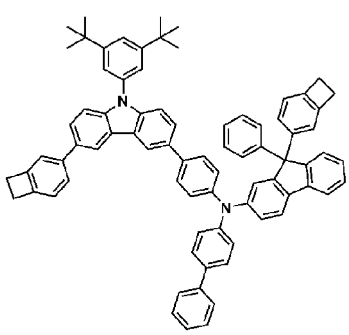
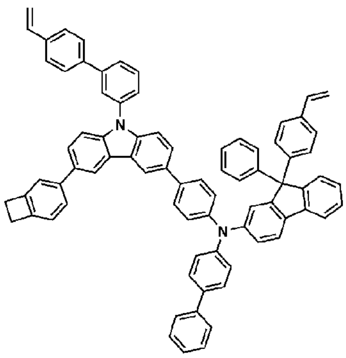
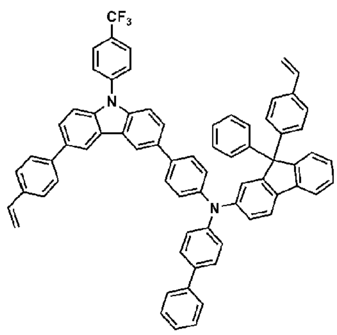

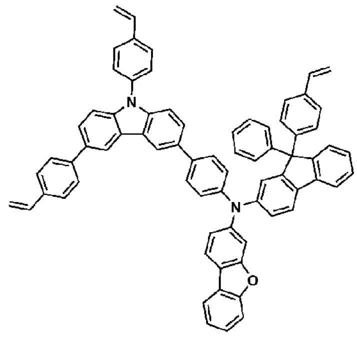
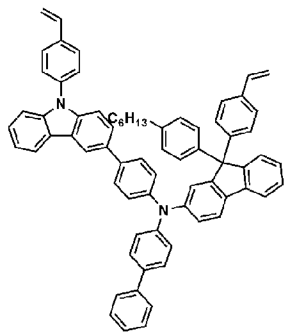
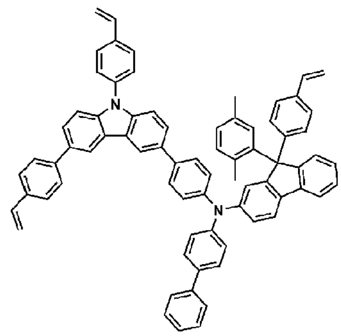

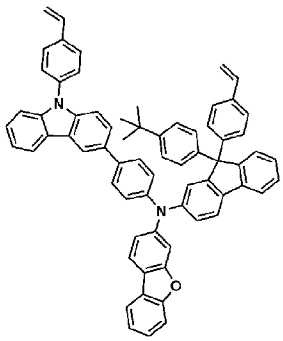
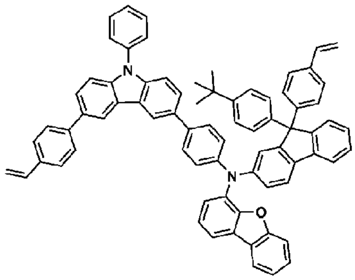
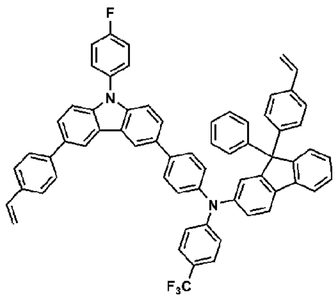

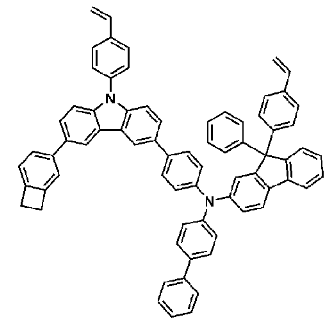
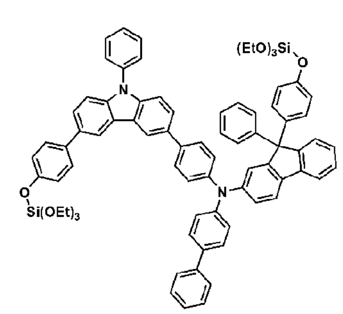
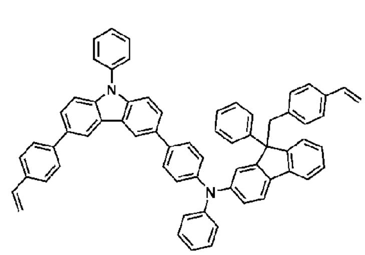

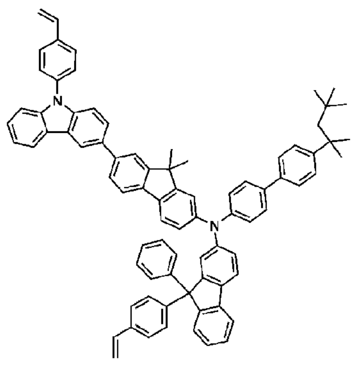
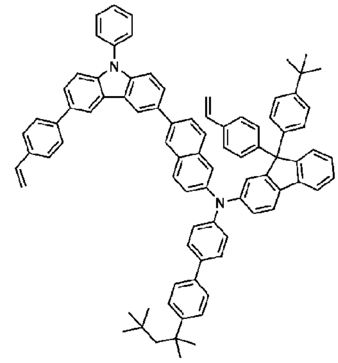
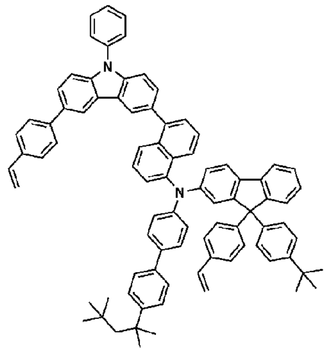

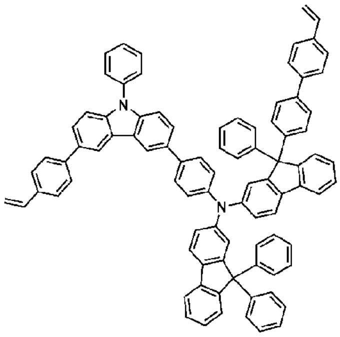
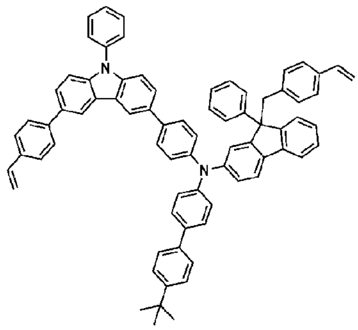
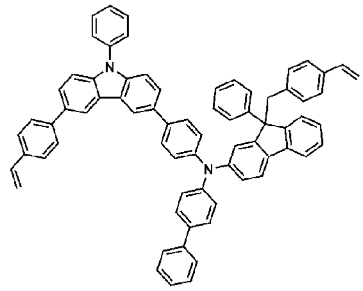

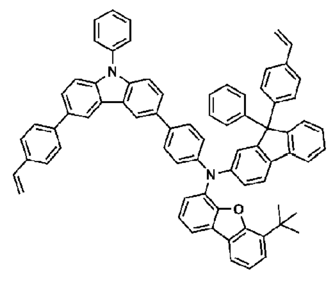
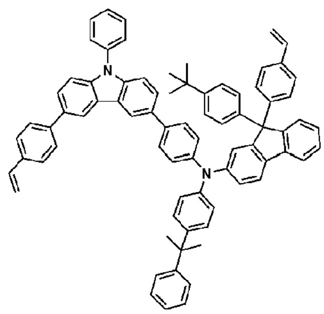
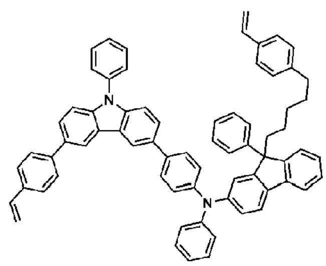

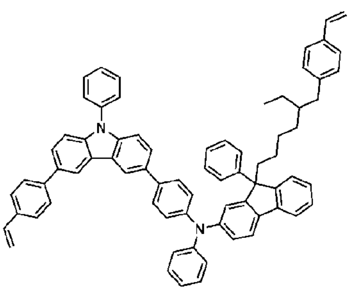
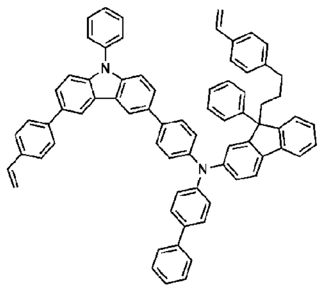
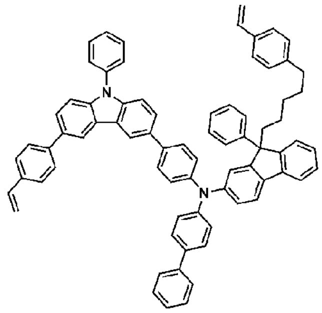

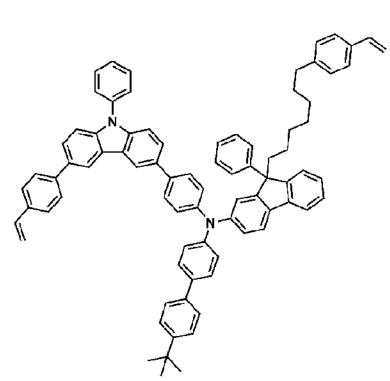

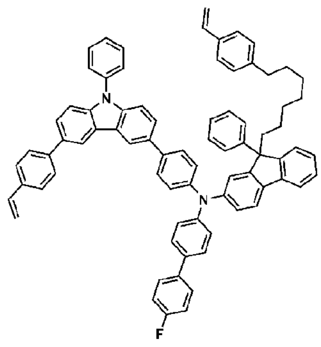

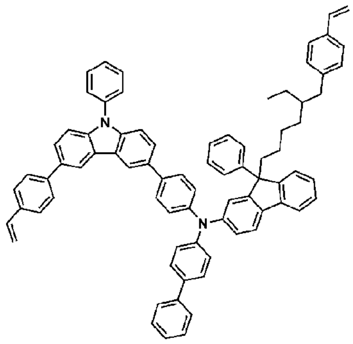

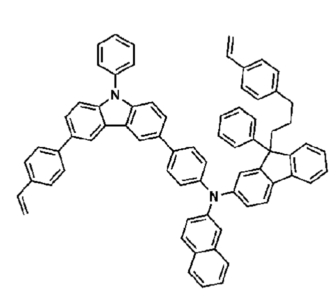

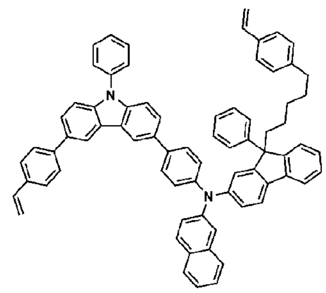

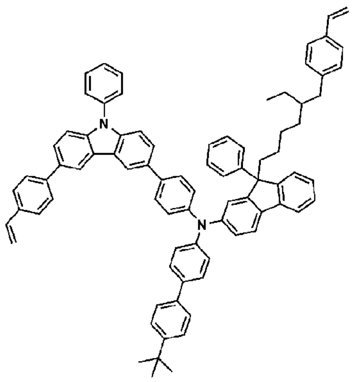

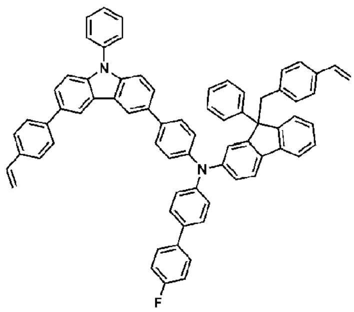

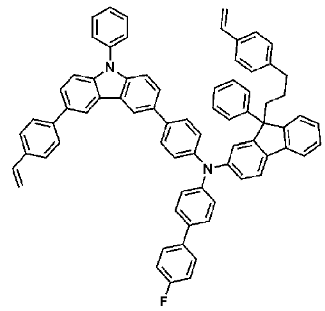

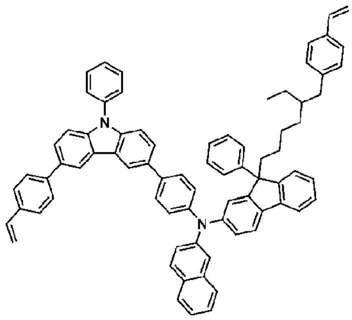

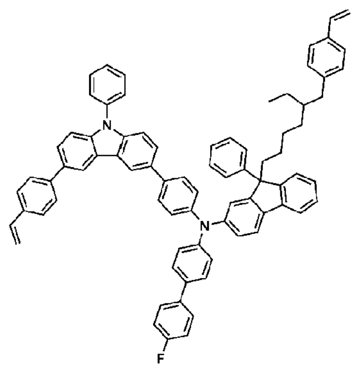

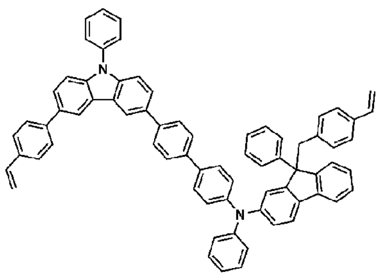

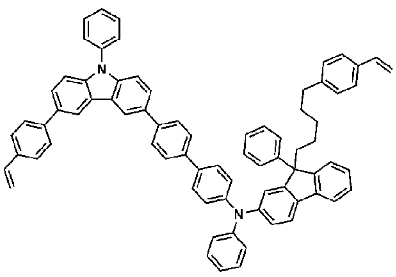

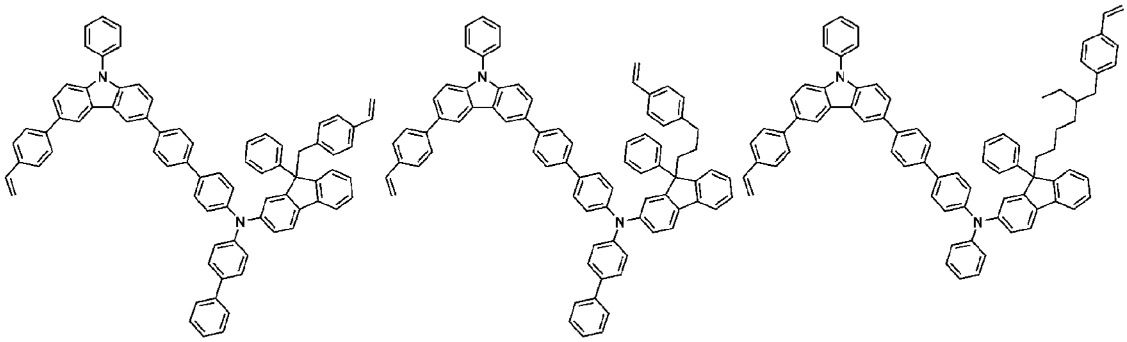

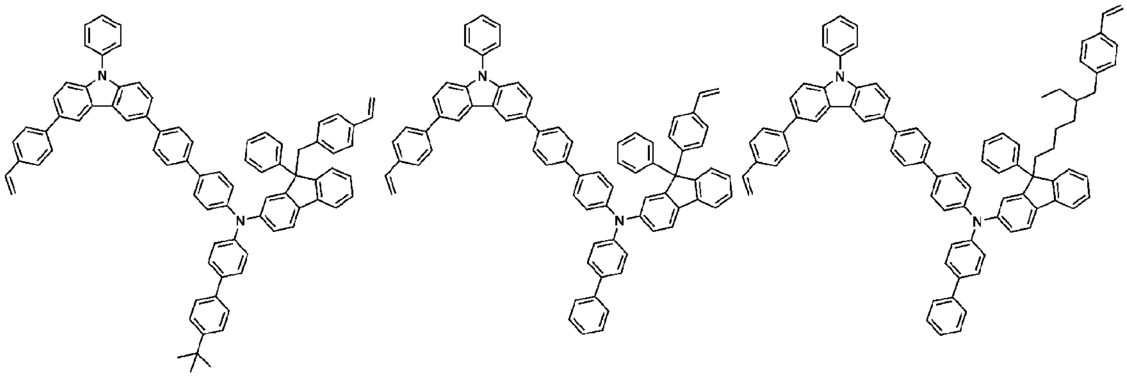

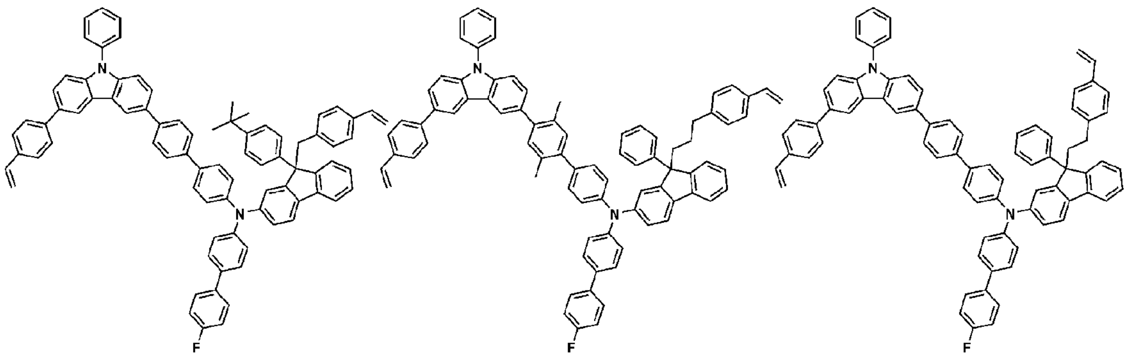

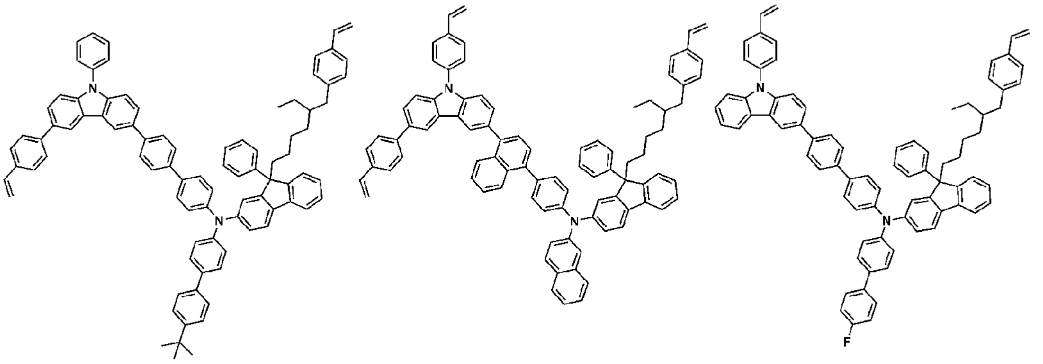

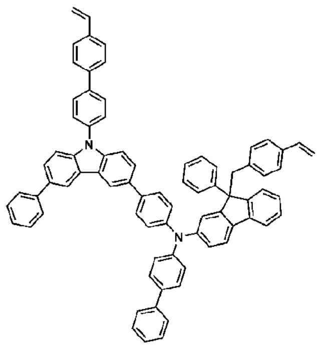

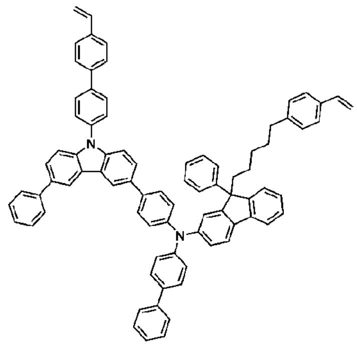

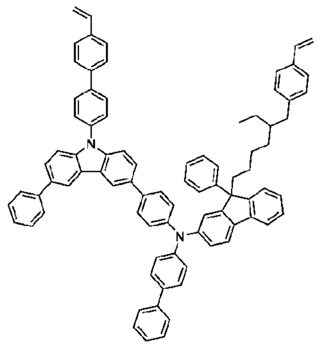

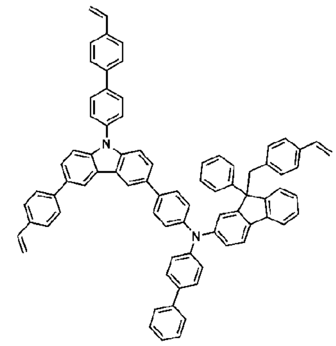

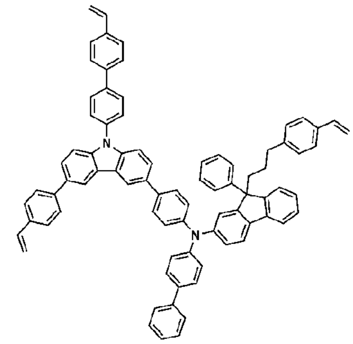

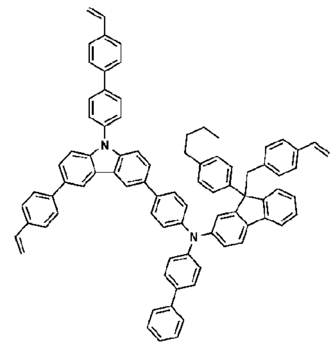

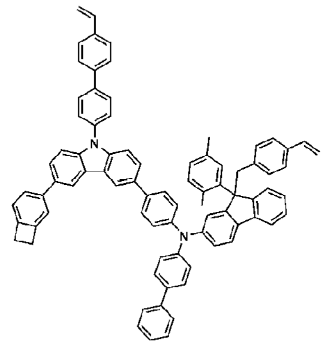

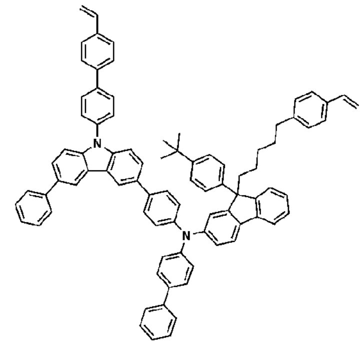

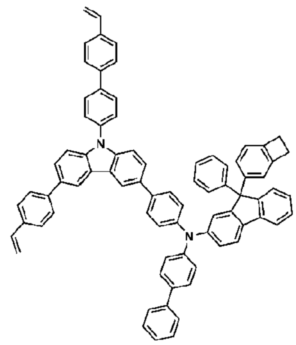

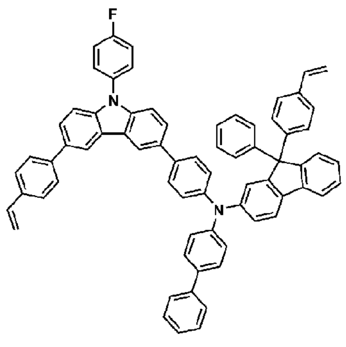

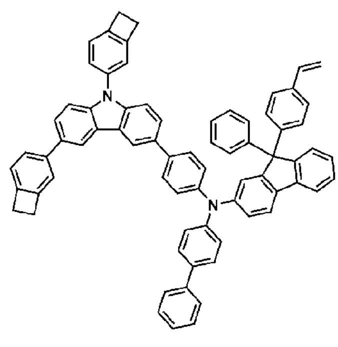

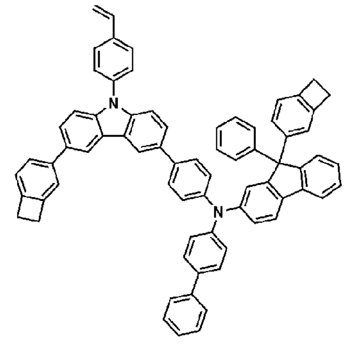

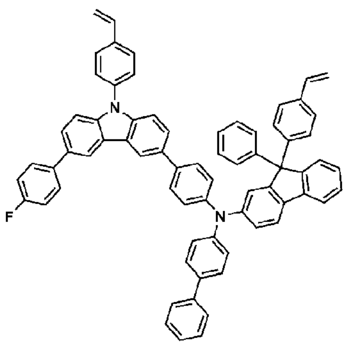
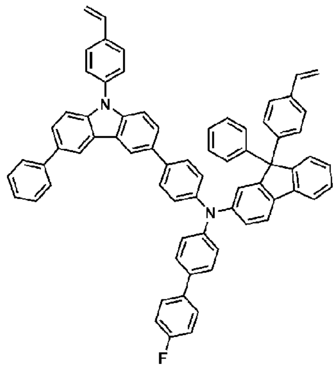
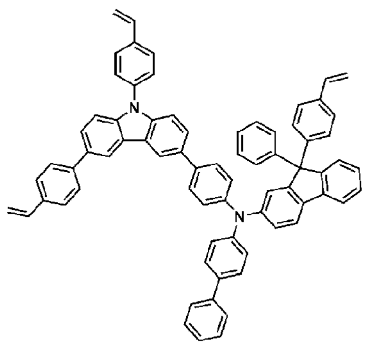
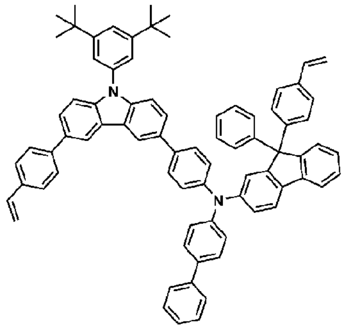
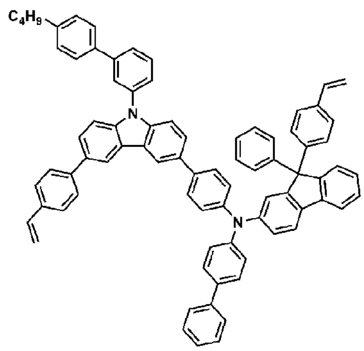
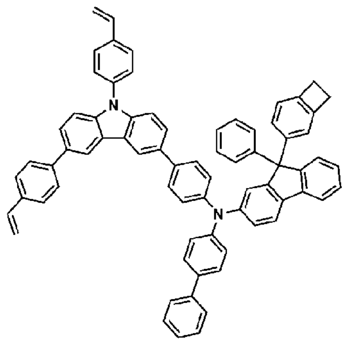
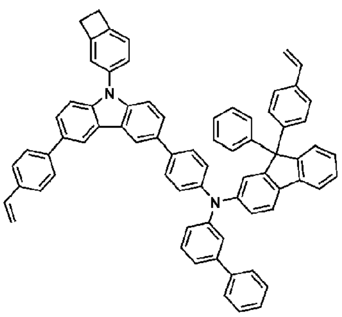
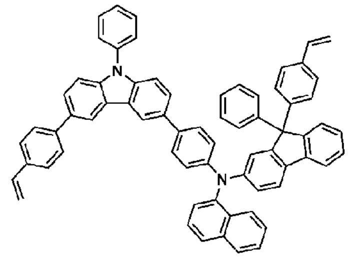
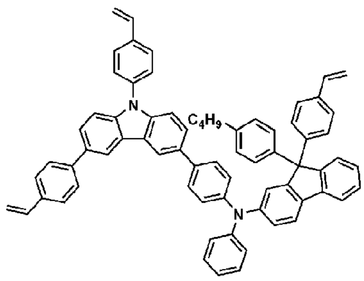
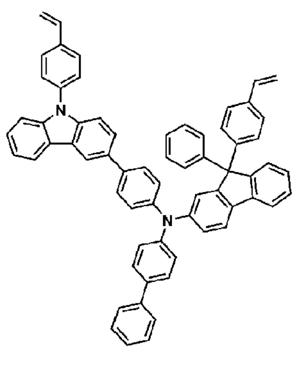
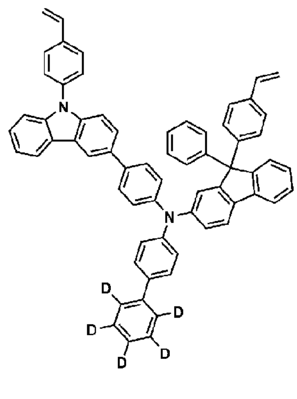
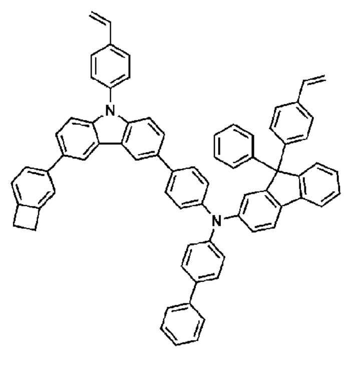

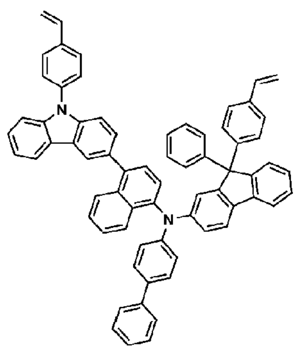
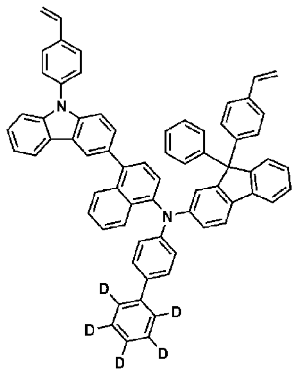
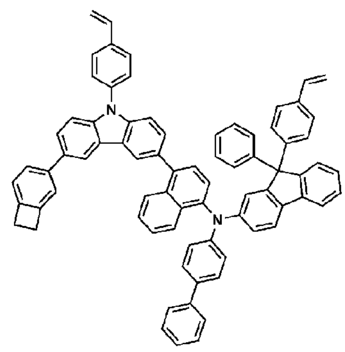
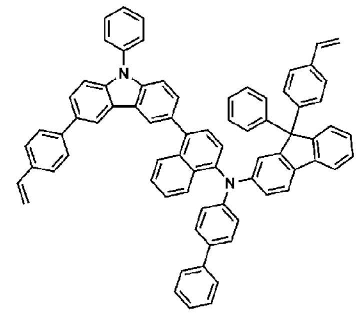
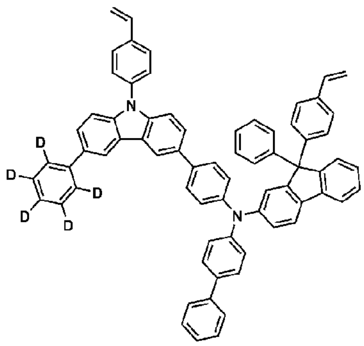
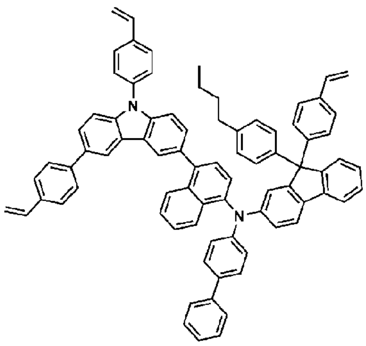
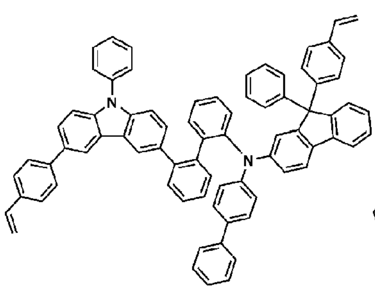
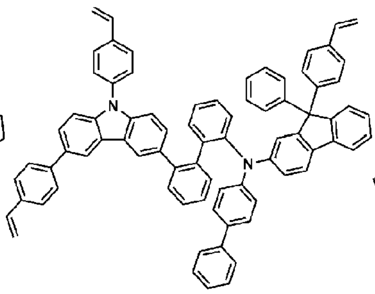
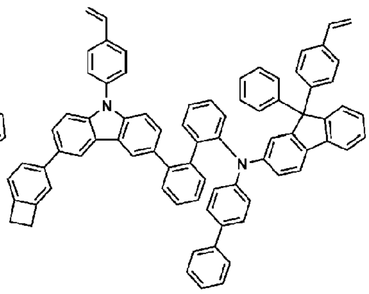
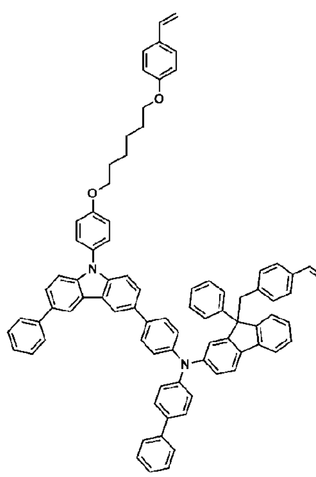
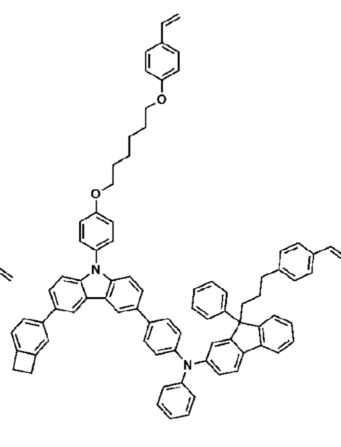
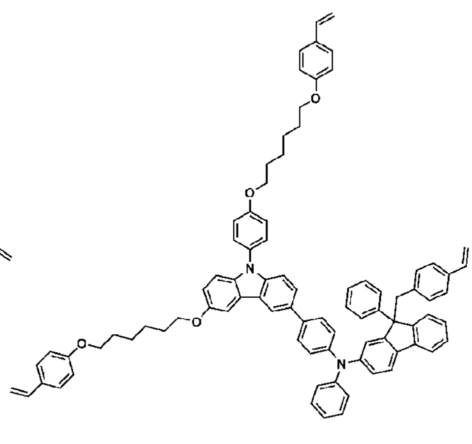

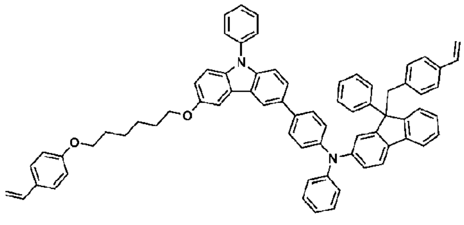
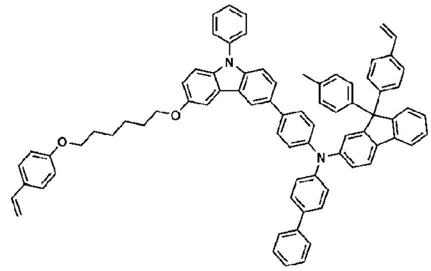

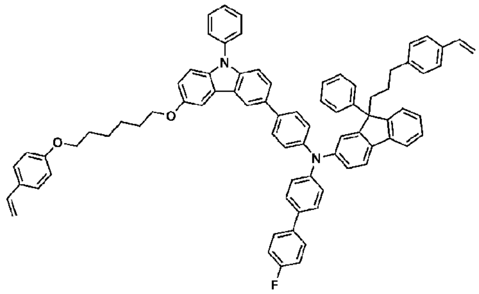
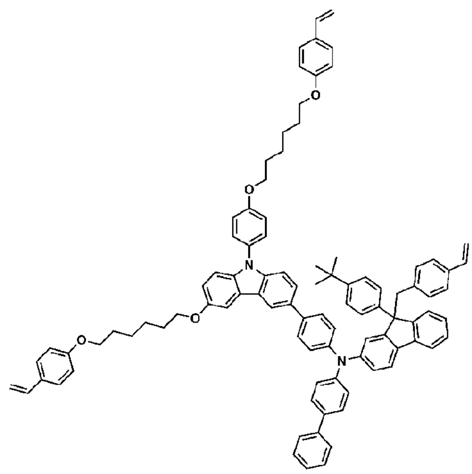

6. The organic light emitting device of Claim 1, wherein at least one of R103, R108, R113 and R118 is a curing group.

7. The organic light emitting device of Claim 1, wherein the curing group is any one of the following structures:

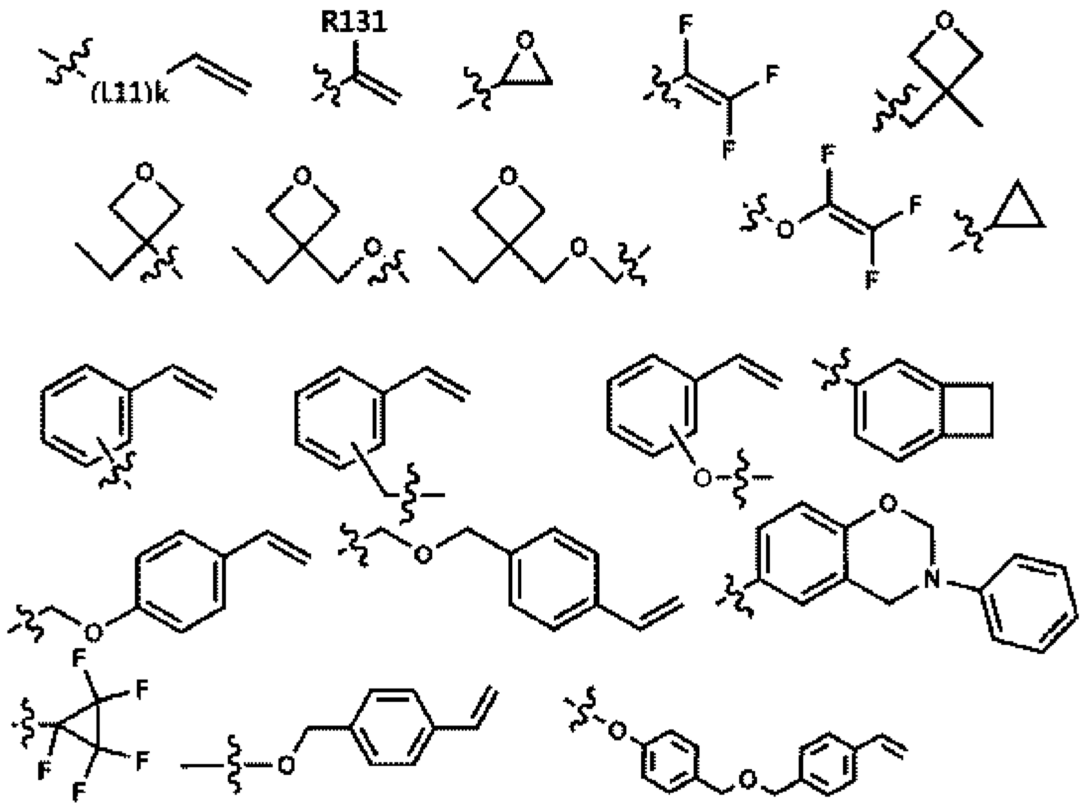

wherein:

L11 is a direct bond, -O-, -S-, a substituted or unsubstituted alkylene group, a substituted or unsubstituted arylene group or a substituted or unsubstituted heteroarylene group;
k is 1 or 2;
when k is 2, L11s are the same as or different from each other;
R131 is a substituted or unsubstituted alkyl group; and
each

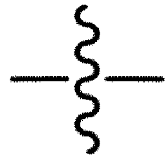

means a linking site.

**8.** The organic light emitting device of Claim 1, wherein the anion group represented by Chemical Formula 11 is any one of the following structures:

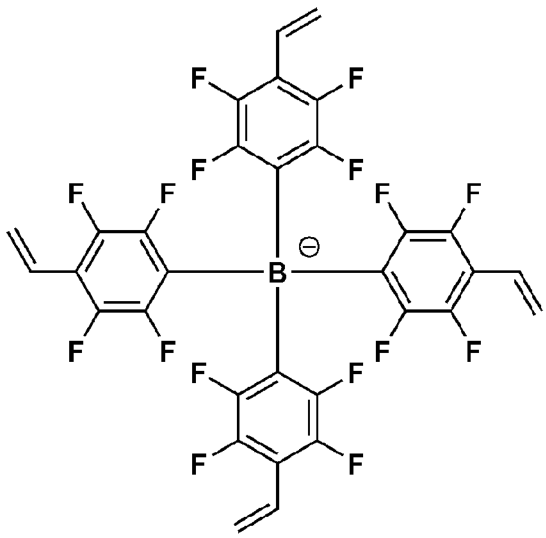

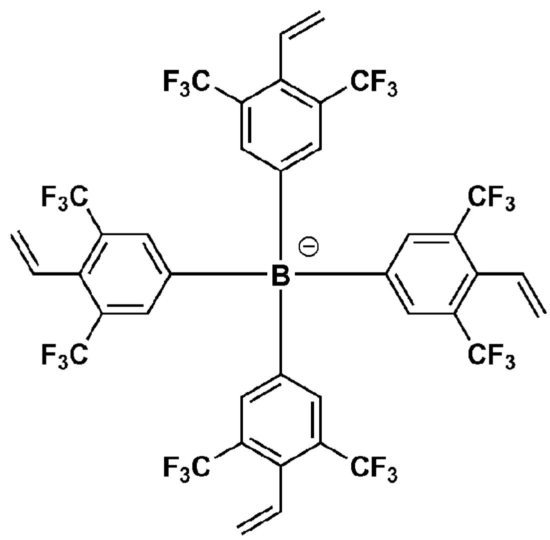

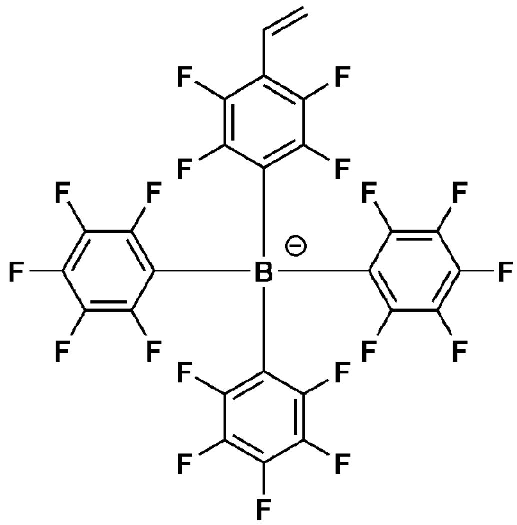

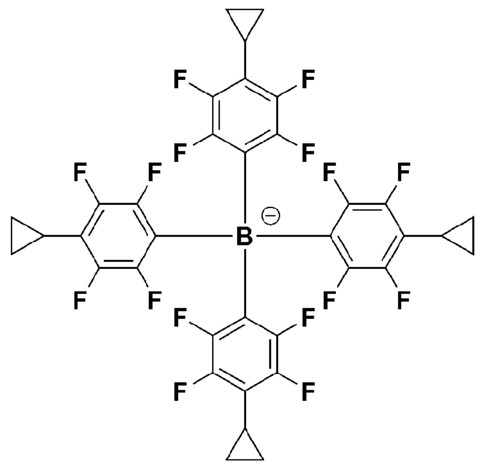

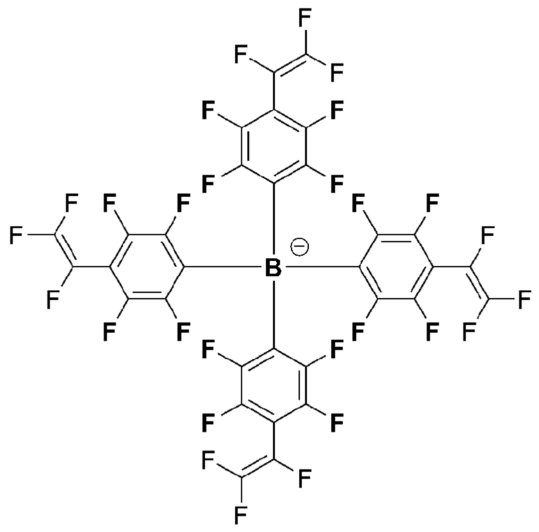

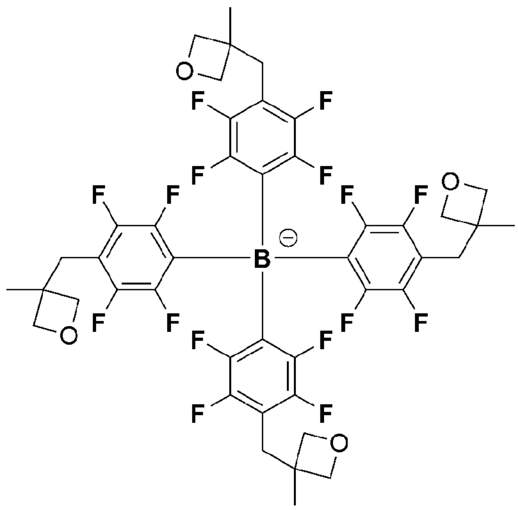

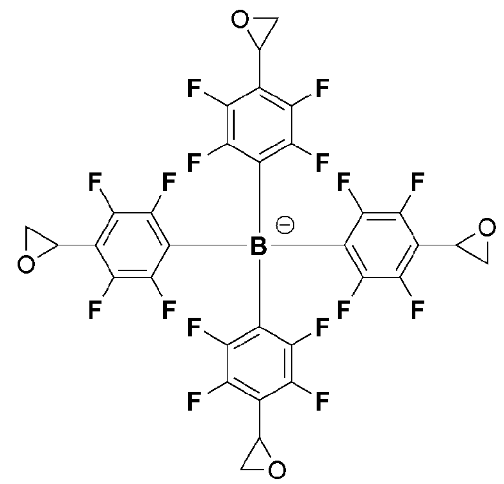

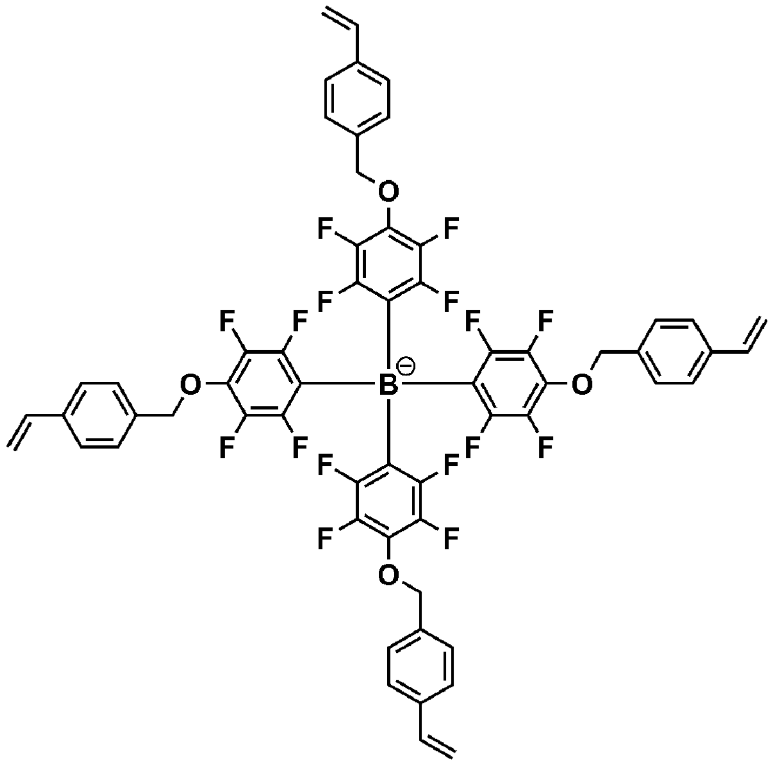

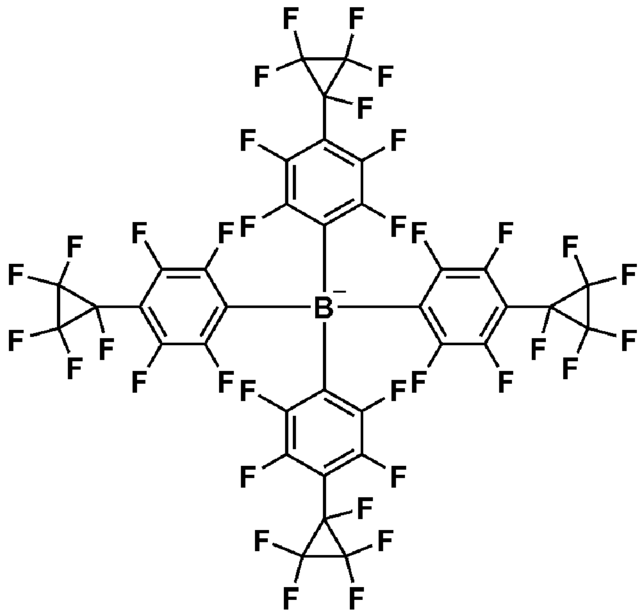

.

**9.** The organic light emitting device of Claim 1, wherein the ionic compound includes a cation group selected from one of the following structural formulae:

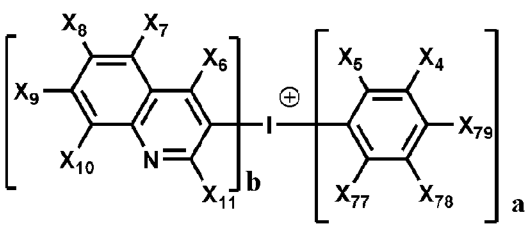

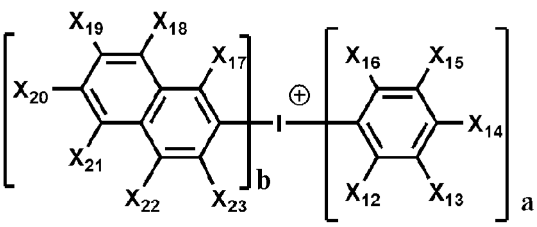

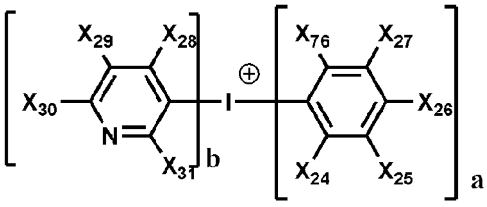

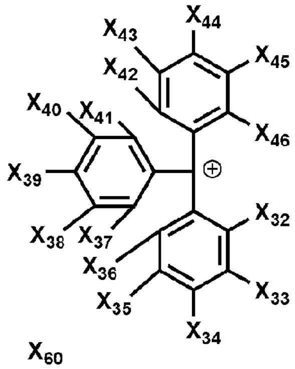

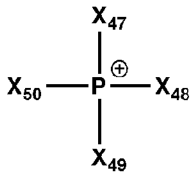

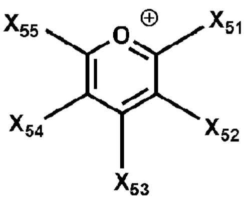

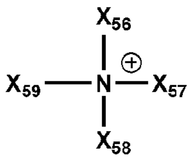

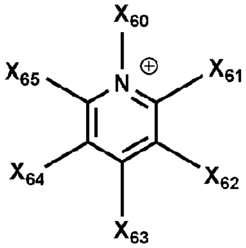

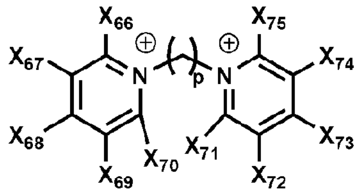

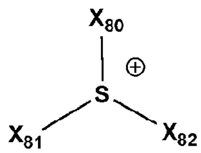

wherein:

$X_4$ to $X_{79}$ are the same as or different from each other, and each independently is hydrogen, a cyano group, a nitro group, a halogen group, -$COOR_{200}$, a substituted or unsubstituted alkyl group, a substituted or unsubstituted alkoxy group, a substituted or unsubstituted cycloalkyl group, a substituted or unsubstituted fluoroalkyl group, a substituted or unsubstituted aryl group or the curing group;
$R_{200}$ is hydrogen; deuterium; or a substituted or unsubstituted alkyl group;
p is an integer of 0 to 10;
a is 1 or 2, b is 0 or 1, and a+b=2; and
$X_{80}$ to $X_{82}$ are the same as or different from each other, and each independently is a substituted or unsubstituted alkyl group, a substituted or unsubstituted alkenyl group, a substituted or unsubstituted alkynyl group, a substituted or unsubstituted cycloalkyl group, a substituted or unsubstituted aryl group, or a substituted or unsubstituted heterocyclic group, or groups adjacent to each other bond to each other to form a ring.

**10.** The organic light emitting device of Claim 1, wherein the organic material layer including the cured material is a hole transfer layer, a hole injection layer or a layer carrying out hole transfer and hole injection at the same time.

**11.** The organic light emitting device of Claim 1, wherein the organic material layer including the cured material is a light emitting layer.

## Patentansprüche

**1.** Organische lichtemittierende Vorrichtung, umfassend:

eine erste Elektrode,
eine zweite Elektrode, die gegenüber der ersten Elektrode angeordnet ist, und
eine oder mehr organische Materialschichten, die zwischen der ersten Elektrode und der zweiten Elektrode angeordnet sind,
wobei eine oder mehr Schichten der organischen Materialschichten ein gehärtetes Material einschließen, das

aus einer durch die folgende chemische Formel 1 dargestellten Verbindung und einer ionischen Verbindung einschließlich einer durch die folgende chemische Formel 11 dargestellten Anionengruppe gebildet ist:

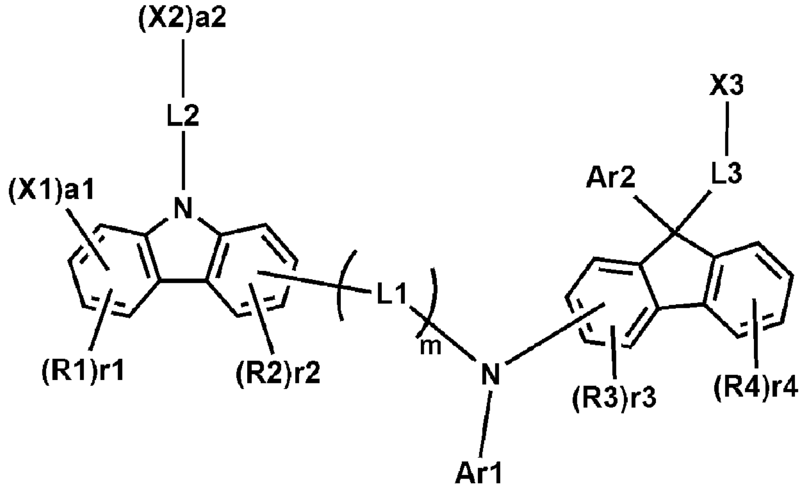

[Chemische Formel 1]

worin

Ar1 und Ar2 gleich oder verschieden voneinander sind und jeweils unabhängig eine substituierte oder unsubstituierte Arylgruppe oder eine substituierte oder unsubstituierte heterocyclische Gruppe sind,
R1 bis R4 gleich oder verschieden voneinander sind und jeweils unabhängig Wasserstoff, Deuterium, eine Halogengruppe, eine Nitrilgruppe, eine substituierte oder unsubstituierte Alkylgruppe, eine substituierte oder unsubstituierte Arylgruppe oder eine substituierte oder unsubstituierte heterocyclische Gruppe sind,
r1 bis r3 jeweils 1 bis 3 sind,
r4 1 bis 4 ist,
wenn r1 bis r4 jeweils zwei oder größer sind, die zwei oder mehr R1 bis R4 jeweils gleich oder verschieden voneinander sind,
X1 bis X3 gleich oder verschieden voneinander sind und jeweils unabhängig aus den folgenden Strukturformeln ausgewählt sind,

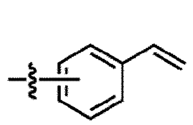
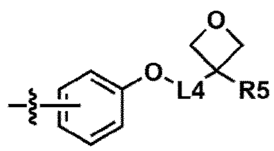
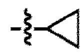

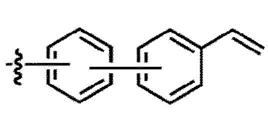
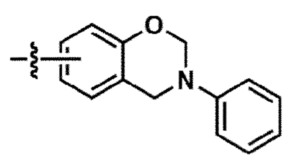
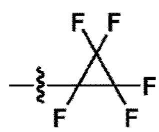

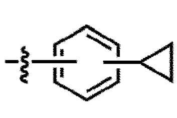
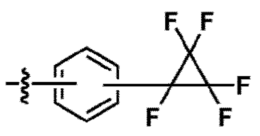
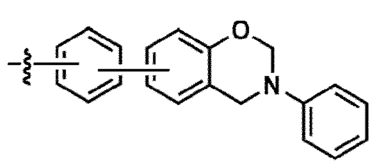

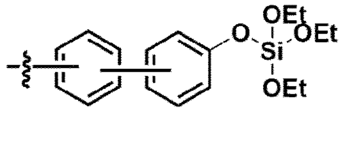
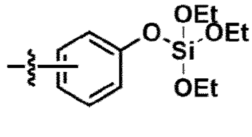
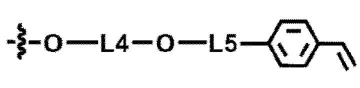

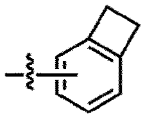 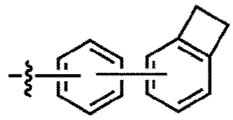

jedes

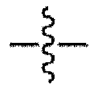

eine Verknüpfungsstelle bezeichnet,
L4 eine substituierte oder unsubstituierte Alkylengruppe ist,
L5 eine direkte Bindung oder eine substituierte oder unsubstituierte Arylengruppe ist,
R5 Wasserstoff oder eine substituierte oder unsubstituierte Alkylgruppe ist,
a1 und a2 jeweils 0 oder 1 sind,
wenn a2 0 ist, L2 eine substituierte oder unsubstituierte Arylgruppe ist,
wenn a2 1 ist, L2 eine direkte Bindung oder eine substituierte oder unsubstituierte Arylengruppe ist,
m 1 oder 2 ist, und wenn m 2 ist, die L1 gleich oder verschieden voneinander sind, und L1 eine direkte Bindung oder eine substituierte oder unsubstituierte Arylengruppe ist,
L3 eine direkte Bindung oder eine substituierte oder unsubstituierte Alkylengruppe ist und

$$0 \le a1 + a2 \le 2$$

ist,

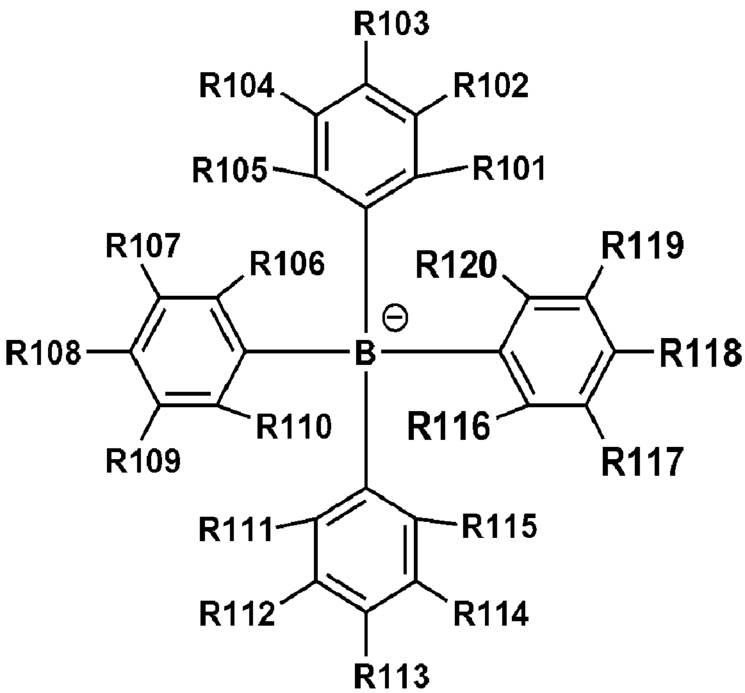

[Chemische Formel 11]

worin

mindestens eines von R101 bis R120 F, eine Cyanogruppe oder eine substituierte oder unsubstituierte Fluoralkylgruppe ist,
mindestens eines der verbleibenden R101 bis R120 eine härtende Gruppe ist und
die verbleibenden R101 bis R120 gleich oder verschieden voneinander sind und jeweils unabhängig Wasserstoff, Deuterium, eine Nitrogruppe, eine substituierte oder unsubstituierte Alkylgruppe, eine

substituierte oder unsubstituierte Alkenylgruppe, eine substituierte oder unsubstituierte Amingruppe, eine substituierte oder unsubstituierte Arylgruppe oder eine substituierte oder unsubstituierte heterocyclische Gruppe sind.

**2.** Organische lichtemittierende Vorrichtung gemäß Anspruch 1, wobei die chemische Formel 1 durch die folgende chemische Formel 2 dargestellt ist:

[Chemische Formel 2]

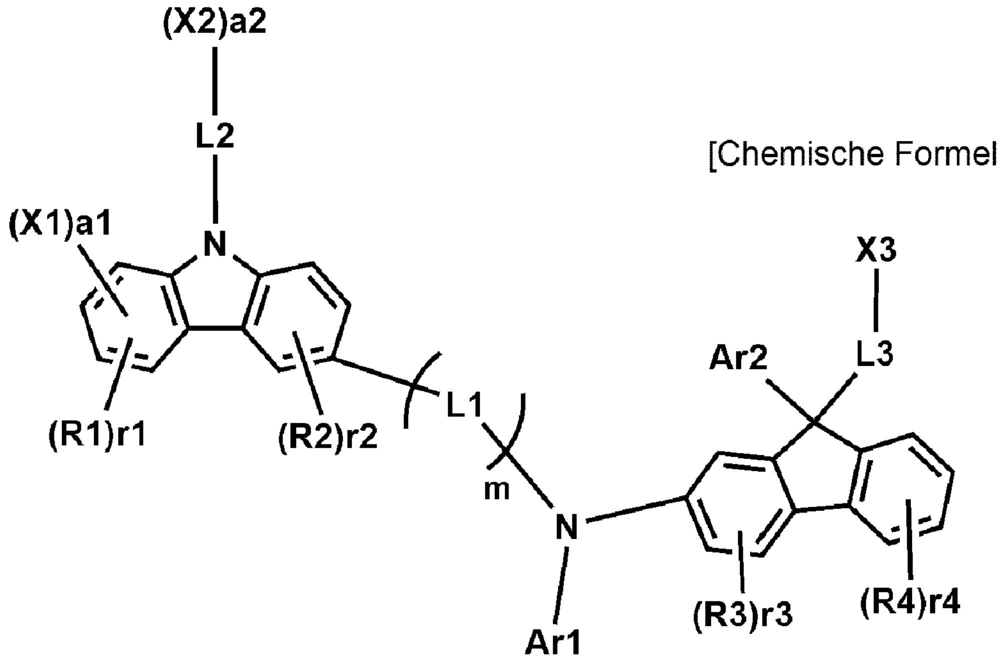

worin
L1 bis L3, Ar1, Ar2, R1 bis R4, r1 bis r4, X1 bis X3, m, a1 und a2 dieselben wie in Anspruch 1 definiert sind.

**3.** Organische lichtemittierende Vorrichtung gemäß Anspruch 1, wobei L1 eine substituierte oder unsubstituierte Phenylengruppe ist.

**4.** Organische lichtemittierende Vorrichtung gemäß Anspruch 1, wobei Ar1 und Ar2 gleich oder verschieden voneinander sind und jeweils unabhängig eine substituierte oder unsubstituierte Phenylgruppe oder eine substituierte oder unsubstituierte Biphenylgruppe sind.

**5.** Organische lichtemittierende Vorrichtung gemäß Anspruch 1, wobei die durch die chemische Formel 1 dargestellte Verbindung irgendeine der folgenden Verbindungen ist:

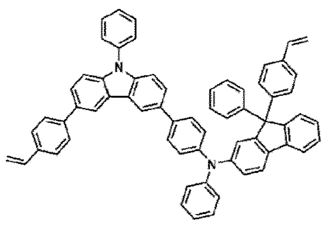 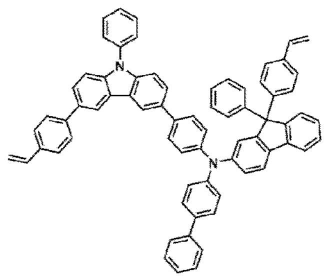 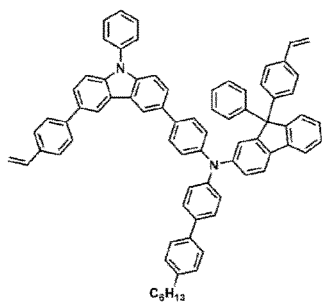

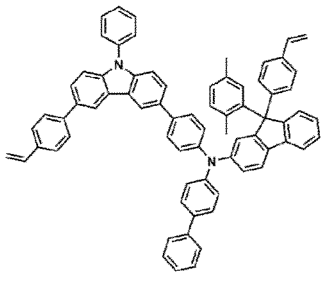
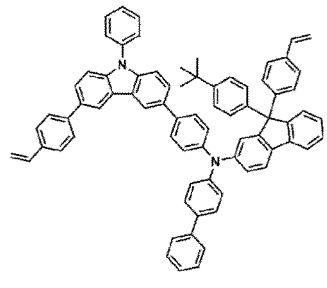
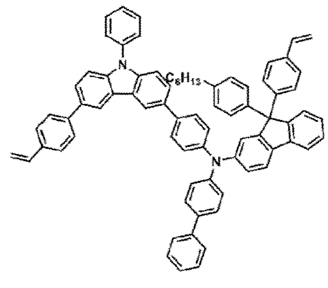
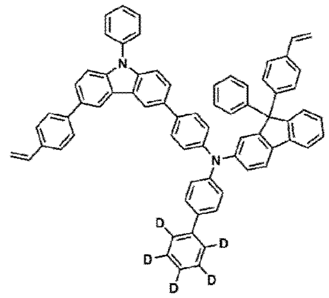
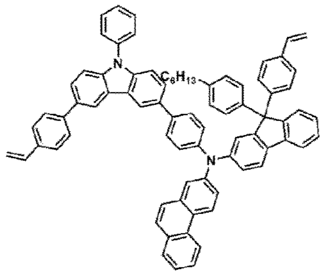
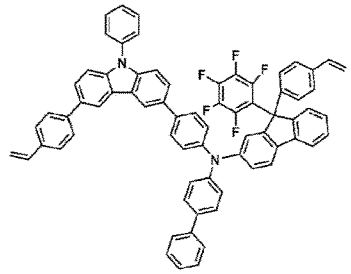
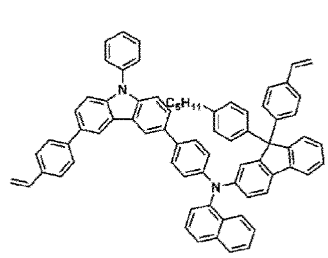
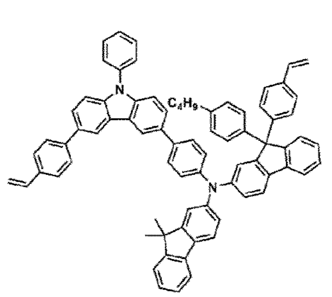
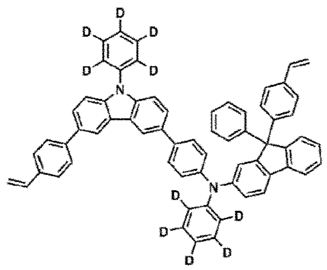
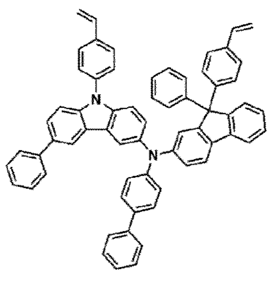
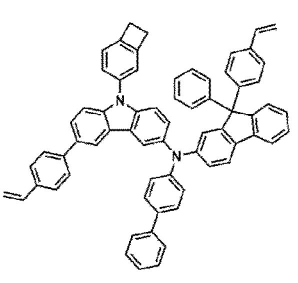
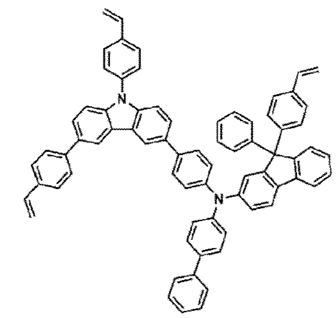
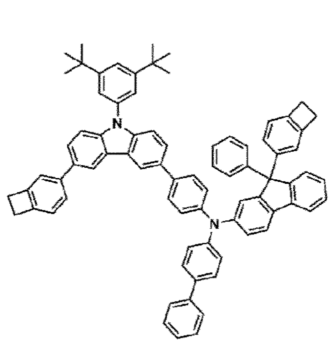
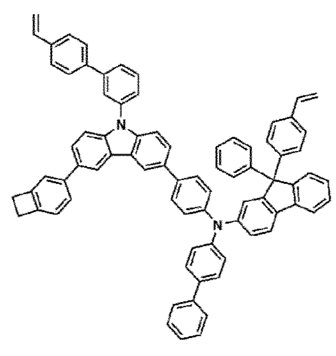
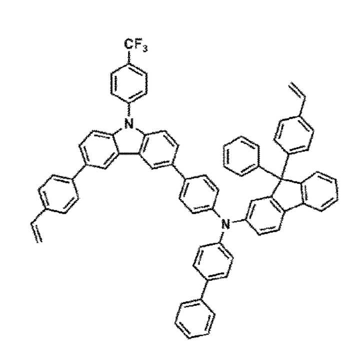

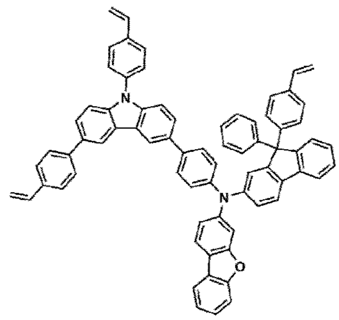

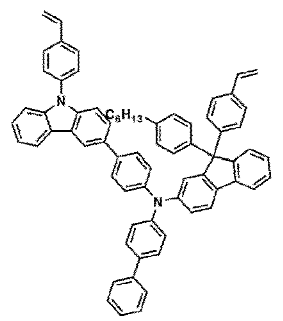

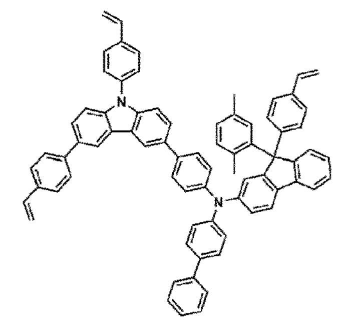

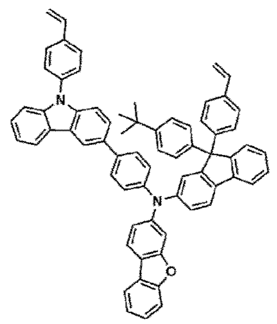

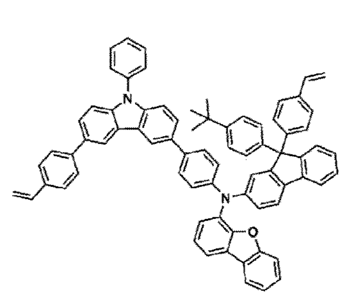

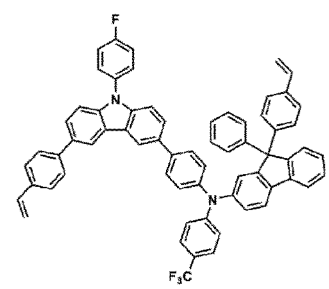

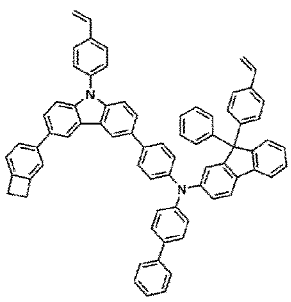

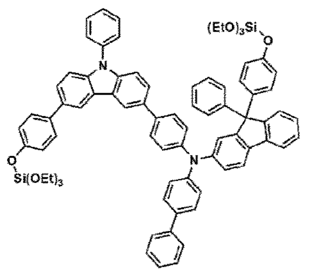

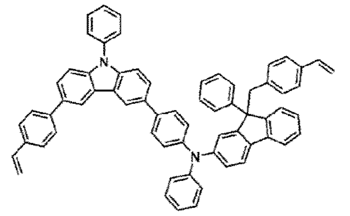

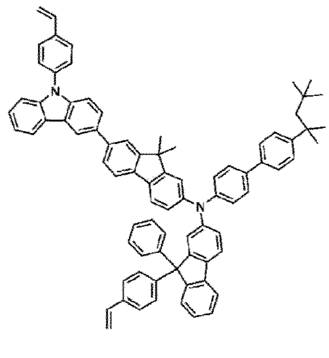

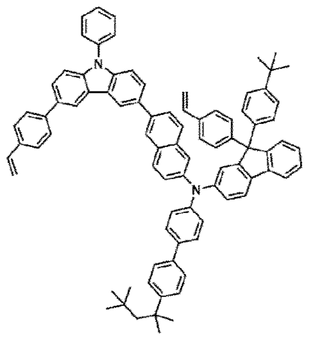

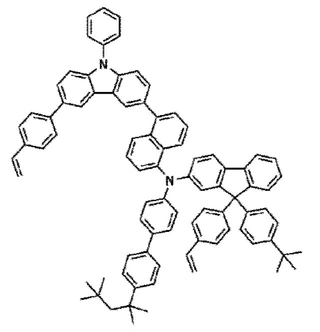

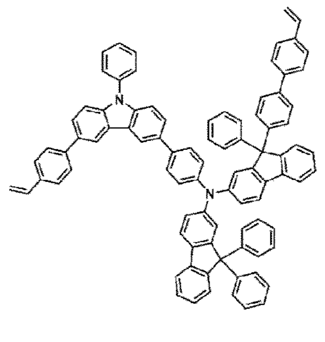
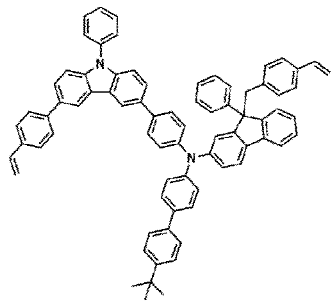
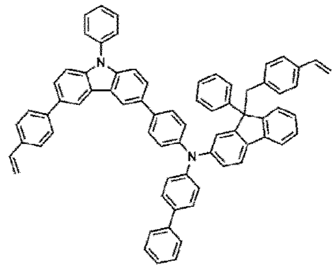

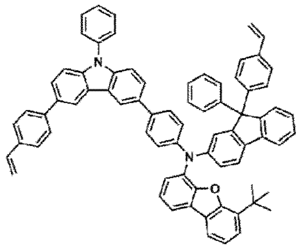
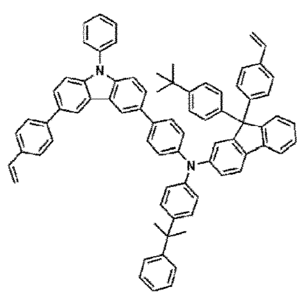
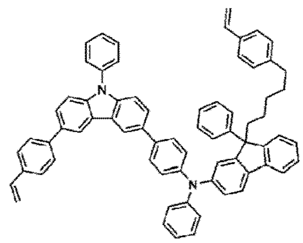

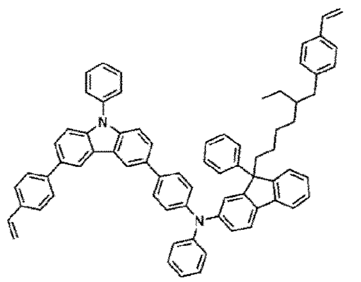
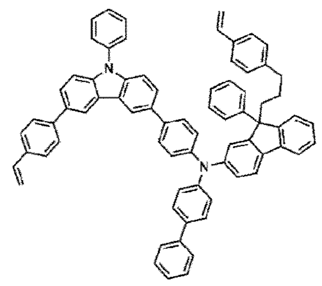
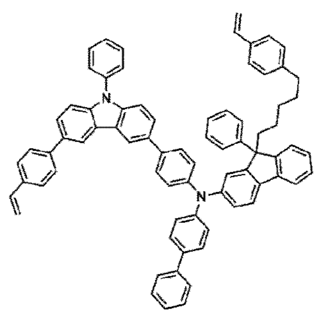

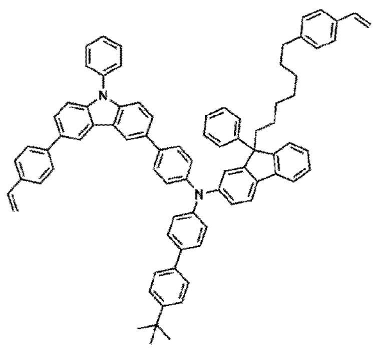
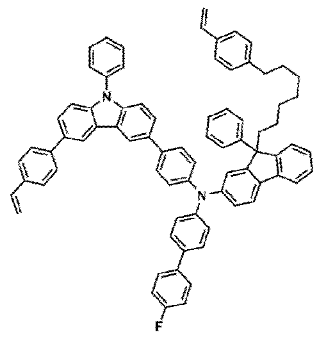
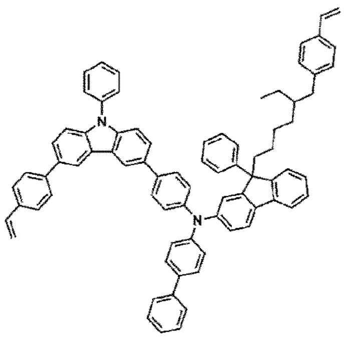

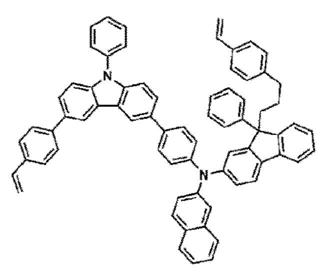

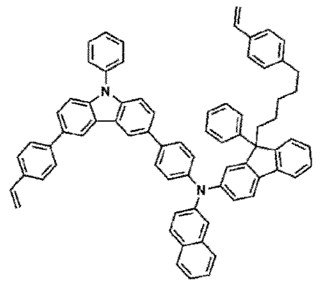

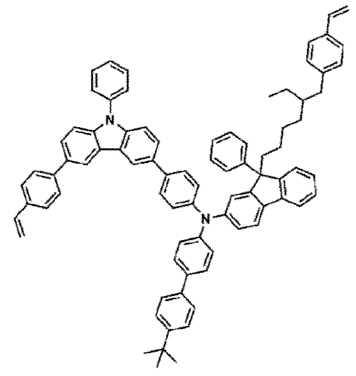

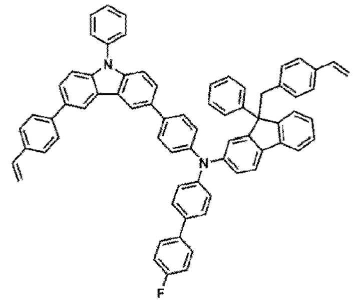

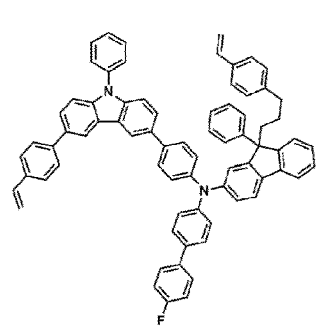

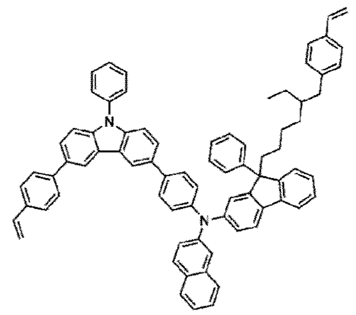

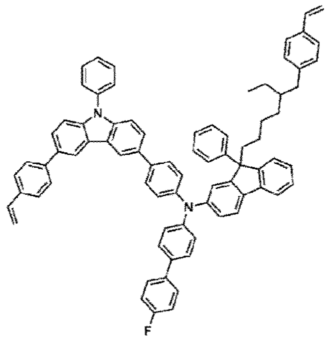

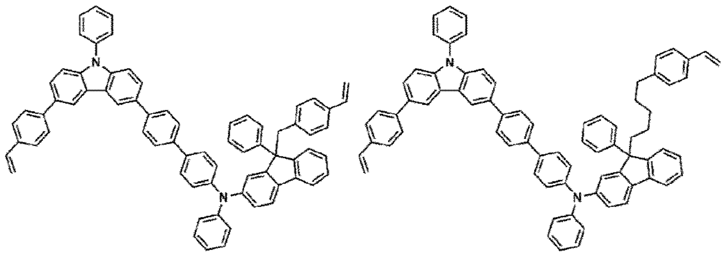

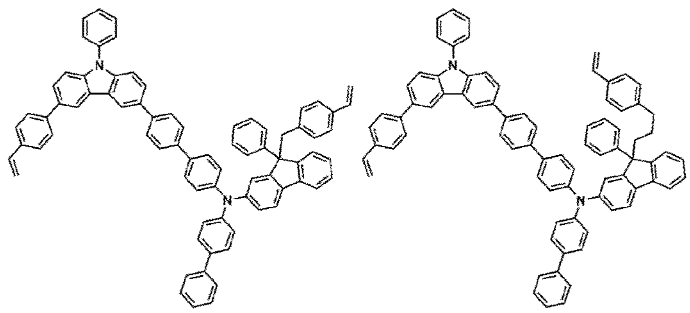

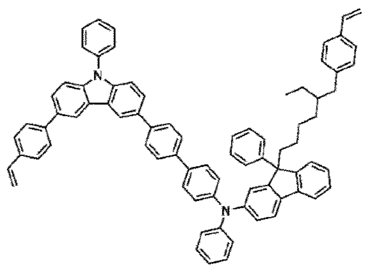

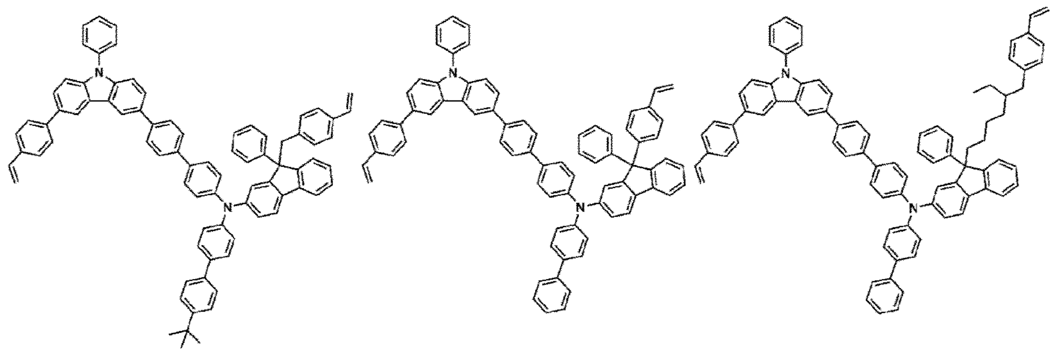

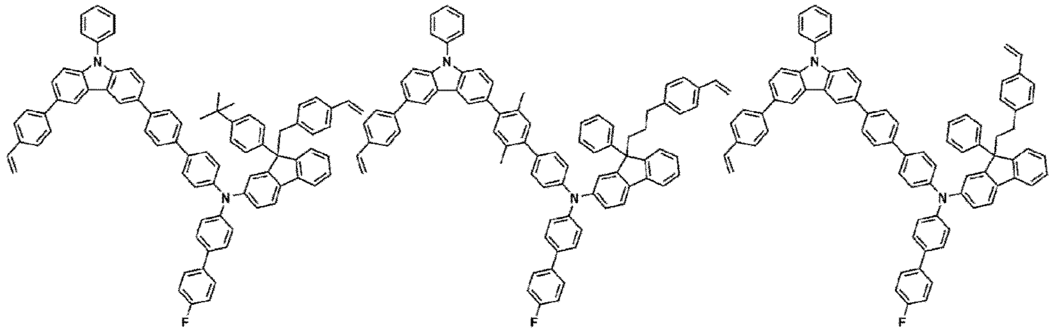

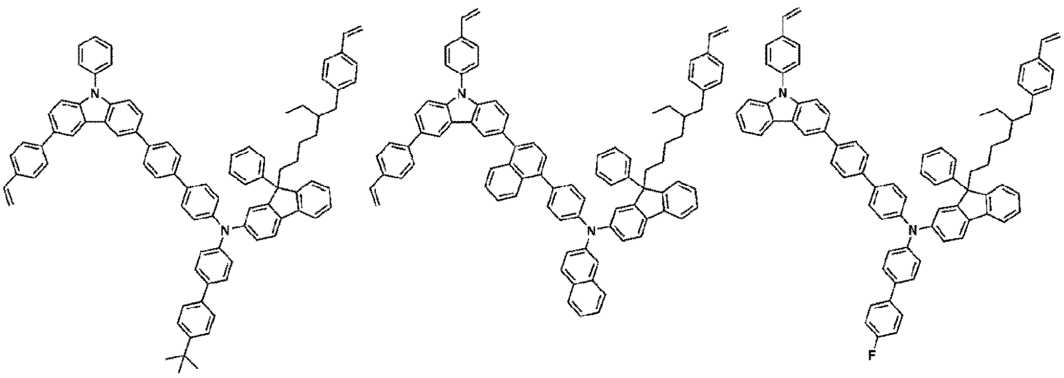

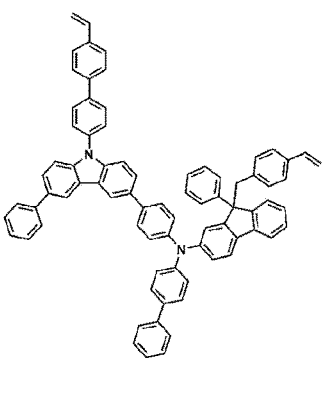

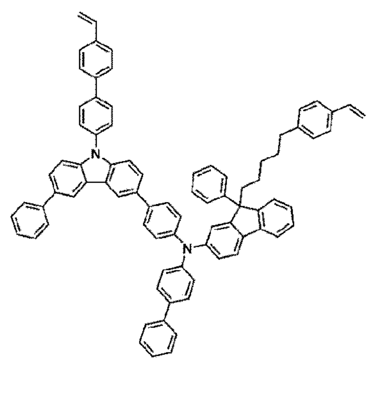

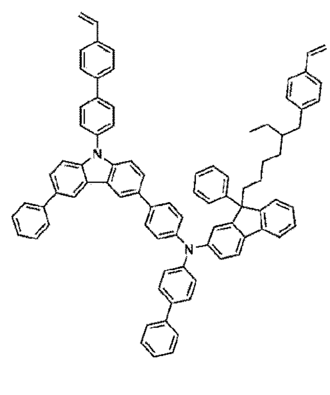

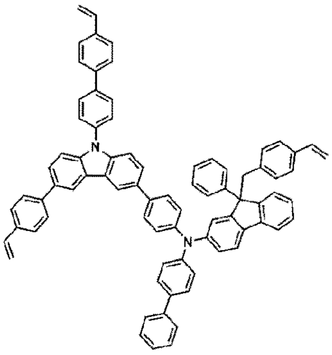
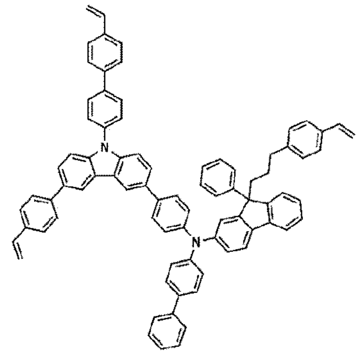
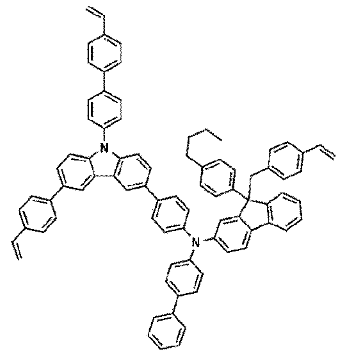

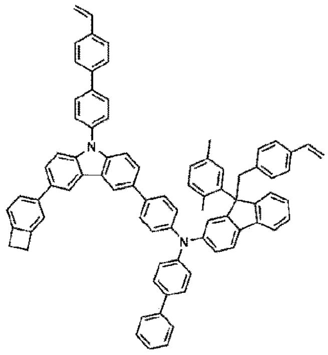
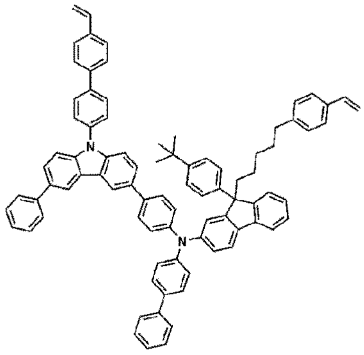
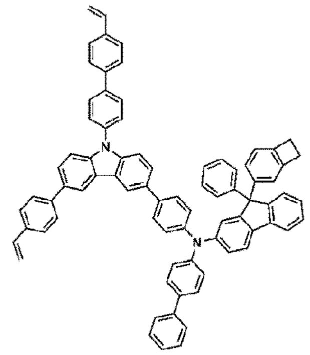

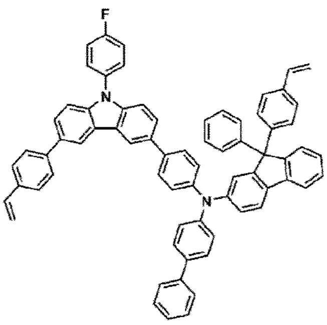
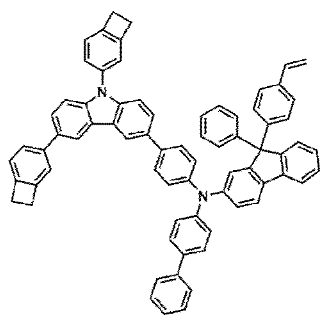
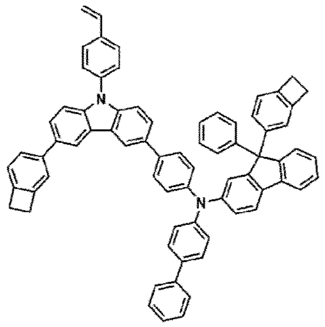

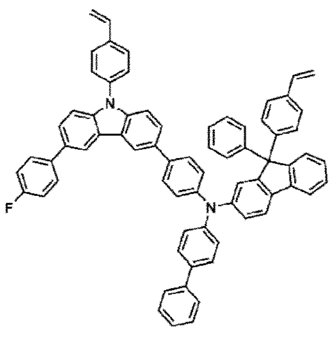
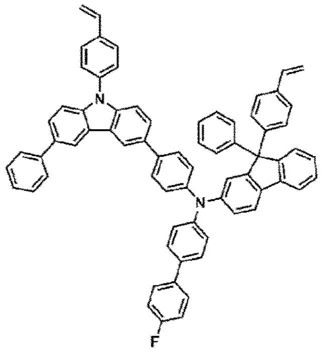
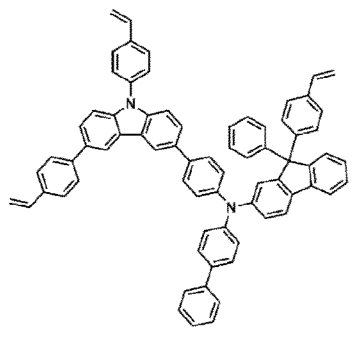

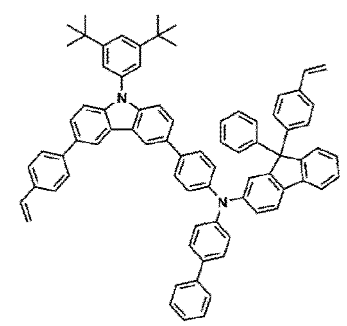
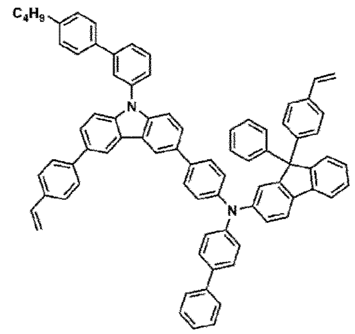
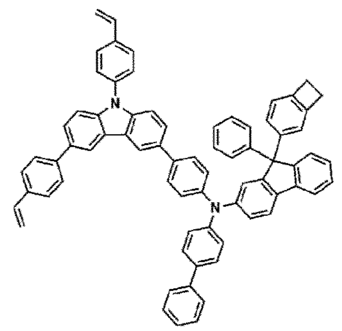
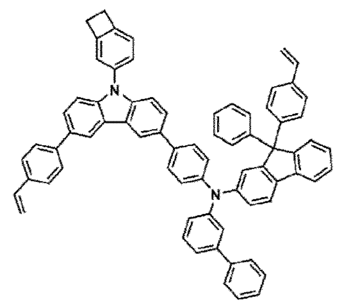
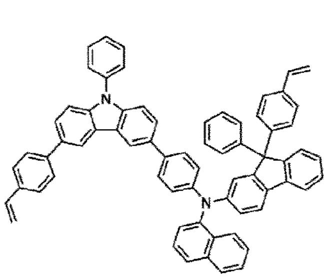
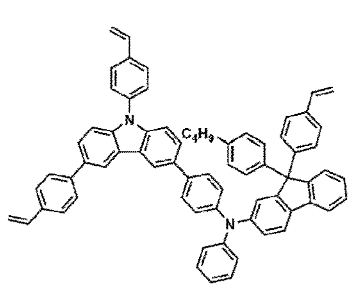
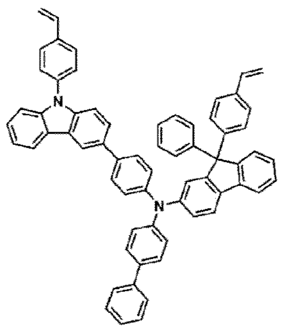
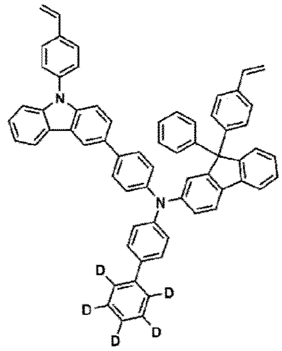
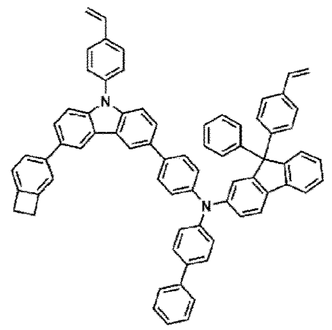
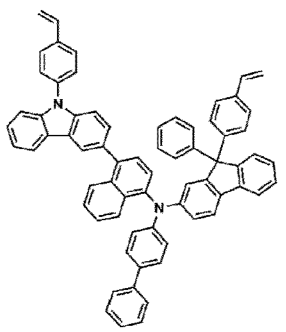
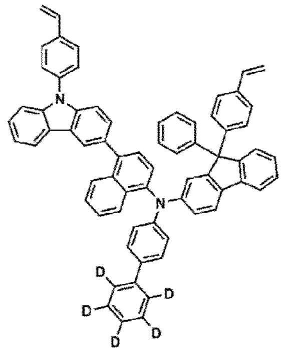
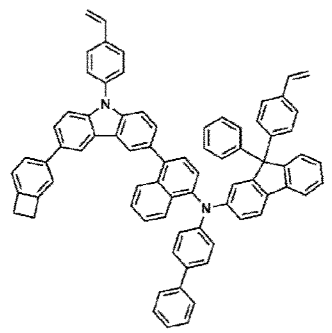

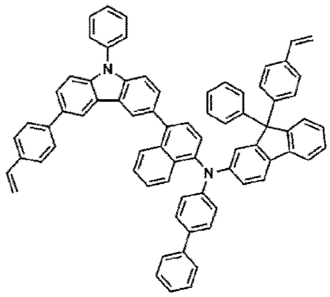

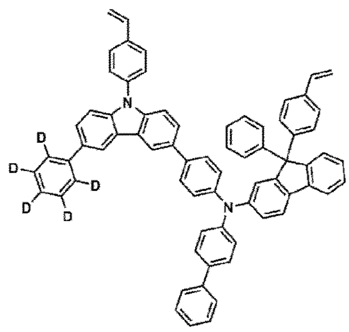

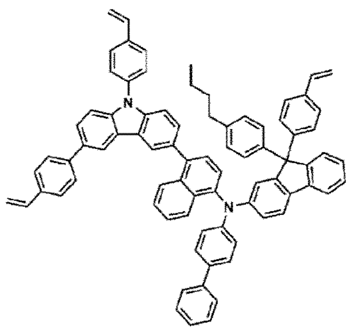

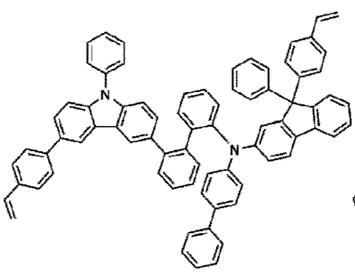

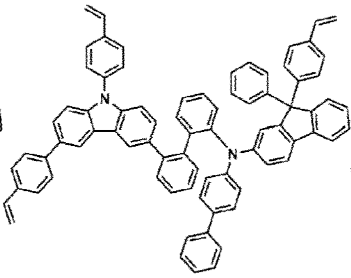

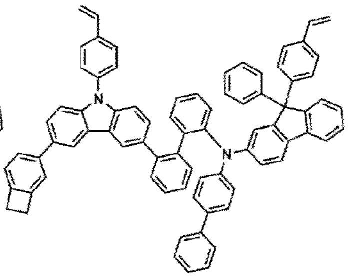

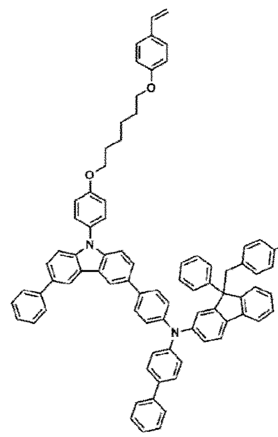

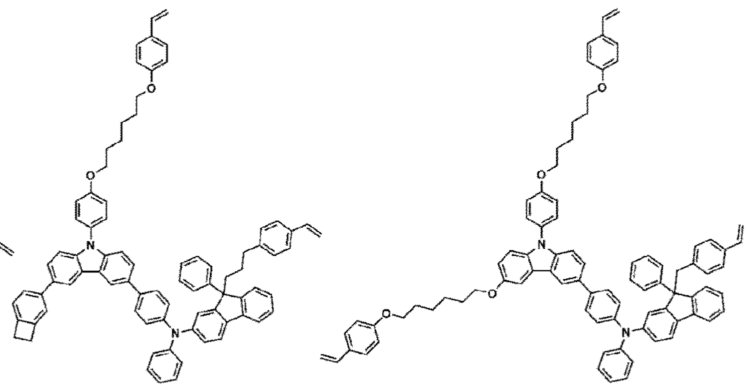

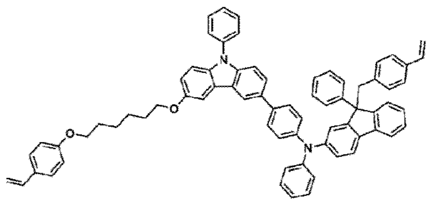

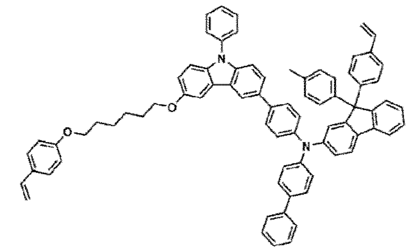

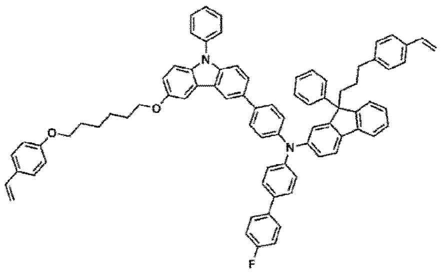 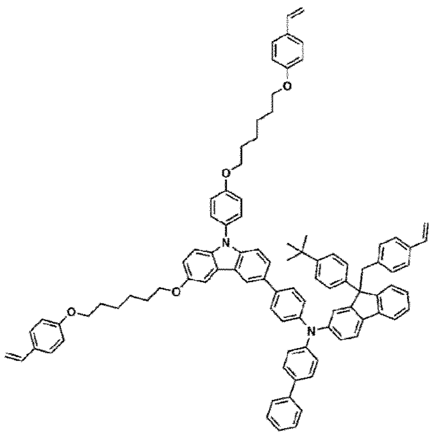 .

6. Organische lichtemittierende Vorrichtung gemäß Anspruch 1, wobei mindestens eines von R103, R108, R113 und R118 eine härtende Gruppe ist.

7. Organische lichtemittierende Vorrichtung gemäß Anspruch 1, wobei die härtende Gruppe irgendeine der folgenden Strukturen ist:

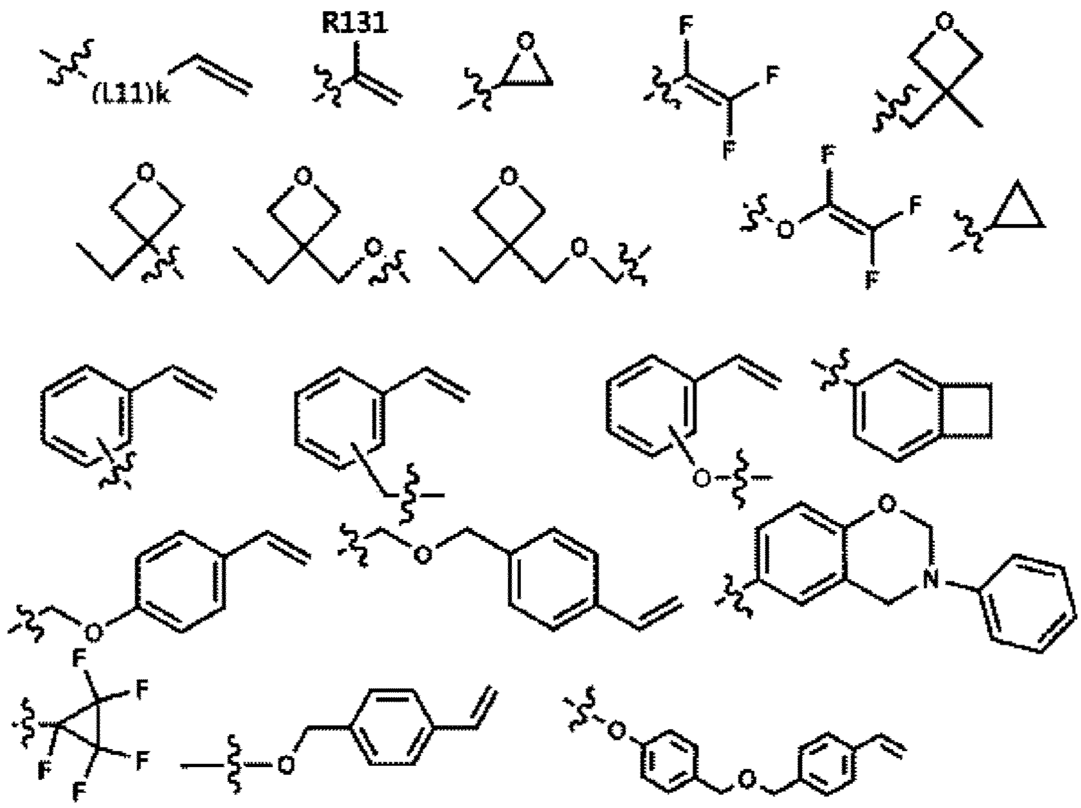

worin

L11 eine direkte Bindung, -O-, -S-, eine substituierte oder unsubstituierte Alkylengruppe, eine substituierte oder unsubstituierte Arylengruppe oder eine substituierte oder unsubstituierte Heteroarylengruppe ist,
k 1 oder 2 ist,
wenn k 2 ist, die L11 gleich oder verschieden voneinander sind,
R131 eine substituierte oder unsubstituierte Alkylgruppe ist und
jedes

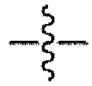

eine Verknüpfungsstelle bezeichnet.

**8.** Organische lichtemittierende Vorrichtung gemäß Anspruch 1, wobei die durch die chemische Formel 11 dargestellte Anionengruppe irgendeine der folgenden Strukturen ist:

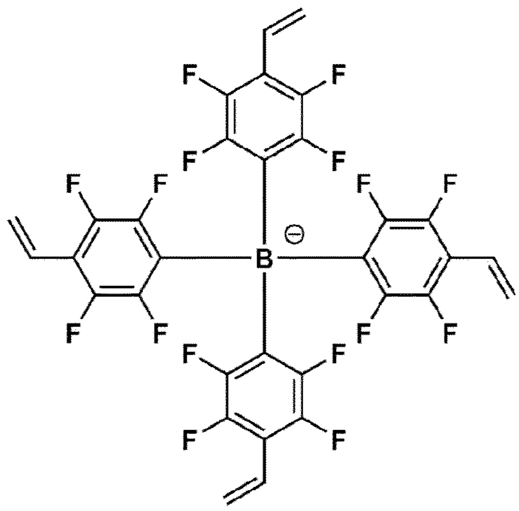

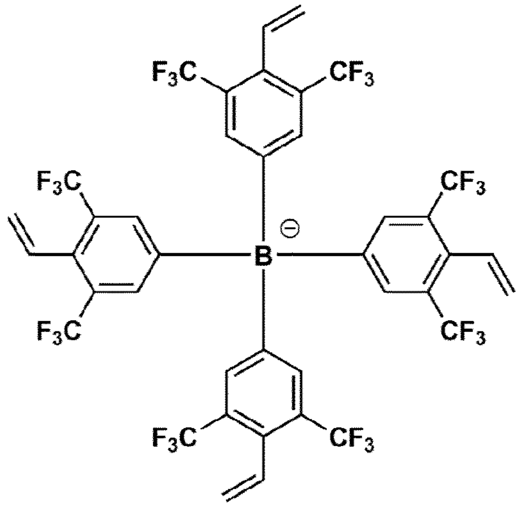

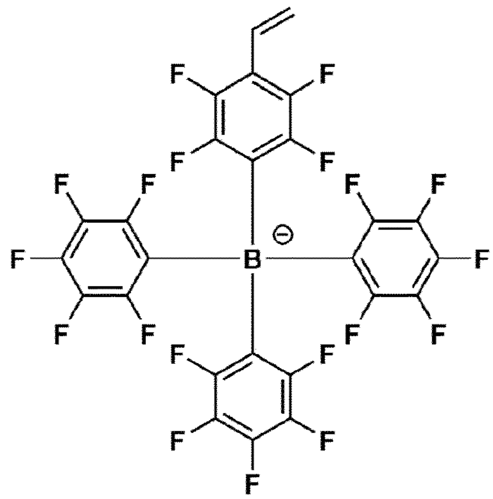

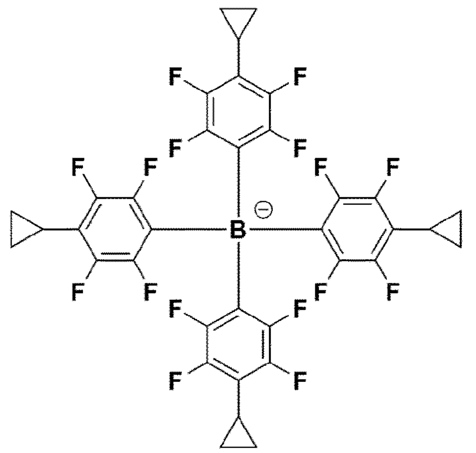

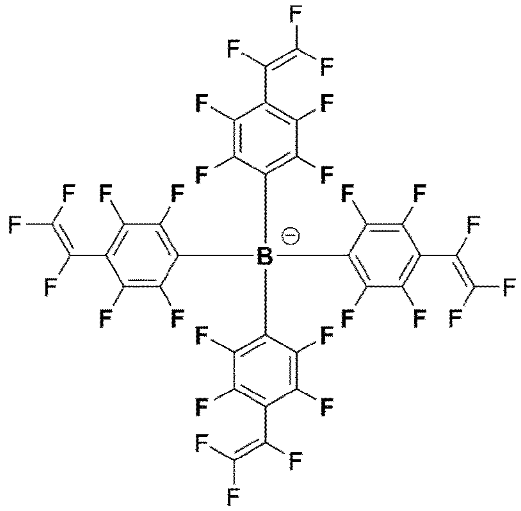

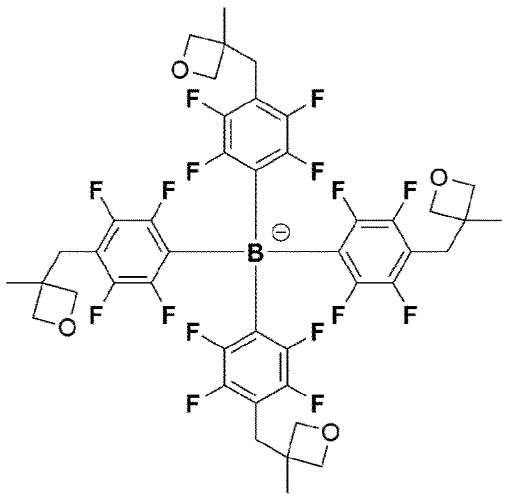

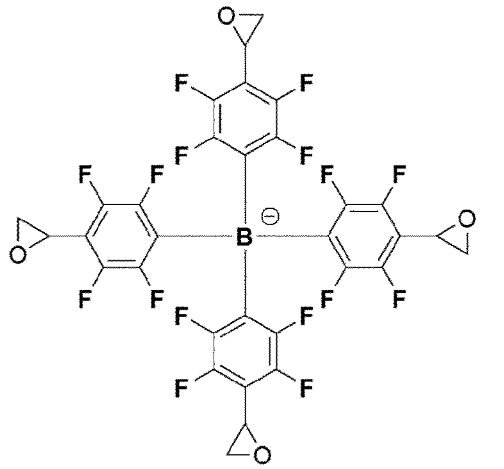

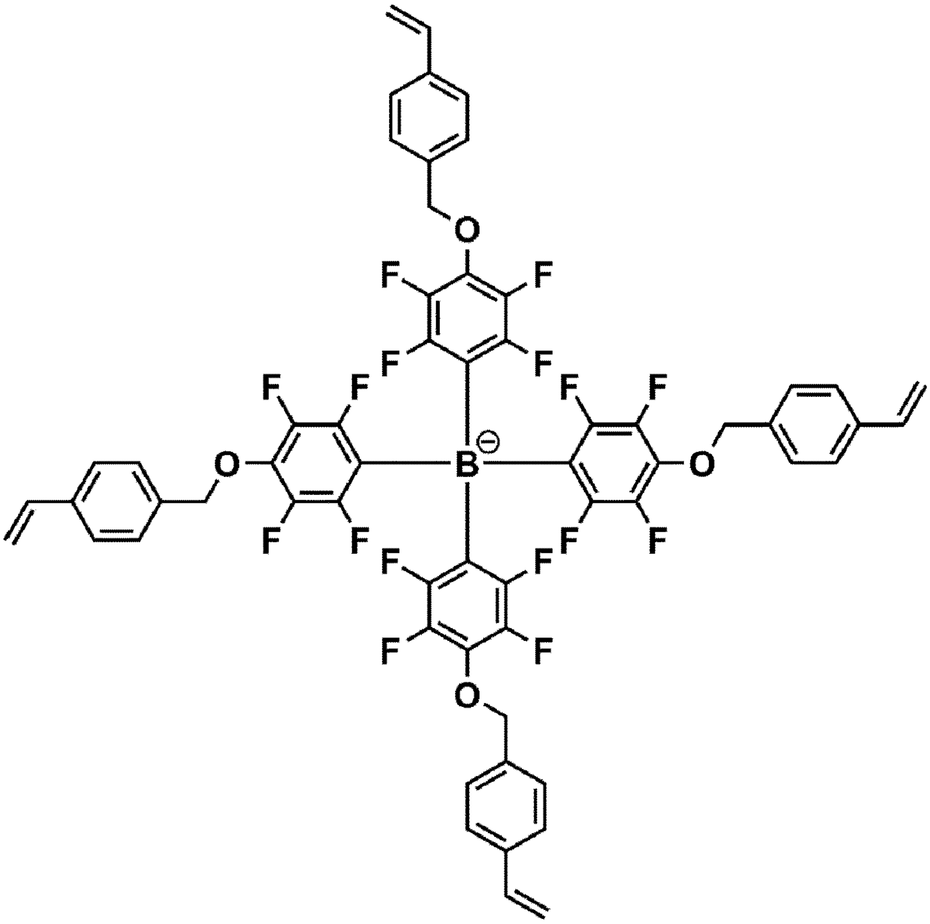

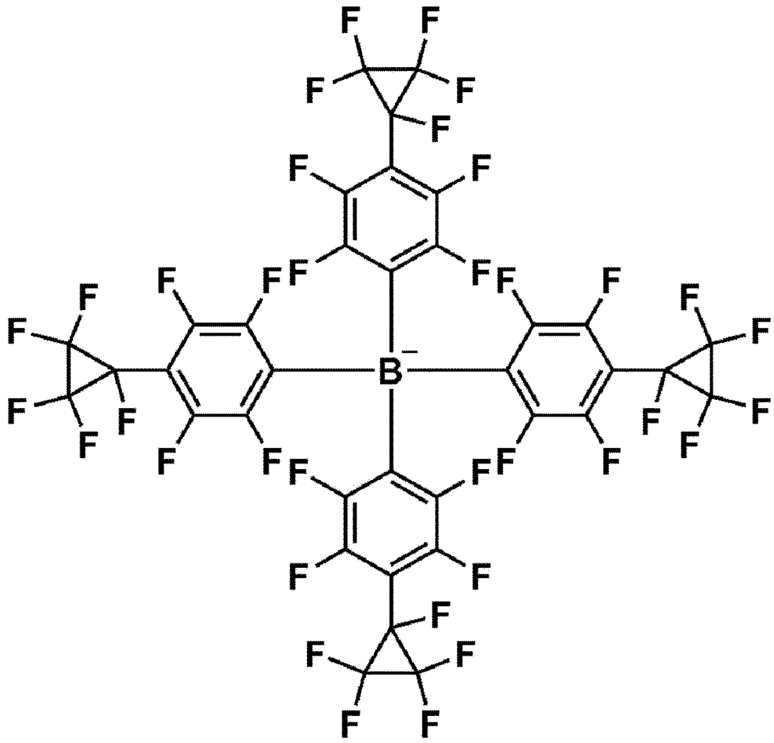

9. Organische lichtemittierende Vorrichtung gemäß Anspruch 1, wobei die ionische Verbindung eine Kationengruppe, ausgewählt aus einer der folgenden Strukturformeln, einschließt:

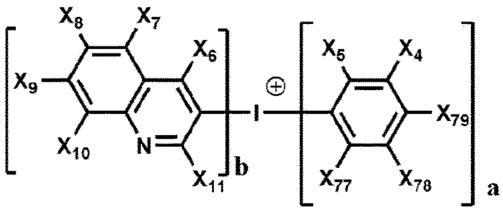
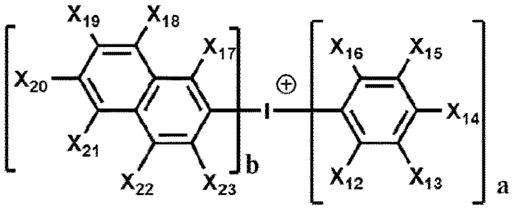
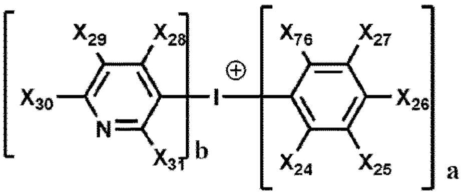
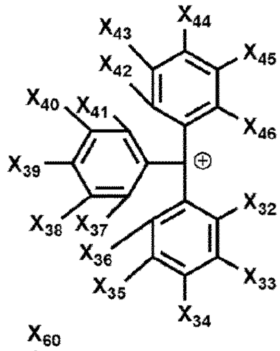
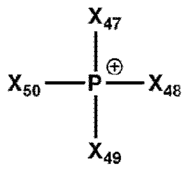
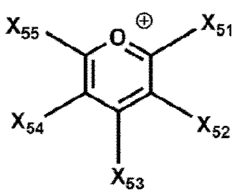
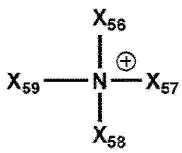
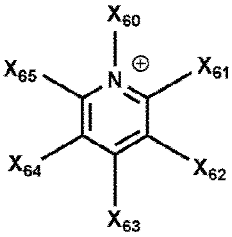
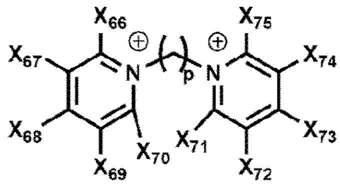
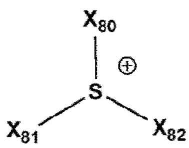

worin

$X_4$ bis $X_{79}$ gleich oder verschieden voneinander sind und jeweils unabhängig Wasserstoff, eine Cyanogruppe, eine Nitrogruppe, eine Halogengruppe, $-COOR_{200}$, eine substituierte oder unsubstituierte Alkylgruppe, eine substituierte oder unsubstituierte Alkoxygruppe, eine substituierte oder unsubstituierte Cycloalkylgruppe, eine substituierte oder unsubstituierte Fluoralkylgruppe, eine substituierte oder unsubstituierte Arylgruppe oder die härtende Gruppe sind,

$R_{200}$ Wasserstoff, Deuterium oder eine substituierte oder unsubstituierte Alkylgruppe ist,

p eine ganze Zahl von 0 bis 10 ist,

a 1 oder 2 ist, b 0 oder 1 ist und a+b=2 ist und

$X_{80}$ bis $X_{82}$ gleich oder verschieden voneinander und jeweils unabhängig eine substituierte oder unsubstituierte Alkylgruppe, eine substituierte oder unsubstituierte Alkenylgruppe, eine substituierte oder unsubstituierte Alkinylgruppe eine substituierte oder unsubstituierte Cycloalkylgruppe, eine substituierte oder unsubstituierte Arylgruppe oder eine substituierte oder unsubstituierte heterocyclische Gruppe sind, oder Gruppen die nebeneinander liegen, sich miteinander verbinden, um einen Ring zu bilden.

**10.** Organische lichtemittierende Vorrichtung gemäß Anspruch 1, wobei die organische Materialschicht, die das gehärtete Material einschließt, eine Lochtransferschicht, eine Lochinjektionsschicht oder eine Schicht, die gleichzeitig Lochtransfer und Lochinjektion durchführt, ist.

**11.** Organische lichtemittierende Vorrichtung gemäß Anspruch 1, wobei die organische Materialschicht, die das gehärtete Material einschließt, eine lichtemittierende Schicht ist.

## Revendications

1. Dispositif électroluminescent organique comprenant :

une première électrode ;
une seconde électrode disposée opposée à la première électrode ; et
une ou plusieurs couches de matériau organique disposées entre la première électrode et la seconde électrode, dans lequel une ou plusieurs couches des couches de matériau organique inclut un matériau durci constitué d'un composé représenté par la Formule chimique 1 suivante et d'un composé ionique incluant un groupe anionique représenté par la Formule chimique 11 suivante :

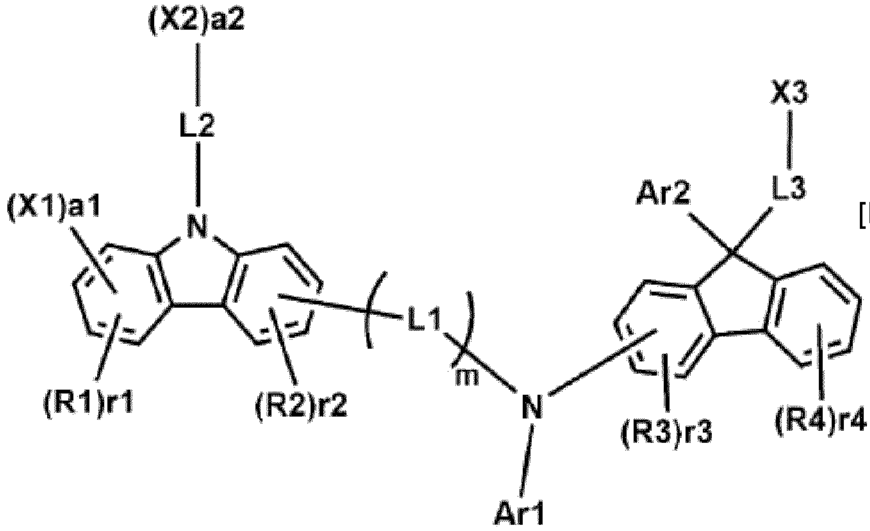

[Formule chimique 1]

dans lequel :

Ar1 et Ar2 sont identiques ou différents l'un de l'autre, et sont chacun indépendamment un groupe aryle substitué ou non substitué ou un groupe hétérocyclique substitué ou non substitué ;
R1 à R4 sont identiques ou différents les uns des autres, et sont chacun indépendamment un hydrogène, un deutérium, un groupe halogéno, un groupe nitrile, un groupe alkyle substitué ou non substitué, un groupe aryle substitué ou non substitué ou un groupe hétérocyclique substitué ou non substitué ;
r1 à r3 valent chacun de 1 à 3 ;
r4 vaut de 1 à 4 ;
lorsque r1 à r4 sont chacun supérieurs ou égaux à 2, les deux R1 à R4 ou plus sont chacun identiques ou différents les uns des autres ;
X1 à X3 sont identiques ou différents les uns des autres, et chacun est indépendamment choisi parmi les formules structurales suivantes,

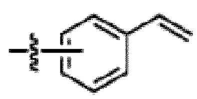
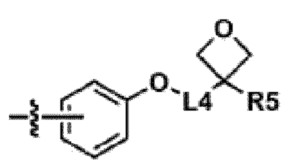
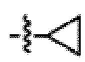

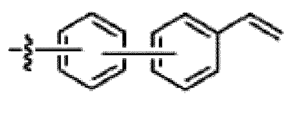
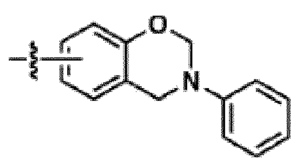
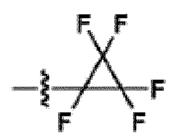

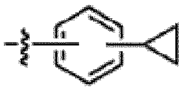
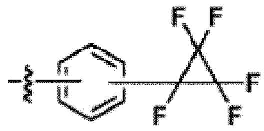
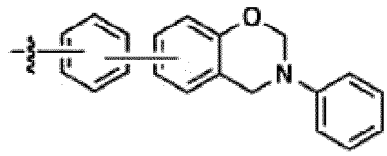

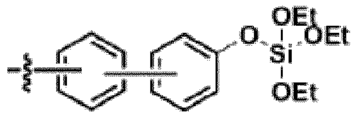
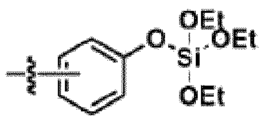
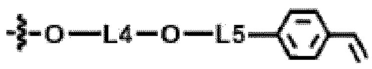

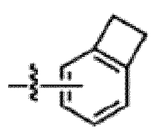
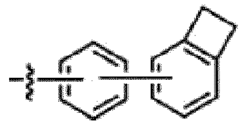

chaque 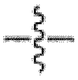 désigne un site de liaison ;

L4 est un groupe alkylène substitué ou non substitué ;

L5 est une liaison directe ou un groupe arylène substitué ou non substitué ;

R5 est un hydrogène ou un groupe alkyle substitué ou non substitué ;

a1 et a2 valent chacun 0 ou 1 ;

lorsque a2 vaut 0, L2 est un groupe aryle substitué ou non substitué ;

lorsque a2 vaut 1, L2 est une liaison directe ou un groupe arylène substitué ou non substitué ;

m vaut 1 ou 2, et lorsque m vaut 2, les L1 sont identiques ou différents les uns des autres, et L1 est une liaison directe ou un groupe arylène substitué ou non substitué ;

L3 est une liaison directe ou un groupe alkylène substitué ou non substitué ; et

$$0 \leq a1 + a2 \leq 2,$$

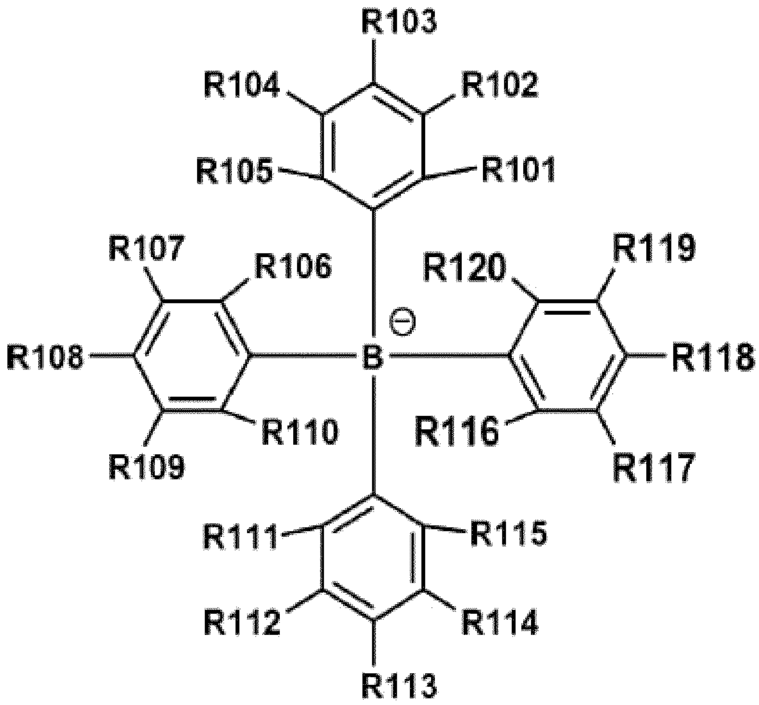

[Formule chimique 11]

dans lequel :

au moins un de R101 à R120 est un F, un groupe cyano ou un groupe fluoroalkyle substitué ou non substitué ;
au moins un des R101 à R120 restants est un groupe de durcissement ; et
les R101 à R120 restants sont identiques ou différents les uns des autres, et sont chacun indépendamment un hydrogène, un deutérium, un groupe nitro, un groupe alkyle substitué ou non substitué, un groupe alcényle substitué ou non substitué, un groupe amine substitué ou non substitué, un groupe aryle substitué ou non substitué ou un groupe hétérocyclique substitué ou non substitué.

2. Dispositif électroluminescent organique selon la revendication 1, dans lequel la Formule chimique 1 est représentée par la Formule chimique 2 suivante :

[Formule chimique 2]

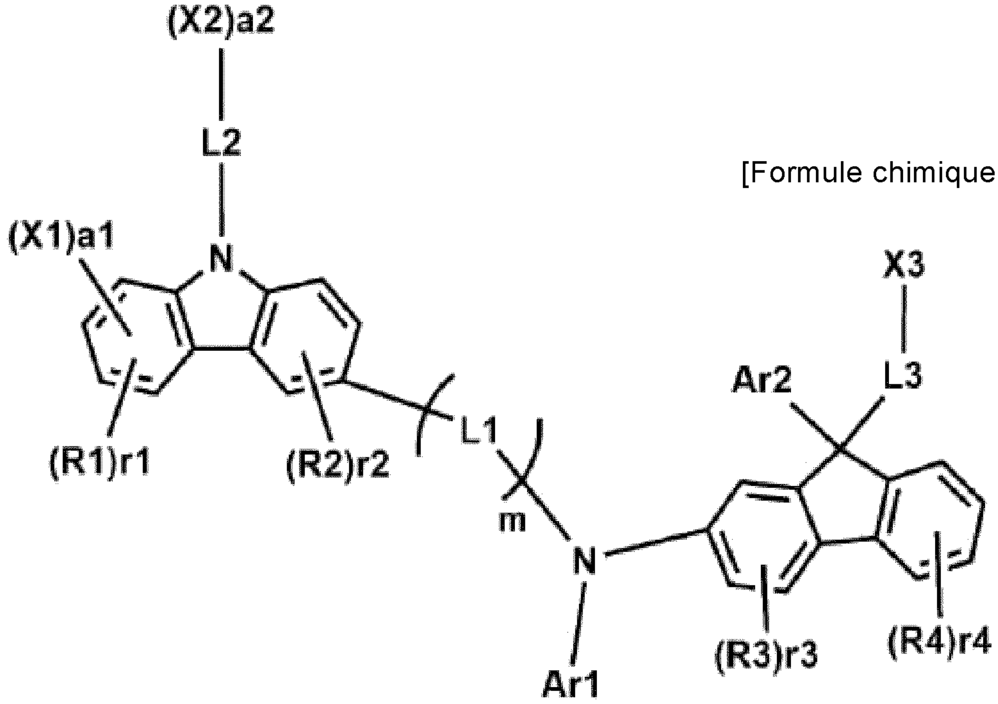

dans lequel :
L1 à L3, Ar1, Ar2, R1 à R4, r1 à r4, X1 à X3, m, a1 et a2 sont tels que définis dans la revendication 1.

3. Dispositif électroluminescent organique selon la revendication 1, dans lequel L1 est un groupe phénylène substitué ou non substitué.

4. Dispositif électroluminescent organique selon la revendication 1, dans lequel Ar1 et Ar2 sont identiques ou différents l'un de l'autre, et sont chacun indépendamment un groupe phényle substitué ou non substitué ou un groupe biphényle substitué ou non substitué.

5. Dispositif électroluminescent organique selon la revendication 1, dans lequel le composé représenté par la Formule chimique 1 est l'un quelconque des composés suivants :

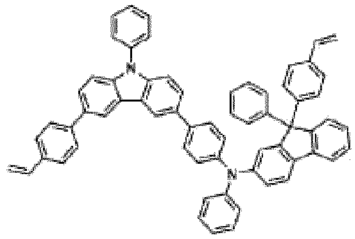
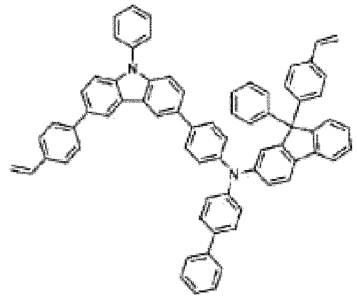
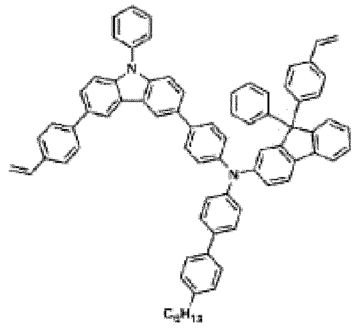

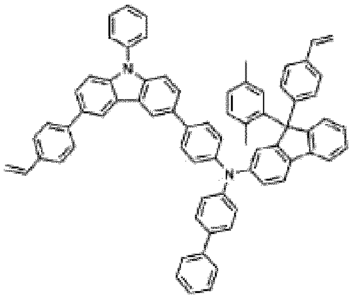
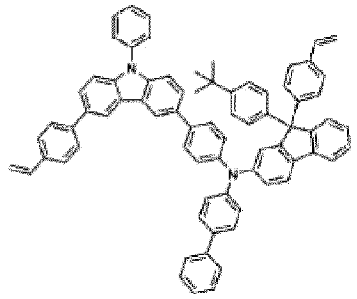
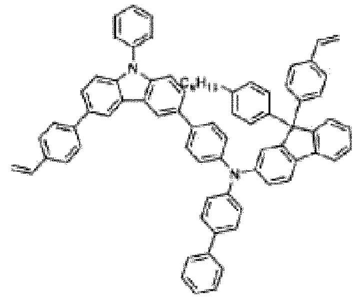

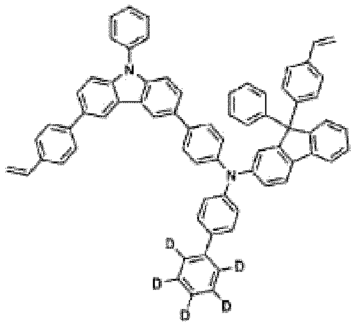
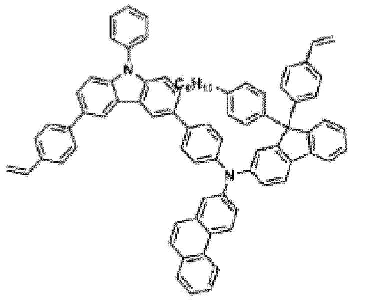
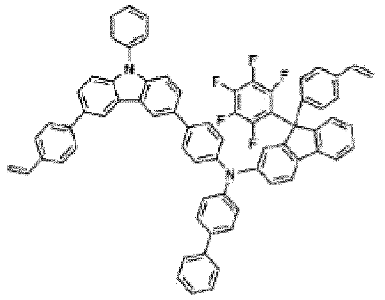

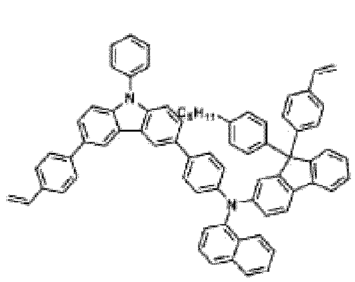
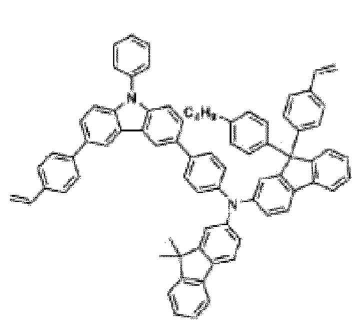
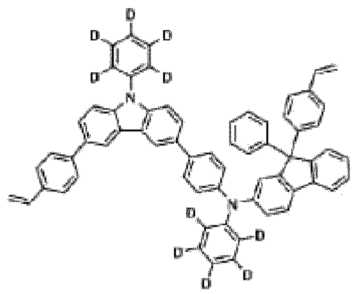

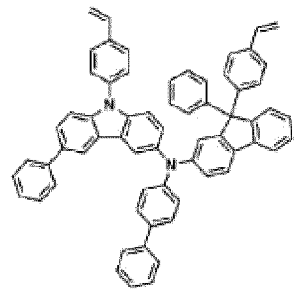
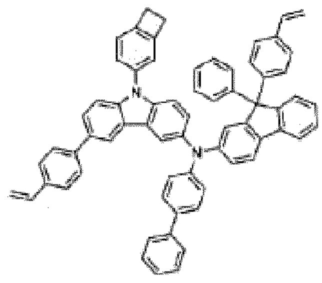
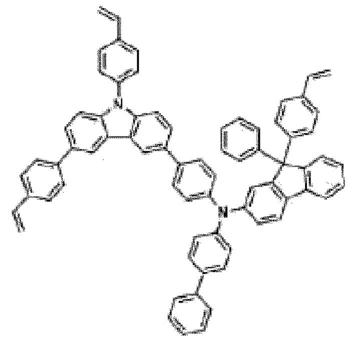

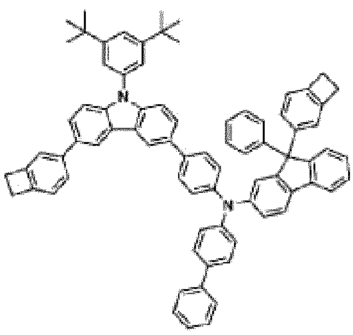
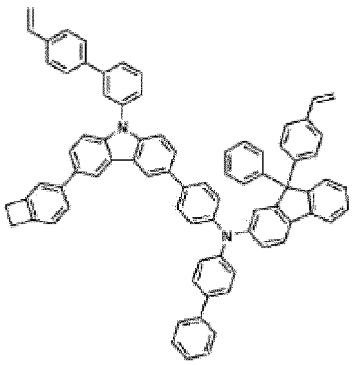
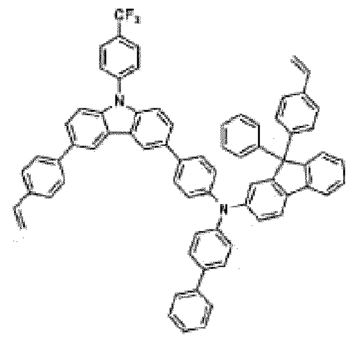

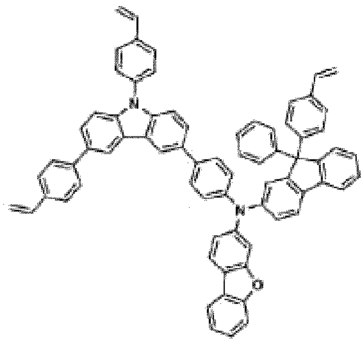
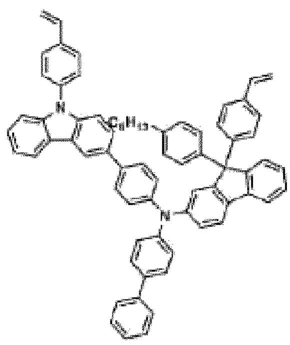
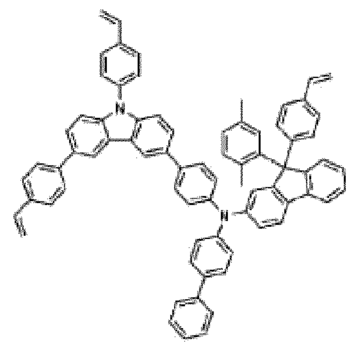

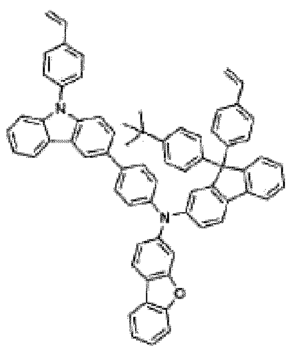
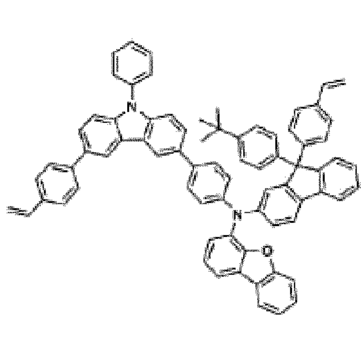
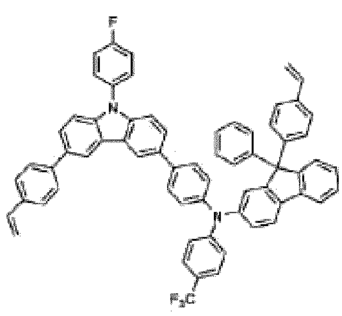

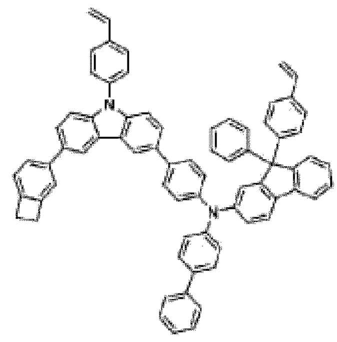
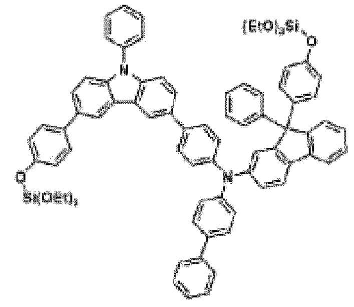
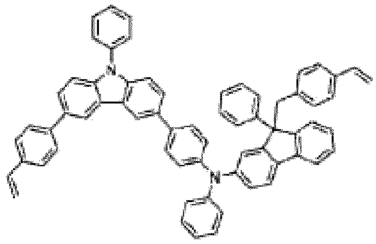
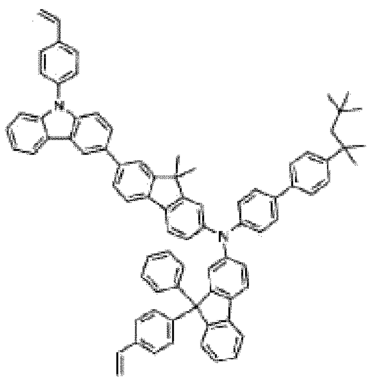
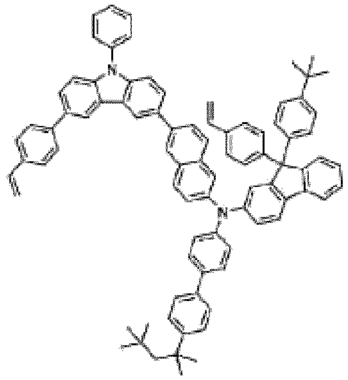
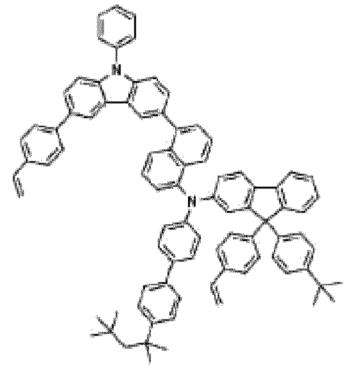
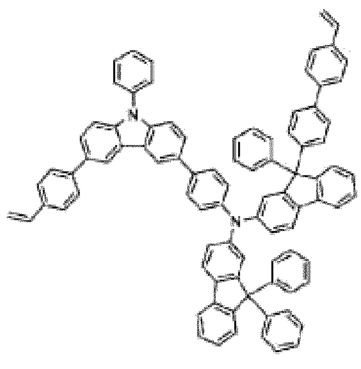
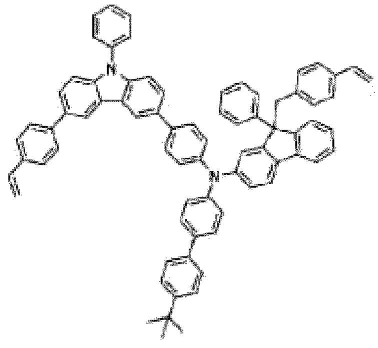
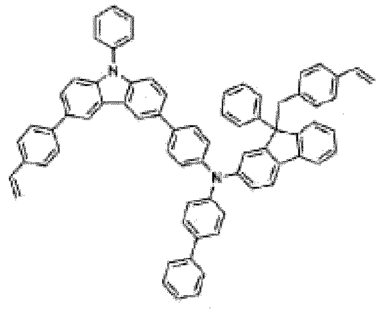
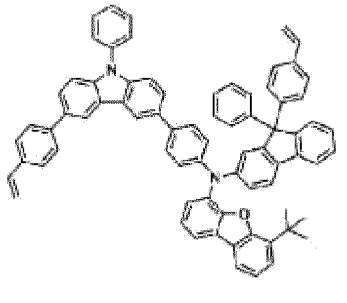
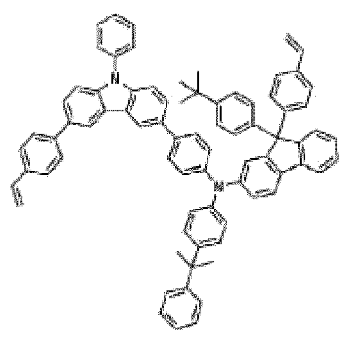
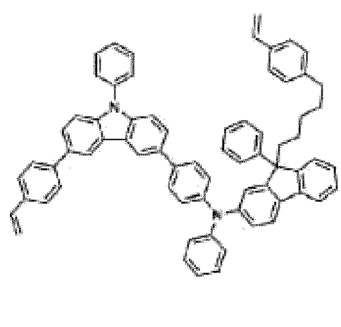

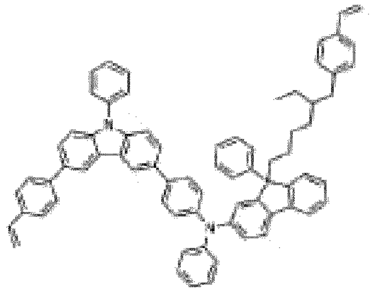

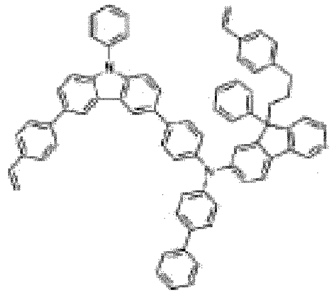

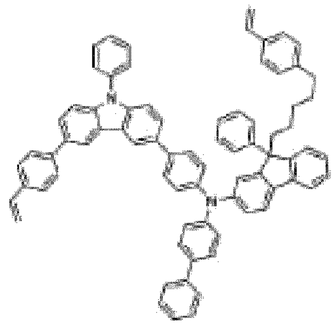

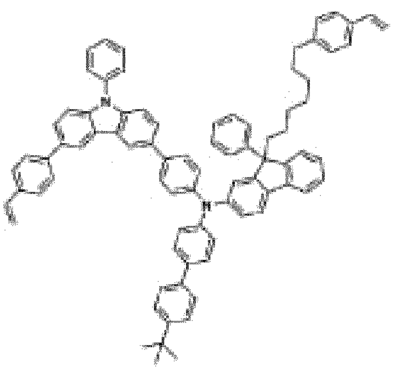

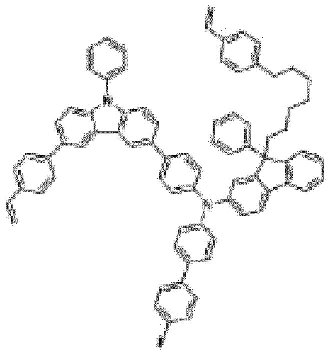

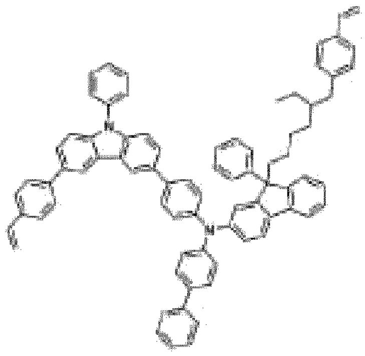

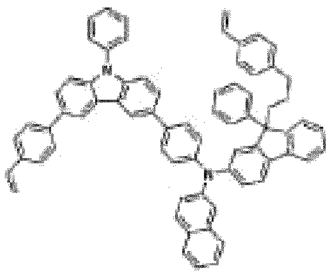

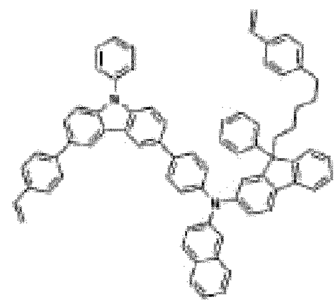

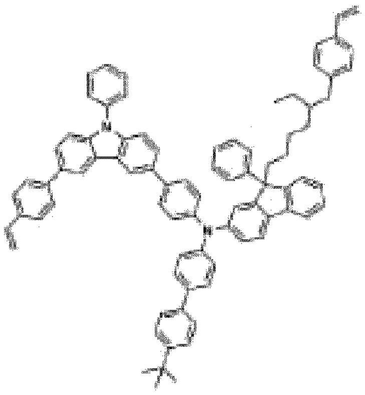

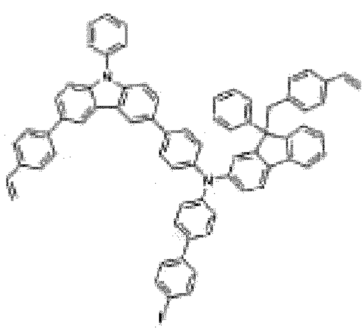

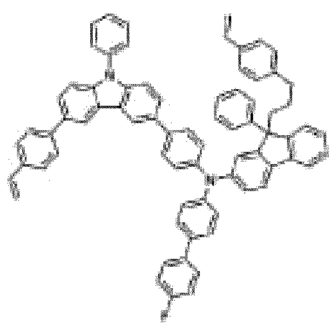

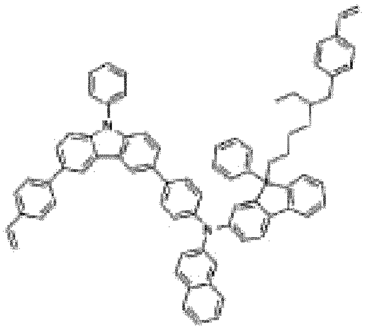

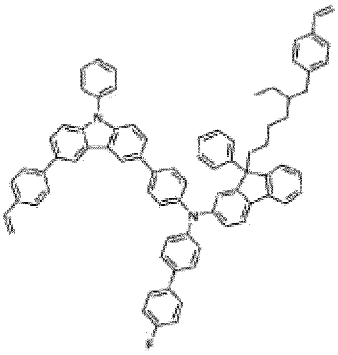

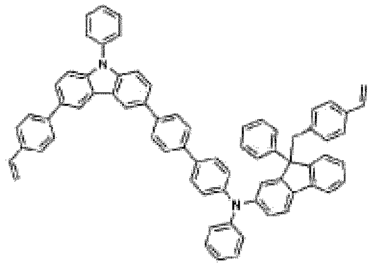

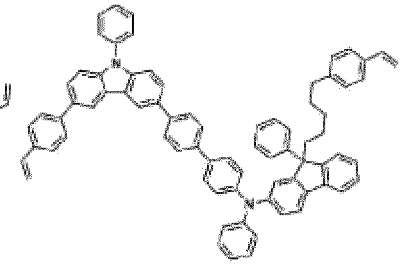

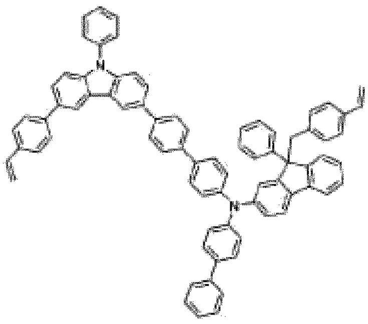

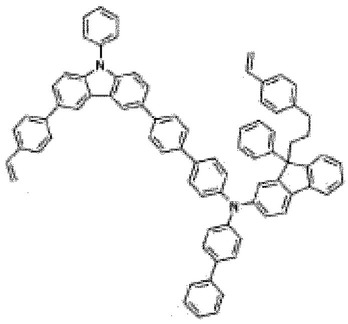

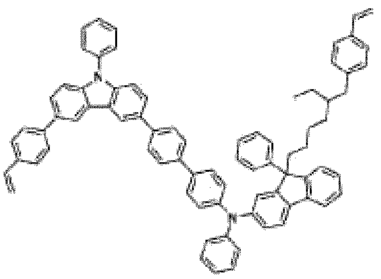

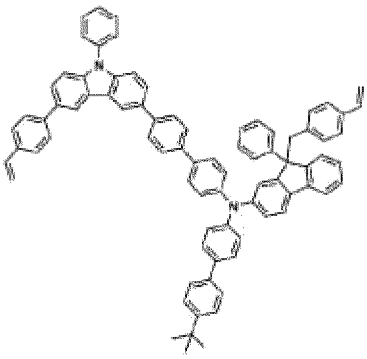

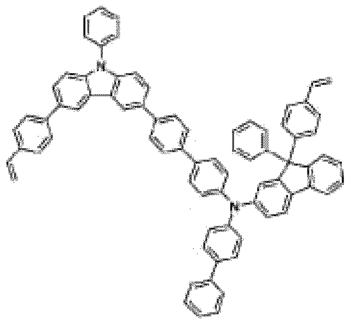

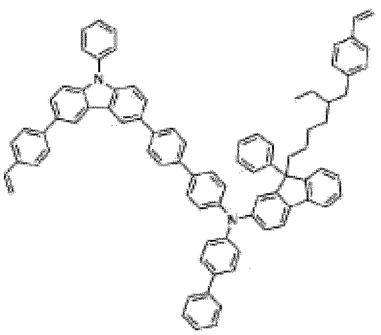

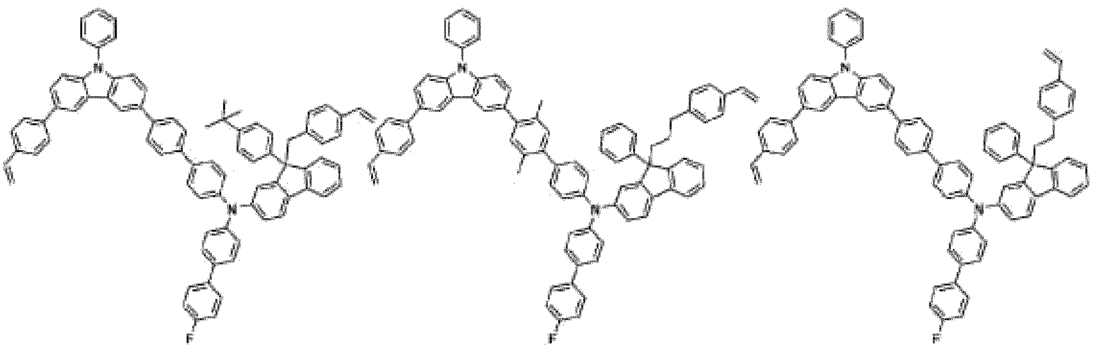

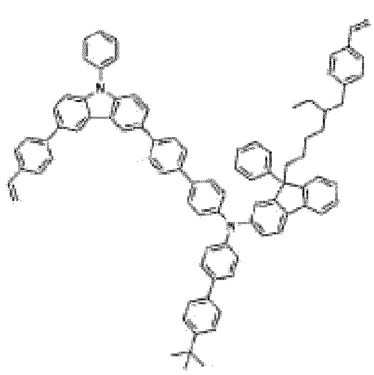

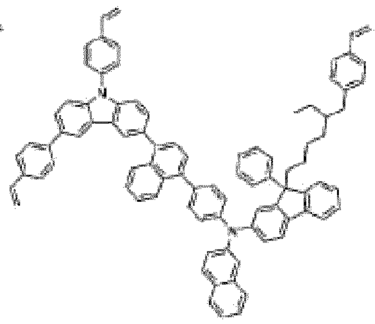

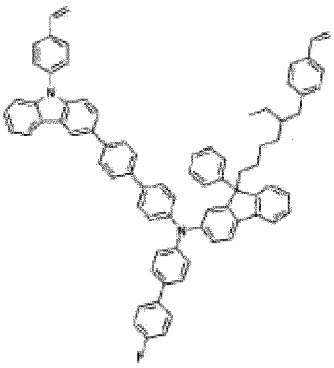

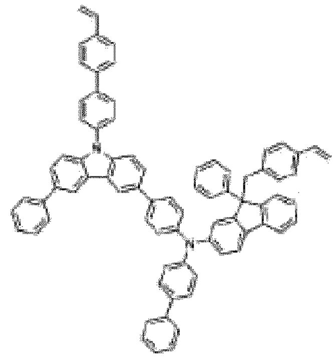

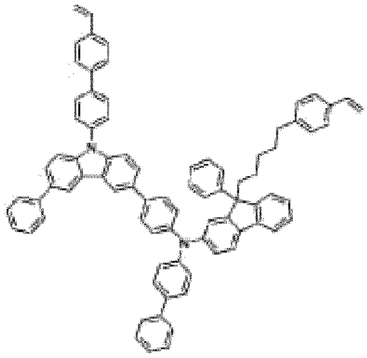

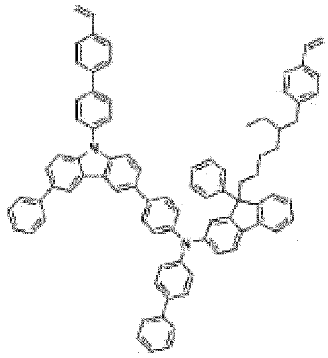

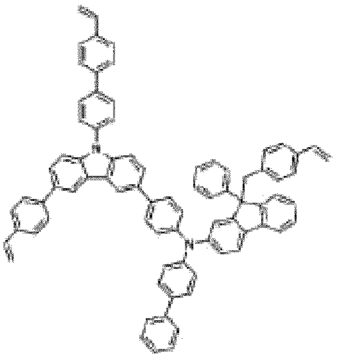

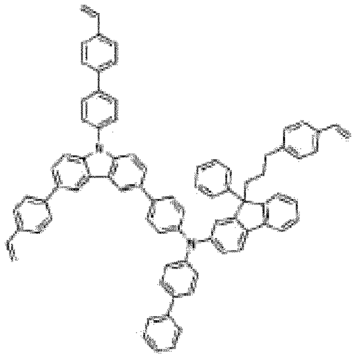

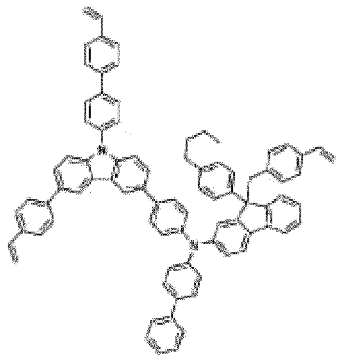

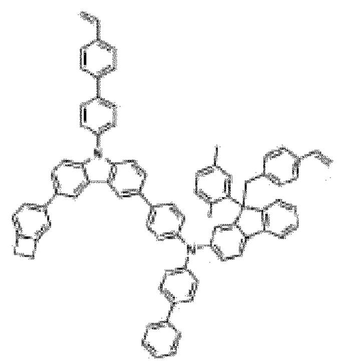

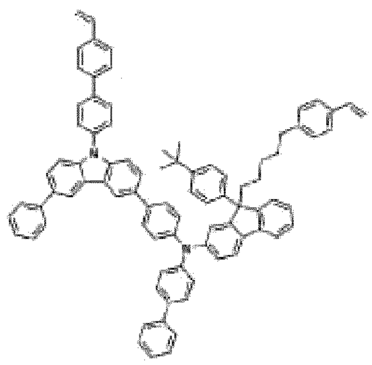

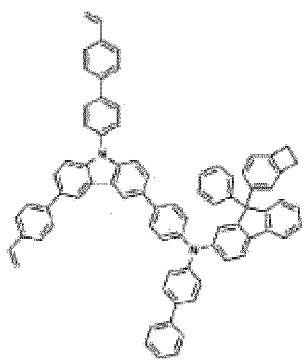

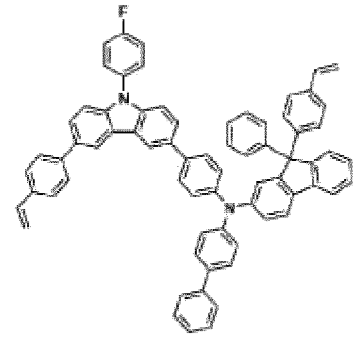
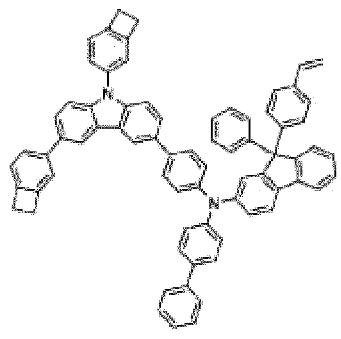
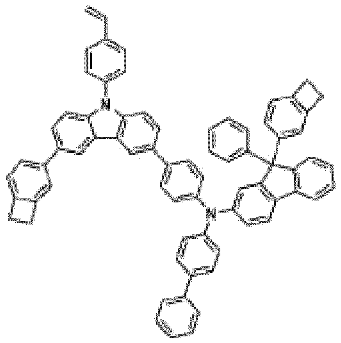

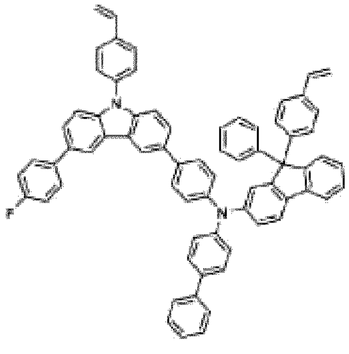
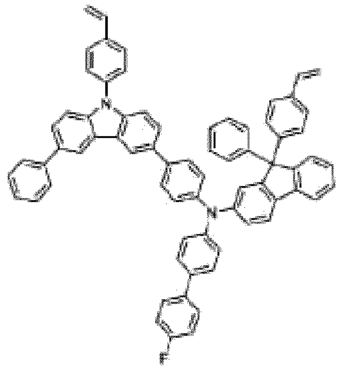
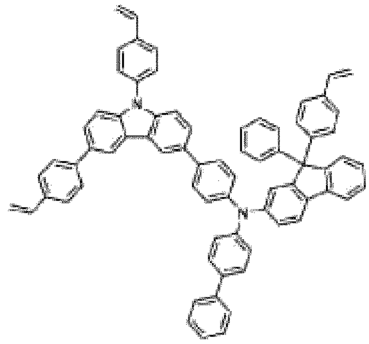

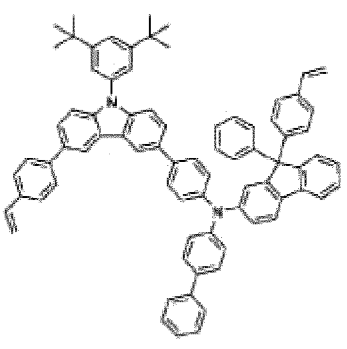
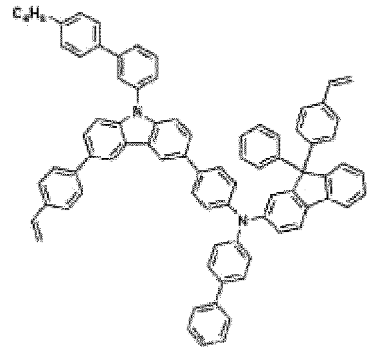
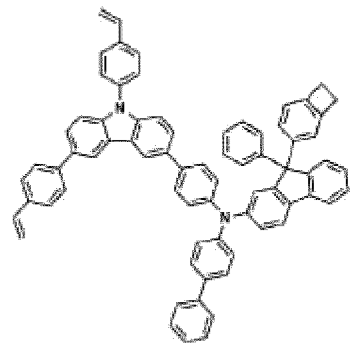

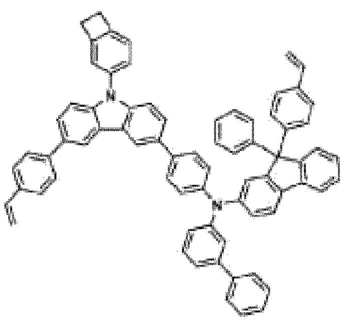
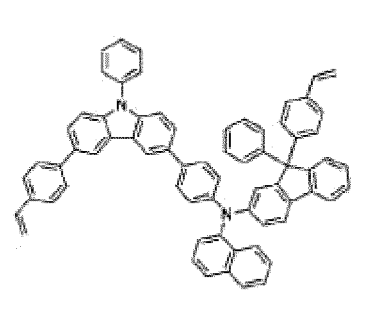
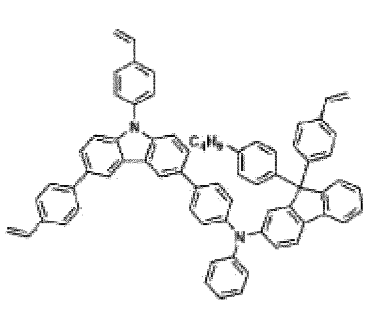

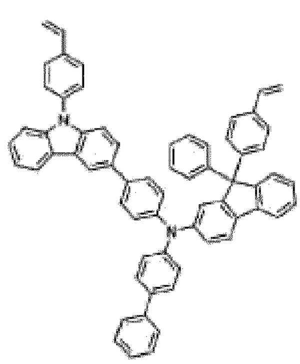
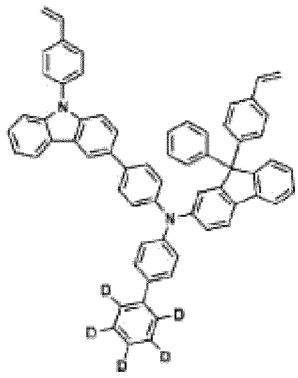
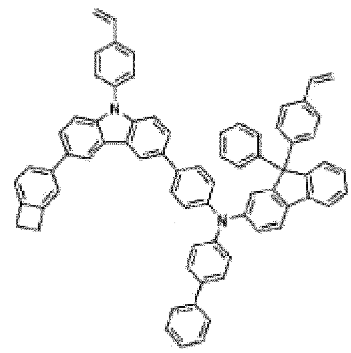

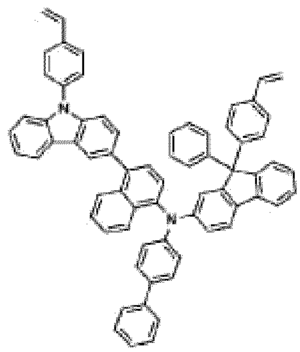
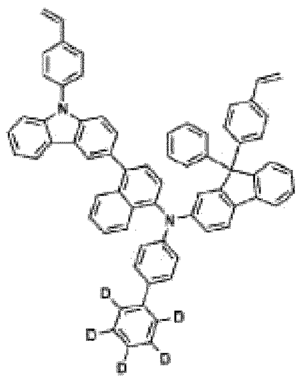
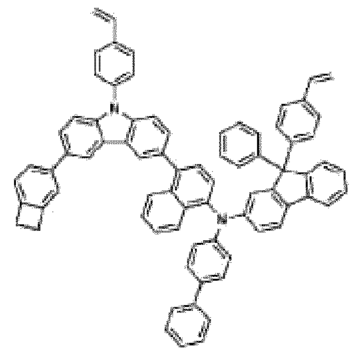

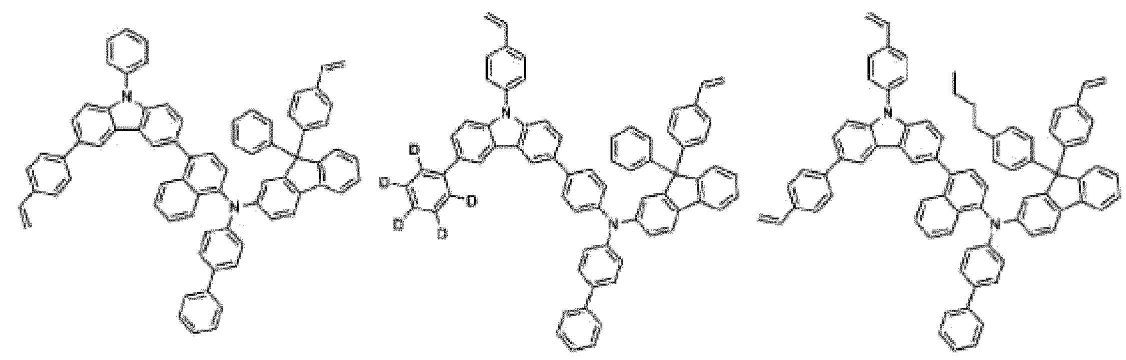

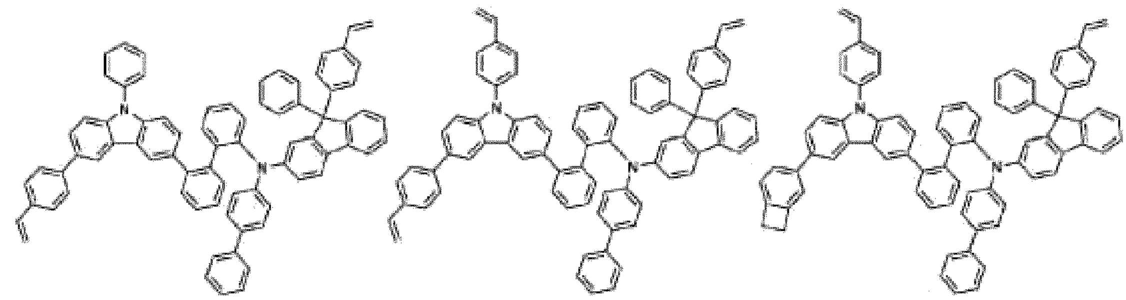

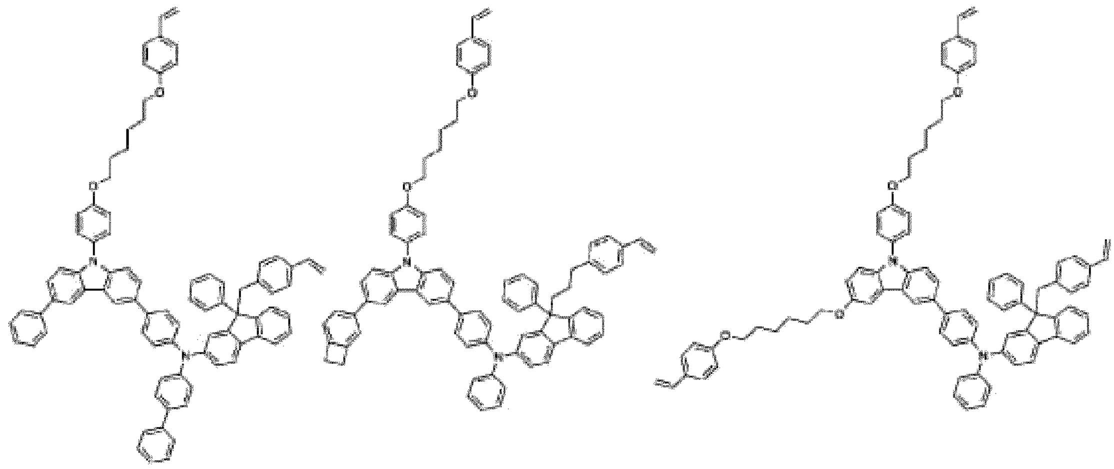

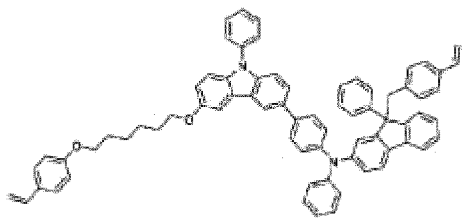

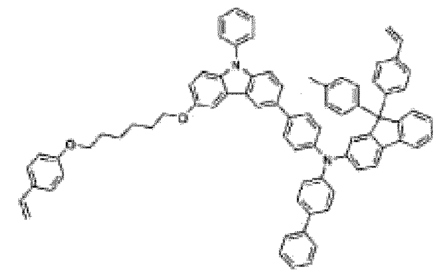

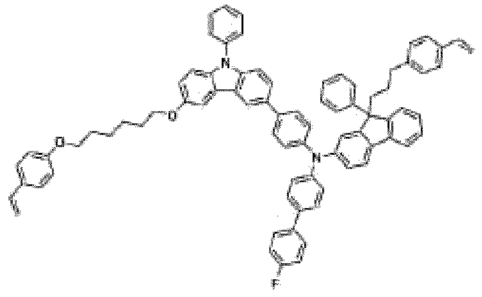

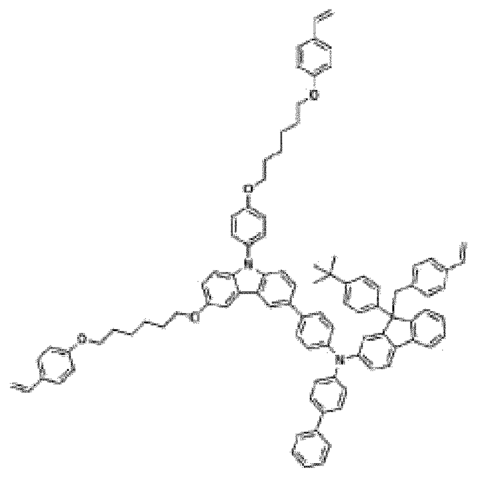

6. Dispositif électroluminescent organique selon la revendication 1, dans lequel au moins un de R103, R108, R113 et R118 est un groupe de durcissement.

7. Dispositif électroluminescent organique selon la revendication 1, dans lequel le groupe de durcissement est l'une quelconque des structures suivantes :

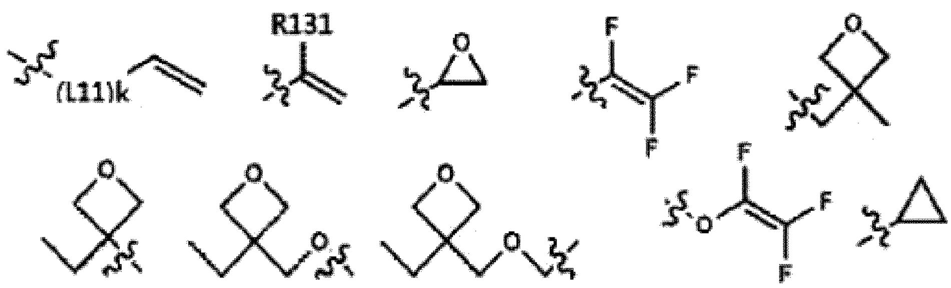

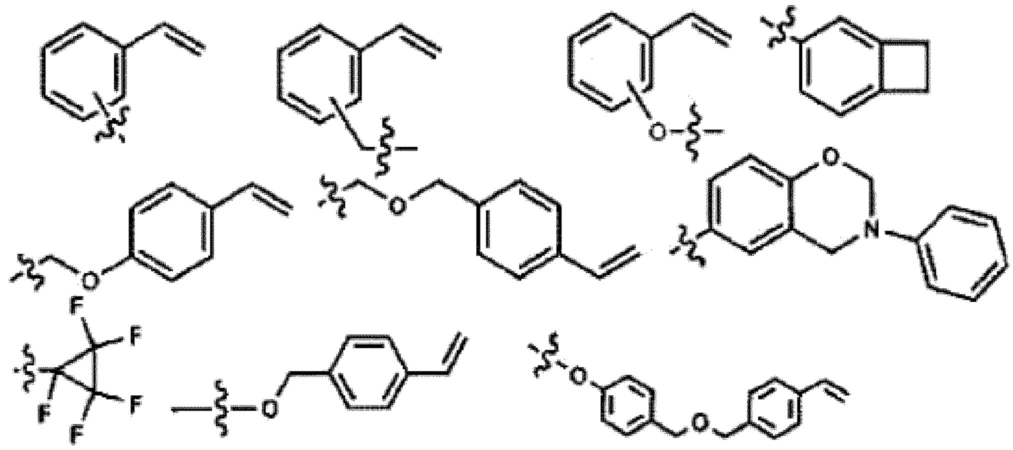

dans lequel :

L11 est une liaison directe, un -O-, un -S-, un groupe alkylène substitué ou non substitué, un groupe arylène substitué ou non substitué ou un groupe hétéroarylène substitué ou non substitué ;
k vaut 1 ou 2 ;
lorsque k vaut 2, les L11 sont identiques ou différents les uns des autres ;
R131 est un groupe alkyle substitué ou non substitué ; et
chaque

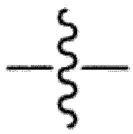

désigne un site de liaison.

**8.** Dispositif électroluminescent organique selon la revendication 1, dans lequel le groupe anionique représenté par la Formule chimique 11 est l'une quelconque des structures suivantes :

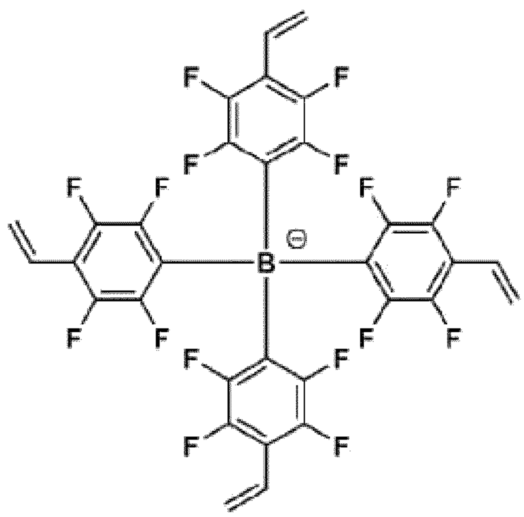
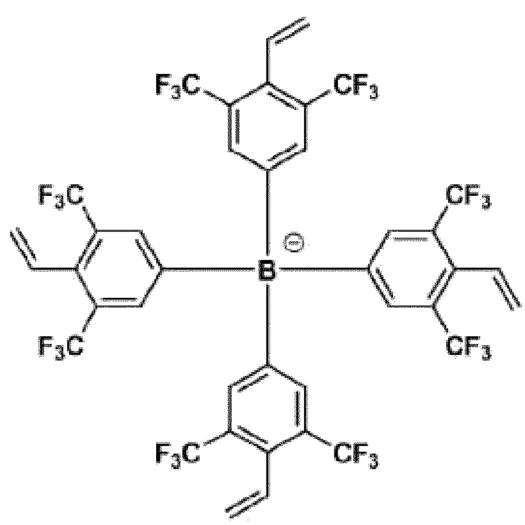

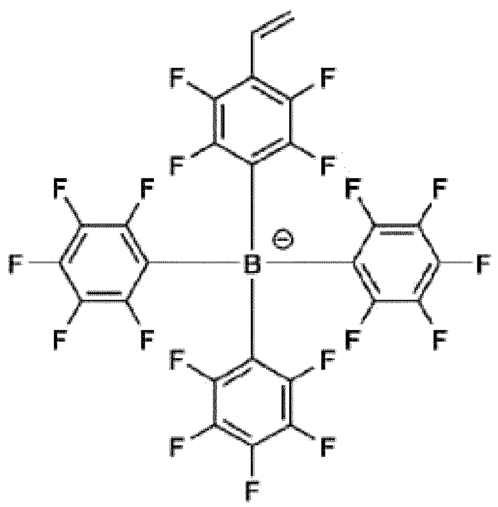

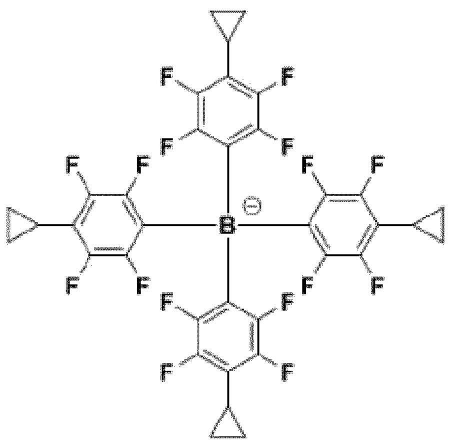

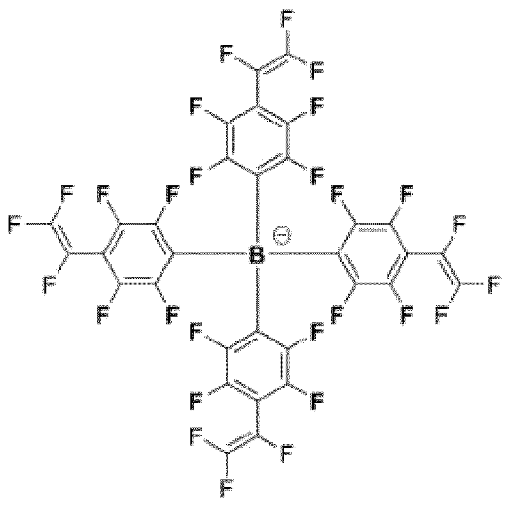

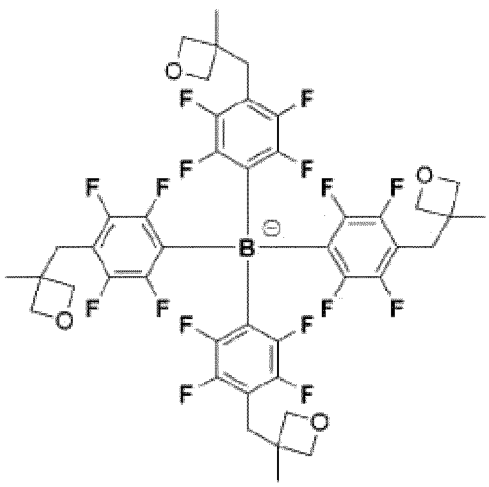

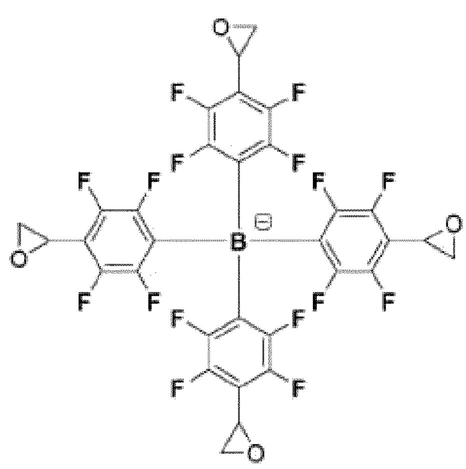

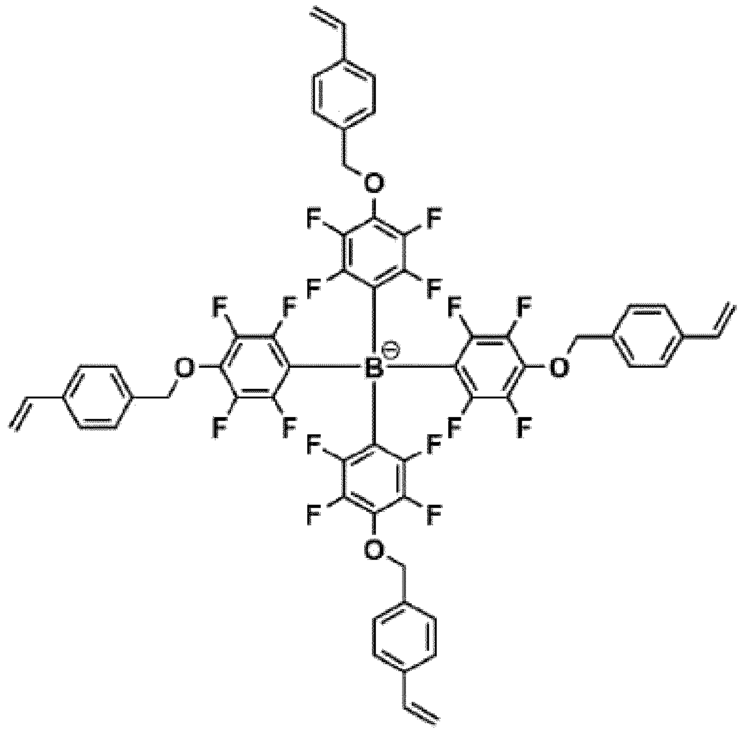

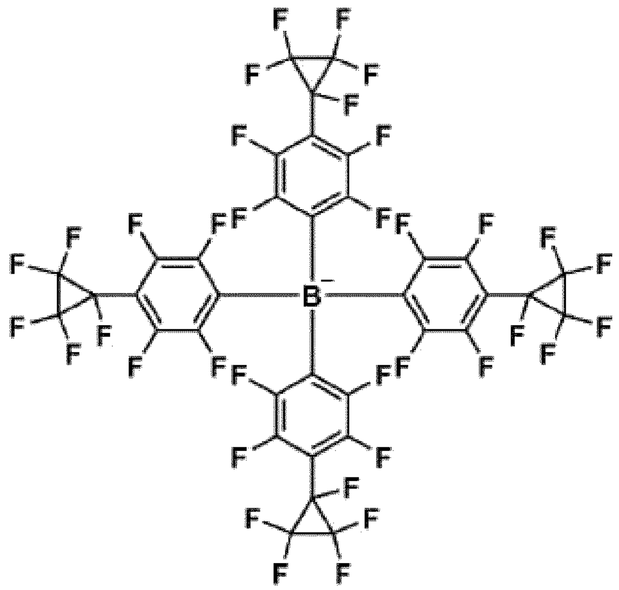

9. Dispositif électroluminescent organique selon la revendication 1, dans lequel le composé ionique inclut un groupe cationique choisi parmi l'une des formules structurales suivantes :

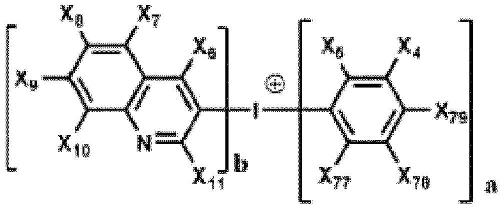

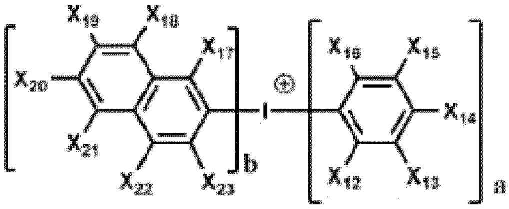

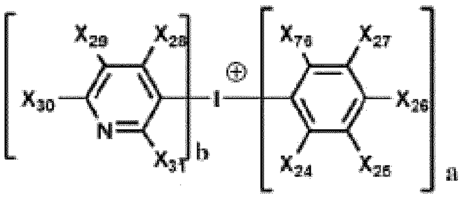
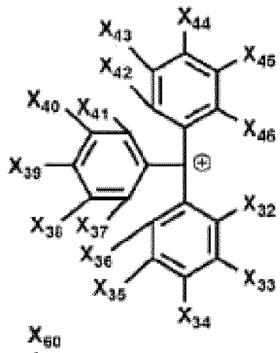
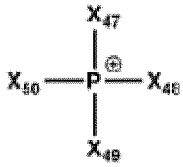

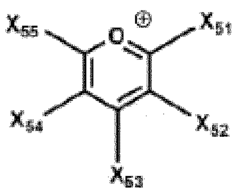
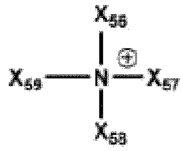
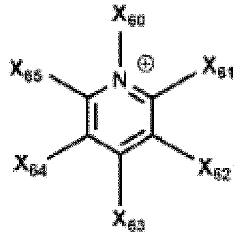
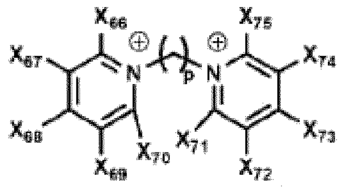

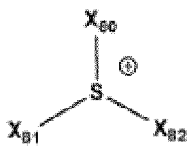

dans lequel :

$X_4$ à $X_{79}$ sont identiques ou différents les uns des autres et sont chacun indépendamment un hydrogène, un groupe cyano, un groupe nitro, un groupe halogéno, un -COOR$_{200}$, un groupe alkyle substitué ou non substitué, un groupe alcoxy substitué ou non substitué, un groupe cycloalkyle substitué ou non substitué, un groupe fluoroalkyle substitué ou non substitué, un groupe aryle substitué ou non substitué ou le groupe de durcissement ;
$R_{200}$ est un hydrogène ; un deutérium ; ou groupe alkyle substitué ou non substitué ;
p est un nombre entier de 0 à 10 ;
a vaut 1 ou 2, b vaut 0 ou 1, et a + b = 2 ; et
$X_{80}$ à $X_{82}$ sont identiques ou différents les uns des autres, et sont chacun indépendamment un groupe alkyle substitué ou non substitué, un groupe alcényle substitué ou non substitué, un groupe alcynyle substitué ou non substitué, un groupe cycloalkyle substitué ou non substitué, un groupe aryle substitué ou non substitué ou un groupe hétérocyclique substitué ou non substitué, ou des groupes adjacents les uns aux autres se lient les uns aux autres pour former un noyau.

**10.** Dispositif électroluminescent organique selon la revendication 1, dans lequel la couche de matériau organique incluant le matériau durci est une couche de transport de trous, une couche d'injection de trous ou une couche réalisant simultanément un transport de trous et une injection de trous.

**11.** Dispositif électroluminescent organique selon la revendication 1, dans lequel la couche de matériau organique incluant le matériau durci est une couche électroluminescente.

【FIG. 1】

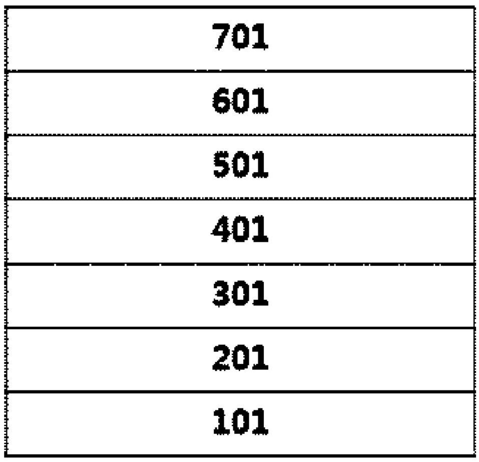

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- EP 3686186 A
- WO 2017107117 A
- KR 20180008154 A